# EUROPEAN PATENT APPLICATION

(11) **EP 4 753 432 A1**
(43) Date of publication of application: **03.06.2026**
(21) Application number: 25216479.3
(22) Date of filing: 17.11.2025
(51) Int. Cl.: H10K 85/40, C07F 7/08, H10K 85/60, H10K 50/11, H10K 59/12, H10K 85/30

(54) **ORGANIC COMPOUND, LIGHT-EMITTING DEVICE INCLUDING THE SAME, DISPLAY DEVICE INCLUDING THE LIGHT-EMITTING DEVICE, AND ELECTRONIC DEVICE INCLUDING THE DISPLAY DEVICE**

(30) Priority: 02.12.2024 KR 20240176722
(71) Applicant: Samsung Display Co., Ltd., Yongin-si, Gyeonggi-do 17113 (KR)
(72) Inventor: KIM, Hyeongmin, 17113 Yongin-si (KR); AHN, Heechoon, 17113 Yongin-si (KR); UM, Hyunah, 17113 Yongin-si (KR); HAN, Junghoon, 17113 Yongin-si (KR)
(74) Representative: Marks & Clerk LLP

(57) **Abstract**

Provided are: an organic compound represented by Formula 1; a light-emitting device including at least one of these; a display device including the light-emitting device and an electronic device including the display device. A description of Formula 1 is provided in the detailed description of the present disclosure.

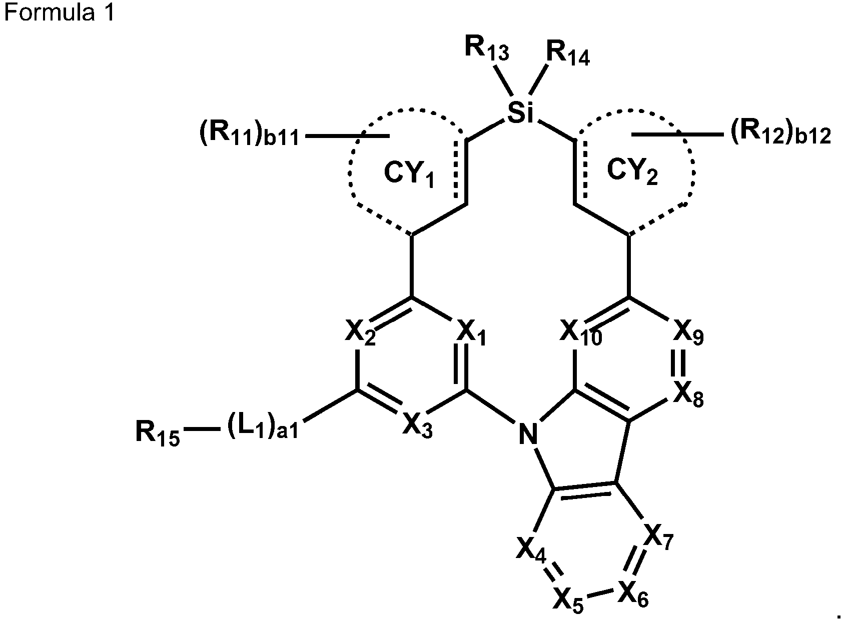

## Description

### BACKGROUND

### 1. Field

One or more embodiments of the present disclosure relate to an organic compound, a light-emitting device including the same, a display device including the light-emitting device, and an electronic device including the display device.

### 2. Description of the Related Art

Self-emissive devices (for example, organic light-emitting devices) from among light-emitting devices have wide viewing angles, high contrast ratios, short response times, and excellent characteristics in terms of luminance, driving voltage, and response speed.

A light-emitting device may include a first electrode, a hole transport region, an emission layer, an electron transport region, and a second electrode, provided sequentially. Holes injected from the first electrode may move toward the emission layer through the hole transport region. Electrons injected from the second electrode may move toward the emission layer through the electron transport region. Carriers, such as holes and electrons, may recombine in the emission layer to produce excitons. When the excitons drop (e.g., transition or relax) from an excited state to a ground state, light may be generated.

### SUMMARY

One or more embodiments of the present disclosure provide an organic compound, a light-emitting device employing the same, a display device including the light-emitting device, and an electronic device including the display device.

Additional aspects of embodiments will be set forth in part in the description which follows and, in part, will be apparent from the description, or may be learned by practice of the presented embodiments of the disclosure.

According to one or more embodiments, a light-emitting device includes a first electrode, a second electrode facing the first electrode, and an interlayer between the first electrode and the second electrode and including an emission layer, wherein the interlayer includes at least one organic compound represented by Formula 1: 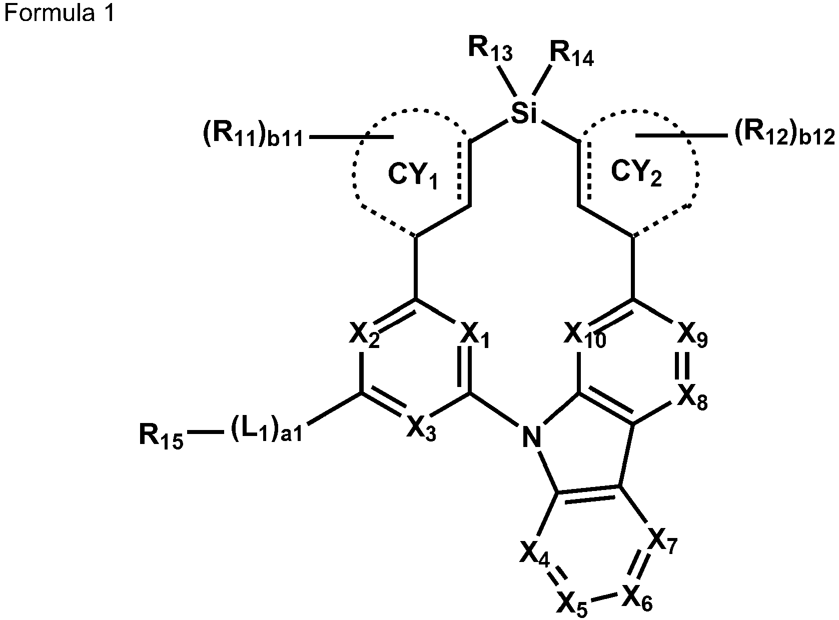 wherein, in Formula 1,
a bond represented by 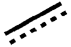 is a single bond or a double bond (e.g., a single covalent bond, a double covalent bond, or a combination thereof such as, for example, a conjugated bond),
CY₁ and CY₂ are each independently a C₅-C₆₀ carbocyclic group or a C₃-C₆₀ heterocyclic group,
X₁ is C(R₁) or N, X₂ is C(R₂) or N, X₃ is C(R₃) or N, X₄ is C(R₄) or N, X₅ is C(R₅) or N, X₆ is C(R₆) or N, X₇ is C(R₇) or N, X₈ is C(R₈) or N, X₉ is C(R₉) or N, X₁₀ is C(R₁₀) or N,
L₁ is a C₅-C₆₀ carbocyclic group unsubstituted or substituted with at least one R₁₀ₐ or a C₁-C₆₀ heterocyclic group unsubstituted or substituted with at least one R₁₀ₐ,
a1 is an integer from 0 to 2, and when a1 is 0, the group represented by (L₁)ₐ₁ is a single bond (e.g., a single covalent bond),
b11 and b12 are each an integer from 1 to 10,
R₁ to R₁₅ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₅-C₆₀ carbocyclic group unsubstituted or substituted with at least one R₁₀ₐ, a C₁-C₆₀ heterocyclic group unsubstituted or substituted with at least one R₁₀ₐ, -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
R₁₁ and (L₁)ₐ₁-R₁₅ are optionally bonded to each other (that is, may be bonded to each other, or may not be bonded to each other) to form a C₅-C₆₀ carbocyclic group or a C₁-C₆₀ heterocyclic group,
R₁₀ₐ is:
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₅-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or a combination thereof,
a C₅-C₆₀ carbocyclic group, a C₃-C₆₀ heterocyclic group, a C₆-C₆₀ aryloxy group, a C₆-C₆₀ arylthio group, a C₇-C₆₀ arylalkyl group, or a C₃-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₅-C₆₀ carbocyclic group, a C₃-C₆₀ heterocyclic group, a C₆-C₆₀ aryloxy group, a C₆-C₆₀ arylthio group, a C₇-C₆₀ arylalkyl group, a C₃-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any suitable combination thereof, or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently
hydrogen, deuterium, -F, -Cl, -Br, -I, a hydroxyl group, a cyano group, or a nitro group, or
a C₁-C₆₀ alkyl group, a C₂-C₆₀ alkenyl group, a C₂-C₆₀ alkynyl group, a C₁-C₆₀ alkoxy group, a C₅-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any suitable combination thereof.

According to one or more embodiments, a display device includes the light-emitting device and a thin film transistor electrically connected to the light-emitting device.

According to one or more embodiments, an electronic device includes a display device and a processor configured to transmit a signal to the display device, wherein the electronic device is one selected from a flat panel display, a curved display, a computer monitor, a medical monitor, a television, a billboard, indoor or outdoor lighting and/or signaling lights, a head-up display, a fully or partially transparent display, a flexible display, a rollable display, a foldable display, a stretchable display, smart glasses, a head-mounted display, a smart watch, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, an augmented reality display, a vehicle dashboard, a center information display (CID) for a vehicle, a head-up display for a vehicle, a rearview mirror display, a video wall including a plurality of displays that are tiled together, a theater screen, a stadium screen, a light therapy device, and a signage.

According to one or more embodiments, provided is an organic compound represented by Formula 1.

At least some of the above and other features of the invention are set out in the claims.

### BRIEF DESCRIPTION OF THE DRAWINGS

The above and other aspects and features of certain embodiments of the disclosure will be more apparent from the following description taken in conjunction with the accompanying drawings, in which:
FIG. 1 is a schematic cross-sectional view of a light-emitting device according to an embodiment;
FIG. 2 is a schematic cross-sectional view of a display device according to an embodiment;
FIG. 3 is a schematic cross-sectional view of a display device according to another embodiment;
FIG. 4 is a block diagram illustrating an electronic device including a display device according to an embodiment;
FIG. 5 is a schematic diagram showing an electronic device according to various embodiments;
FIG. 6 is a perspective view schematically illustrating an electronic device including a light-emitting device according to an embodiment;
FIG. 7 is a schematic view of the exterior of a vehicle as an electronic device including a light-emitting device according to an embodiment; and
FIGS. 8A to 8C are each a diagram schematically illustrating the interior of the vehicle of FIG. 7.

### DETAILED DESCRIPTION

Reference will now be made in more detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects of embodiments of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

According to one or more embodiments, an organic compound represented by Formula 1 is provided: 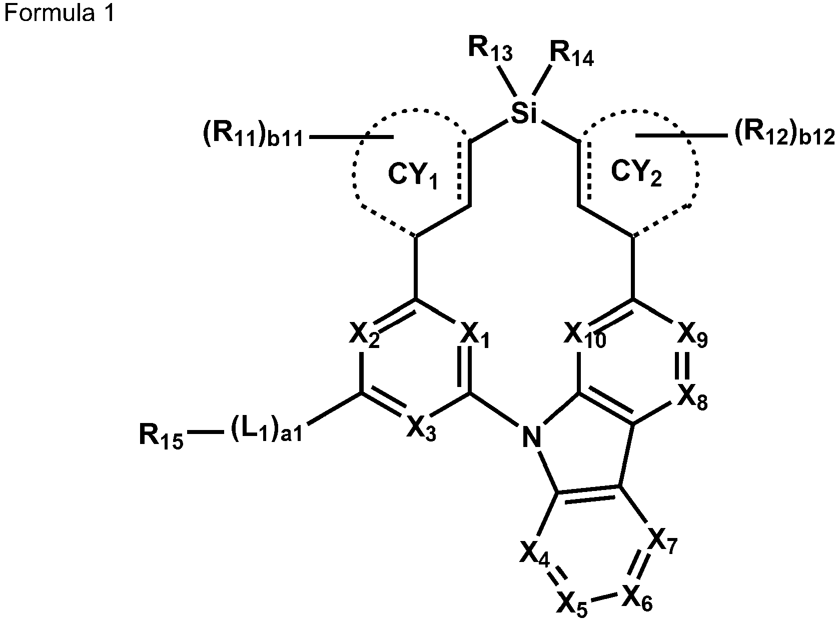 a bond represented by 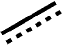 is a single bond or a double bond (e.g., a single covalent bond, a double covalent bond, or a combination thereof such as, for example, a conjugated bond).

CY₁ and CY₂ in Formula 1 are each independently a C₅-C₆₀ (e.g. C₅-C₃₀) carbocyclic group or a C₃-C₆₀ (e.g. C₃-C₂₀) heterocyclic group.

In an embodiment, CY₁ and CY₂ may each independently be a 5-membered ring; a 6-membered ring; a condensed ring of at least one 5-membered ring and at least one 6-membered ring; or a condensed ring of at least two 6-membered rings.

The 5-membered ring may be a cyclopentane group, a cyclopentene group, a cyclopentadiene group, a furan group, a thiophene group, a pyrrolidine group, a 2,3-dihydropyrrole group, a pyrrole group, a silorane group, a 2,3-dihydrosilole group, or a silole group.

The 6-membered ring may be a benzene group, a cyclohexane group, a cyclohexene group, a cyclohexadiene group, pyridine group, a pyrimidine group, pyrazine group, a pyridazine group, or a triazine group.

In an embodiment, CY₁ and CY₂ may each independently be a benzene group, a naphthalene group, 1,2,3,4-tetrahydronaphthalene group, a phenanthrene group, a pyridine group, a pyrimidine group, a pyrazine group, a pyridazine group, a triazine group, a quinoline group, an isoquinoline group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, or an azadibenzosilole group.

X₁ in Formula 1 is C(R₁) or N, X₂ is C(R₂) or N, X₃ is C(R₃) or N, X₄ is C(R₄) or N, X₅ is C(R₅) or N, X₆ is C(R₆) or N, X₇ is C(R₇) or N, X₈ is C(R₈) or N, X₉ is C(R₉) or N, X₁₀ is C(R₁₀) or N.

In an embodiment, at least one selected from X₁ to X₃ may be N. For example, at least two selected from X₁ to X₃ may be N. In some embodiments, each of X₁ to X₃ may be N.

In an embodiment, X₁ may be N, X₂ may be C(R₂), and X₃ may be C(R₃).

In an embodiment, X₁ may be C(R₁), X₂ may be N, and X₃ may be C(R₃).

In an embodiment, X₁ may be C(R₁), X₂ may be C(R₂), and X₃ may be N.

In an embodiment, X₁ may be N, X₂ may be N, and X₃ may be C(R₃).

In an embodiment, X₁ may be N, X₂ may be C(R₂), and X₃ may be N.

In an embodiment, X₁ may be C(R₁), X₂ may be N, and X₃ may be N.

In an embodiment, X₁ may be N, X₂ may be N, and X₃ may be N.

In an embodiment, at least one selected from X₄ to X₁₀ may be CH or CD. H may indicate hydrogen and D may indicate deuterium. At least two selected from X₄ to X₁₀ may be CH or CD. At least three selected from X₄ to X₁₀ may be CH or CD. At least four selected from X₄ to X₁₀ may be CH or CD. At least five selected from X₄ to X₁₀ may be CH or CD. At least six selected from X₄ to X₁₀ may be CH or CD. Each of X₄ to X₁₀ may be CH or CD.

In an embodiment, at least one selected from X₄ to X₇ may be CH or CD.

In an embodiment, at least one selected from X₈ and X₉ may be CH or CD.

In an embodiment, X₁₀ may be CH or CD.

L₁ in Formula 1 is a C₅-C₆₀ (e.g. C₅-C₃₀) carbocyclic group unsubstituted or substituted with at least one R₁₀ₐ or a C₁-C₆₀ (e.g. C₃-C₂₀) heterocyclic group unsubstituted or substituted with at least one R₁₀ₐ.

In an embodiment, L₁ may be a benzene group; a naphthalene group; a 1,2,3,4-tetrahydronaphthalene group; a phenanthrene group; a pyridine group; a pyrimidine group; a pyrazine group; a pyridazine group; a triazine group; a quinoline group; an isoquinoline group; a quinoxaline group; a quinazoline group; a phenanthroline group; a benzofuran group; a benzothiophene group; a fluorene group; a carbazole group; a dibenzofuran group; a dibenzothiophene group; a dibenzosilole group; an azafluorene group; an azacarbazole group; an azadibenzofuran group; an azadibenzothiophene group; or an azadibenzosilole group, each unsubstituted or substituted with at least one R₁₀ₐ.

When L₁ is a benzene group, L₁ may be ortho-phenylene, meta-phenylene, or para-phenylene.

When L₁ is a carbazole group, N of the carbazole group may be a site at which a neighboring atom bonds thereto. N of the carbazole group may be connected to a ring containing X₁ to X₃ in Formula 1, and any one of C of the carbazole group may be connected to R₁₅ in Formula 1.

a1 in Formula 1 is an integer from 0 to 2. When a1 is 0, a group represented by (L₁)ₐ₁ may be a single bond (e.g., a single covalent bond). When a1 is 2, a plurality of L₁ may be identical to or different from each other.

In an embodiment, a1 may be 0 or 1.

b11 and b12 in Formula 1 are each an integer from 1 to 10.

In an embodiment, each of b11 and b12 may be 0, 1, 2, 3, 4, or 5.

R₁ to R₁₅ in Formula 1 are each independently hydrogen, deuterium, -F, -Cl, -Br, -I, a hydroxyl group, a cyano group, a nitro group, a C₁-C₆₀ (e.g. C₁-C₂₀) alkyl group unsubstituted or substituted with at least one R₁₀ₐ, a C₂-C₆₀ (e.g. C₂-C₂₀) alkenyl group unsubstituted or substituted with at least one R₁₀ₐ, a C₂-C₆₀ (e.g. C₂-C₂₀) alkynyl group unsubstituted or substituted with at least one R₁₀ₐ, a C₁-C₆₀ (e.g. C₁-C₂₀) alkoxy group unsubstituted or substituted with at least one R₁₀ₐ, a C₅-C₆₀ (e.g. C₅-C₃₀) carbocyclic group unsubstituted or substituted with at least one R₁₀ₐ, a C₁-C₆₀ (e.g. C₃-C₂₀) heterocyclic group unsubstituted or substituted with at least one R₁₀ₐ, - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂).

R₁₀ₐ is:
deuterium, -F, -Cl, -Br, -I, a hydroxyl group, a cyano group, or a nitro group;
a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₅-C₆₀ (e.g. C₅-C₃₀) carbocyclic group, a C₁-C₆₀ (e.g. C₃-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, a C₂-C₆₀ (e.g. C₃-C₃₀) heteroarylalkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or a combination thereof;
a C₅-C₆₀ (e.g. C₅-C₃₀) carbocyclic group, a C₁-C₆₀ (e.g. C₃-C₃₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, or a C₂-C₆₀ (e.g. C₃-C₃₀) heteroarylalkyl group, each unsubstituted or substituted with deuterium, -F, -Cl, -Br, -I, a hydroxyl group, a cyano group, a nitro group, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₅-C₆₀ (e.g. C₅-C₃₀) carbocyclic group, a C₁-C₆₀ (e.g. C₃-C₃₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, a C₂-C₆₀ (e.g. C₃-C₂₀) heteroarylalkyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or any suitable combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q_{13,} Q₂₁ to Q_{23,} and Q₃₁ to Q₃₃ are each independently:
hydrogen, deuterium, -F, -Cl, -Br, -I, a hydroxyl group, a cyano group, or a nitro group; or
a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₅-C₆₀ (e.g. C₅-C₃₀) carbocyclic group, or a C₁-C₆₀ (e.g. C₃-C₂₀) heterocyclic group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any suitable combination thereof.

In an embodiment, R₁ to R₁₅ may each independently be hydrogen, deuterium, -F, a cyano group, a C₁-C₃₀ (e.g. C₁-C₂₀) alkyl group unsubstituted or substituted with at least one R₁₀ₐ, a C₂-C₃₀ (e.g. C₂-C₂₀) alkenyl group unsubstituted or substituted with at least one R₁₀ₐ, a C₂-C₃₀ (e.g. C₂-C₂₀) alkynyl group unsubstituted or substituted with at least one R₁₀ₐ, a C₁-C₃₀ (e.g. C₁-C₂₀) alkoxy group unsubstituted or substituted with at least one R₁₀ₐ, a C₆-C₆₀ (e.g. C₆-C₃₀) aryl group unsubstituted or substituted with at least one R₁₀ₐ, a C₁-C₆₀ (e.g. C₁-C₂₀) heteroaryl group unsubstituted or substituted with at least one R₁₀ₐ, -Si(Q₁)(Q₂)(Q₃), -N(Q₁)(Q₂), -B(Q₁)(Q₂), - C(=O)(Q₁), -S(=O)₂(Q₁), or -P(=O)(Q₁)(Q₂).

In an embodiment, R₁ to R₁₅ may each independently be hydrogen, deuterium, -F, -Cl, -Br, -I, a cyano group, a C₁-C₆₀ (e.g. C₁-C₂₀) alkyl group unsubstituted or substituted with at least one R₁₀ₐ, a C₁-C₆₀ (e.g. C₁-C₂₀) alkoxy group unsubstituted or substituted with at least one R₁₀ₐ, a C₆-C₆₀ (e.g. C₆-C₃₀) aryl group unsubstituted or substituted with at least one R₁₀ₐ, a C₁-C₆₀ (e.g. C₃-C₂₀) heteroaryl group unsubstituted or substituted with at least one R₁₀ₐ, or -Si(Q₁)(Q₂)(Q₃),
wherein Q₁ to Q₃ may be each independently:
hydrogen, deuterium, -F, a cyano group; or
a C₁-C₆₀ (e.g. C₁-C₂₀) alkyl group, a C₁-C₆₀ (e.g. C₁-C₂₀) alkoxy group, a C₆-C₆₀ (e.g. C₆-C₃₀) aryl group, or a C₁-C₆₀ (e.g. C₃-C₂₀) heteroaryl group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any suitable combination thereof.

In an embodiment, R₁ and R₁₀ may each be hydrogen or deuterium.

R₁₁ and (L₁)ₐ₁-R₁₅ in Formula 1 are optionally bonded to each other to form a C₅-C₆₀ (e.g. C₅-C₃₀) carbocyclic group or a C₁-C₆₀ (e.g. C₃-C₂₀) heterocyclic group. R₁₁ may be bonded to (L₁)ₐ₁-R₁₅, or may not be bonded to (L₁)ₐ₁-R₁₅. R₁₁ may be bonded to (L₁)ₐ₁, or may not be bonded to (L₁)ₐ₁. R₁₁ may be bonded to R₁₅, or may not be bonded to R₁₅.

In an embodiment, the C₅-C₆₀ carbocyclic group or the C₁-C₆₀ heterocyclic group, which is formed by bonding R₁₁ and (L₁)ₐ₁-R₁₅ to each other, may be a 14-membered ring. The 14-membered ring may include C, Si and N as ring forming atoms.

In an embodiment, when R₁₁ and (L₁)ₐ₁-R₁₅ are bonded to each other, R₁₁ may be -Si(Q₁)(Q₂)(Q₃), and at least one selected from Q₁ to Q₃ may be a phenyl group unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any suitable combination thereof. In some embodiments, each of Q₁ to Q₃ may be a phenyl group unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any suitable combination thereof. In some embodiments, when R₁₁ and (L₁)ₐ₁-R₁₅ are bonded to each other, R₁₁ may be -Si(Q₁)(Q₂)(Q₃), and at least one selected from Q₁ to Q₃ may be bonded to (L₁)ₐ₁-R₁₅.

In an embodiment, when R₁₁ and (L₁)ₐ₁-R₁₅ are bonded to each other, (L₁)ₐ₁-R₁₅ may include a carbazole group unsubstituted or substituted with at least one R₁₀ₐ.

R₁₃ and R₁₄ each bonded to Si in Formula 1 may each independently be a C₅-C₆₀ (e.g. C₅-C₃₀) carbocyclic group unsubstituted or substituted with at least one R₁₀ₐ or a C₁-C₆₀ (e.g. C₃-C₂₀) heterocyclic group unsubstituted or substituted with at least one R₁₀ₐ.

In an embodiment, R₁₃ and R₁₄ may each independently be a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₆-C₆₀ (e.g. C₆-C₃₀) aryl group unsubstituted or substituted with at least one R₁₀ₐ, or a C₁-C₆₀ (e.g. C₁-C₂₀) heteroaryl group unsubstituted or substituted with at least one R₁₀ₐ. In Formula 1, each of R₁₃ and R₁₄ directly bonded to Si may be selected from the 6-membered rings described above. The six-membered ring may be substituted or unsubstituted. R₁₃ and R₁₄ may each be a phenyl group unsubstituted or substituted with a phenyl group. When R₁₃ and R₁₄ are each a biphenyl group, R₁₃ and R₁₄ may each independently be ortho-biphenyl, meta-biphenyl or para-biphenyl in terms of a positional relationship with Si. R₁₃ and R₁₄ may each independently be a phenyl group, a biphenyl group, or a terphenyl group.

In an embodiment, the organic compound may be represented by Formula 1-1: 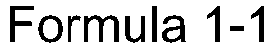 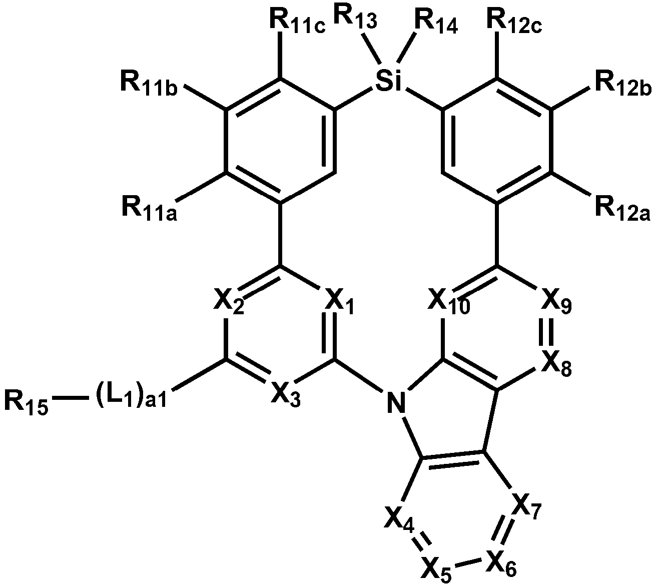 wherein, in Formula 1-1,
X₁ to X₁₀, L₁, a1, and R₁₃ to R₁₅ are each as described in connection with Formula 1,
R₁₁ₐ to R_{11c} are each as described in connection with R₁₁ in Formula 1, and
R₁₂ₐ to R_{12c} are each as described in connection with R₁₂ in Formula 1.
R₁₁ₐ to R_{11c} and R₁₂ₐ to R_{12c} in Formula 1-1 may each independently be hydrogen, deuterium, -F, -Cl, -Br, -I, a cyano group, a C₁-C₆₀ (e.g. C₁-C₂₀) alkyl group unsubstituted or substituted with at least one R₁₀ₐ, a C₁-C₆₀ (e.g. C₁-C₂₀) alkoxy group unsubstituted or substituted with at least one R₁₀ₐ, a C₆-C₆₀ (e.g. C₆-C₃₀) aryl group, a C₁-C₆₀ (e.g. C₃-C₂₀) heteroaryl group unsubstituted or substituted with at least one R₁₀ₐ, or -Si(Q₁)(Q₂)(Q₃),
wherein Q₁ to Q₃ may be each independently:
hydrogen, deuterium, -F, a cyano group; or
a C₁-C₆₀ (e.g. C₁-C₂₀) alkyl group, a C₁-C₆₀ (e.g. C₁-C₂₀) alkoxy group, a C₆-C₆₀ (e.g. C₆-C₃₀) aryl group, or a C₁-C₆₀ (e.g. C₃-C₂₀) heteroaryl group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any suitable combination thereof.

According to an embodiment, R_{11b} and (L₁)ₐ₁-R₁₅ in Formula 1-1 may optionally be bonded to each other to form a C₅-C₆₀ (e.g. C₅-C₃₀) carbocyclic group or a C₁-C₆₀ (e.g. C₃-C₂₀) heterocyclic group. R_{11b} may be bonded to (L₁)ₐ₁-R₁₅ or may not be bonded to (L₁)ₐ₁-R₁₅ R_{11b} may be bonded to (L₁)ₐ₁ or may not be bonded to (L₁)ₐ₁. R_{11b} may be bonded to R₁₅ or may not be bonded to R₁₅.

In an embodiment, the C₅-C₆₀ carbocyclic group or the C₁-C₆₀ heterocyclic group, which is formed by bonding R_{11b} and (L₁)ₐ₁-R₁₅ to each other, may be a 14-membered ring. The 14-membered ring may include C, Si and N as ring forming atoms.

In an embodiment, when R_{11b} and (L₁)ₐ₁-R₁₅ are bonded to each other, R_{11b} may be -Si(Q₁)(Q₂)(Q₃), and at least one selected from Q₁ to Q₃ may be a phenyl group unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any suitable combination thereof. In some embodiments, each of Q₁ to Q₃ may be a phenyl group unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any suitable combination thereof. In some embodiments, when R_{11b} and (L₁)ₐ₁-R₁₅ are bonded to each other, R_{11b} may be -Si(Q₁)(Q₂)(Q₃), and at least one selected from Q₁ to Q₃ may be bonded to (L₁)ₐ₁-R₁₅.

In an embodiment, when R_{11b} and (L₁)ₐ₁-R₁₅ are bonded to each other, (L₁)ₐ₁-R₁₅ may include a carbazole group unsubstituted or substituted with at least one R₁₀ₐ.

A group represented by *-(L₁)ₐ₁-R₁₅ in Formulae 1 and 1-1 may be a group represented by one of Formulae LR1 to LR74:

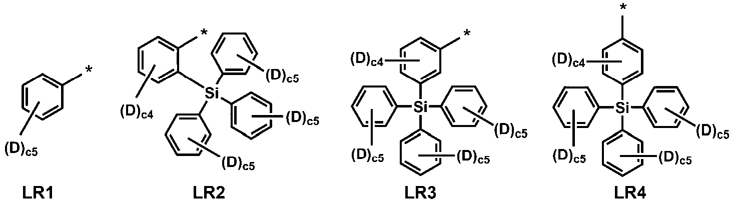

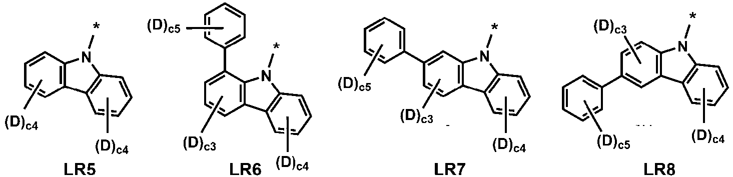

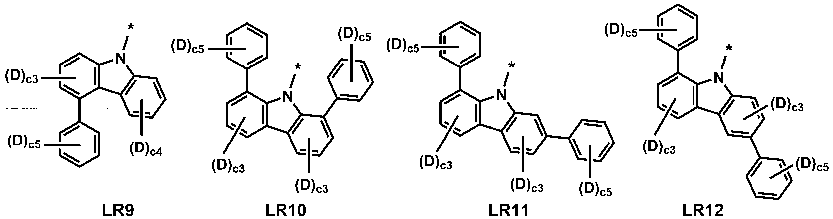

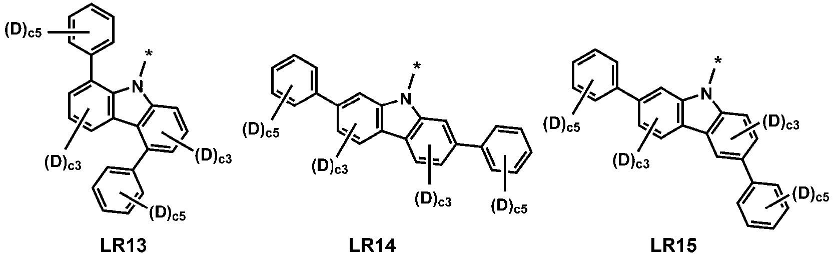

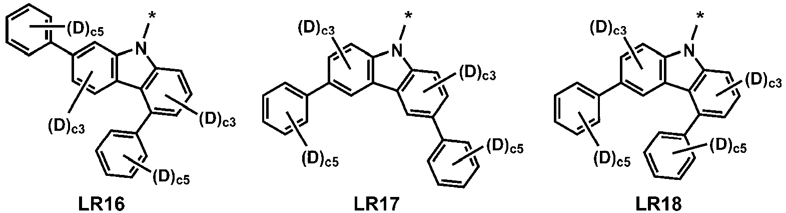

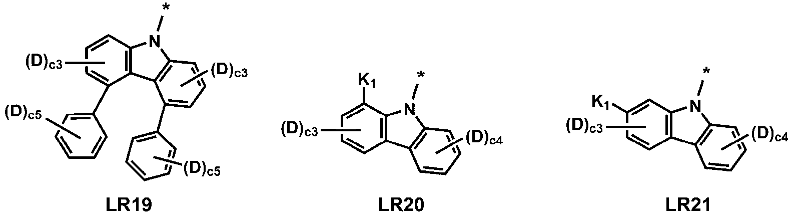

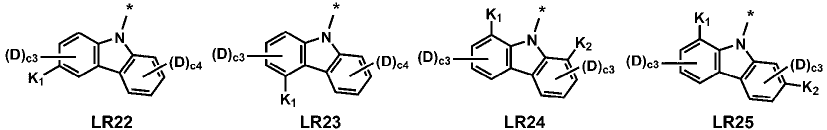

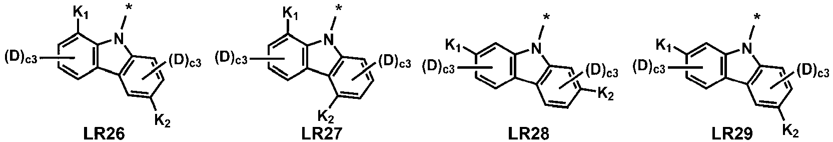

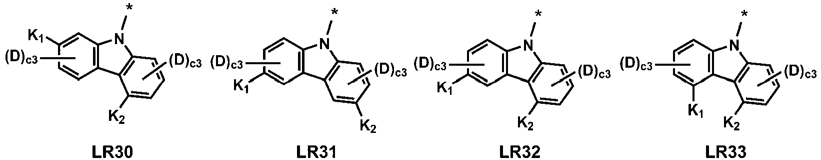

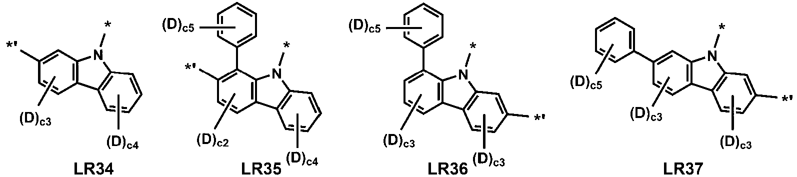

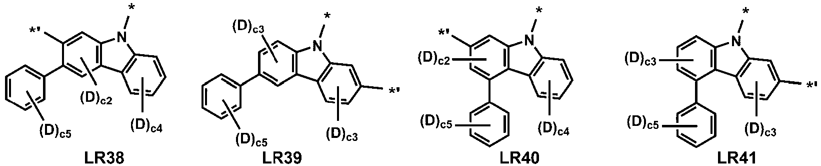

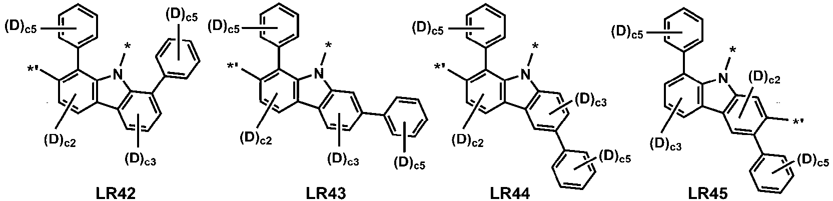

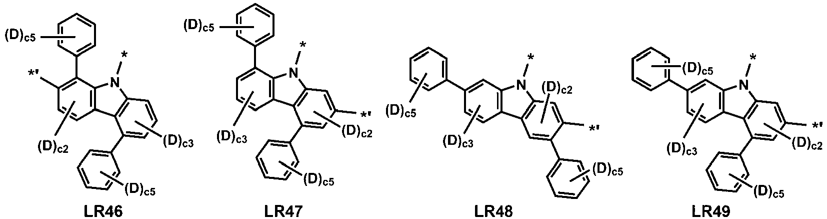

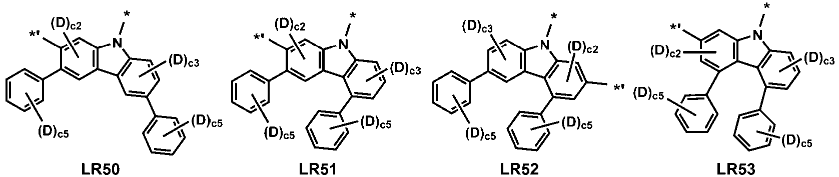

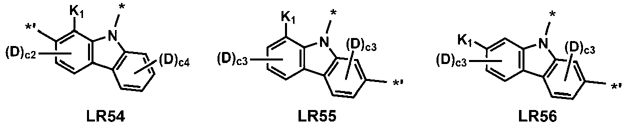

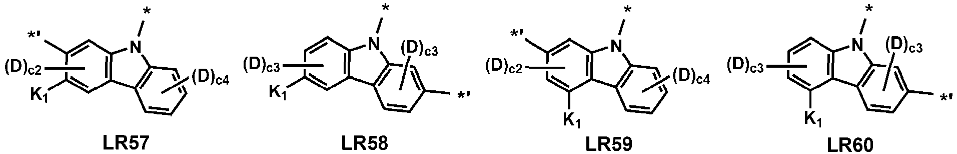

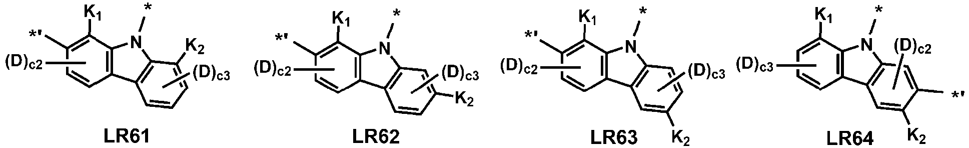

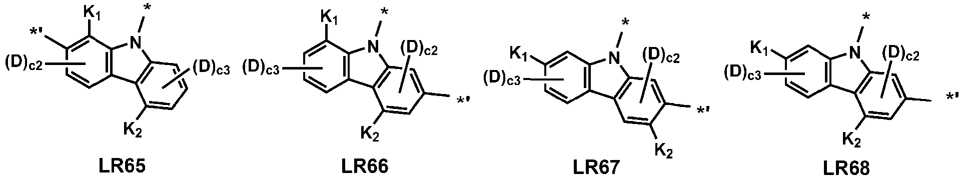

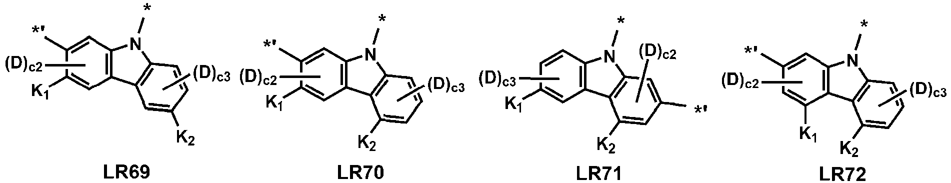

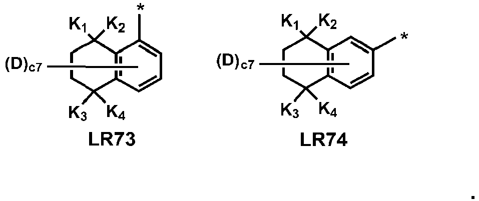

In Formulae LR1 to LR74,
D is deuterium,
K₁ to K₄ are each independently a C₁-C₆₀ (e.g. C₁-C₂₀) alkyl group unsubstituted or substituted with at least one R₁₀ₐ,
c2 is an integer from 0 to 2,
c3 is an integer from 0 to 3,
c4 is an integer from 0 to 4,
c5 is an integer from 0 to 5,
c7 may be an integer from 0 to 7,
* indicates a binding site to a neighboring atom,
*' indiates a binding site to R₁₁ in Formula 1 or a binding site to R_{11b} in Formula 1-1.

In an embodiment, the organic compound may be represented by one of Formulae 1A to 1E: 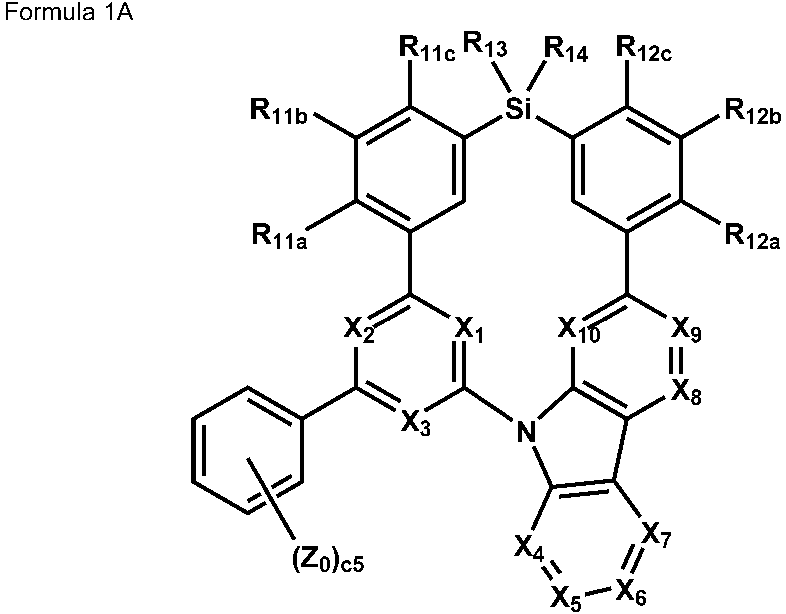 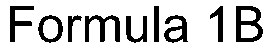 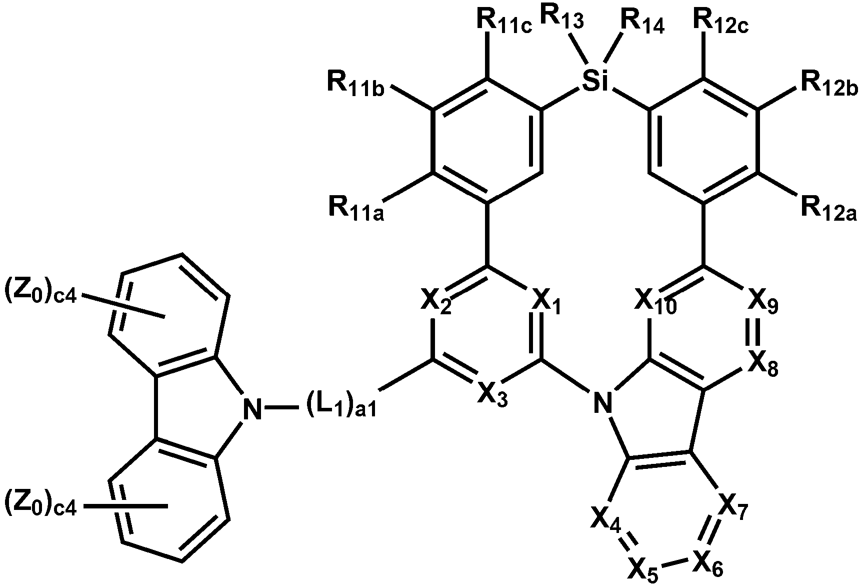 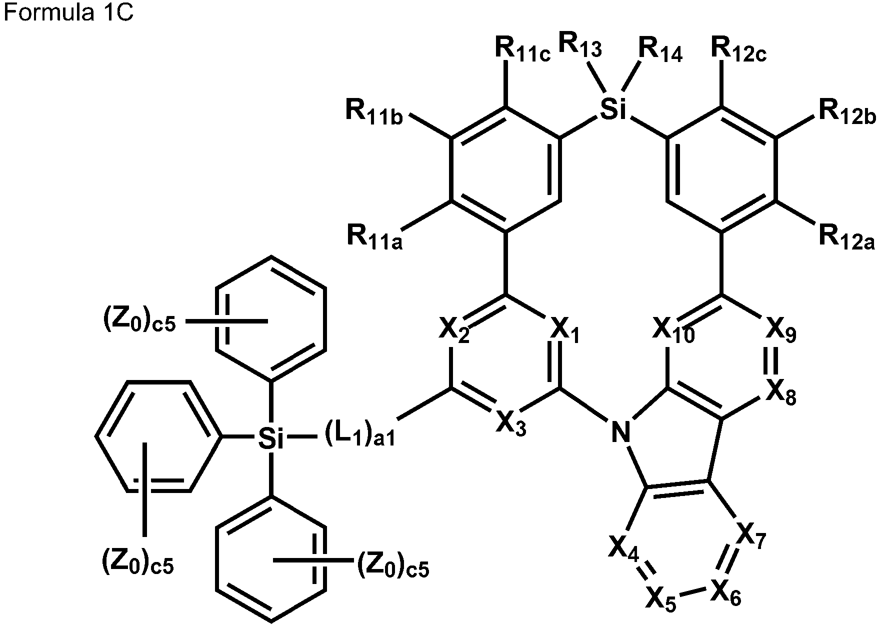 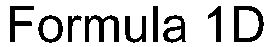 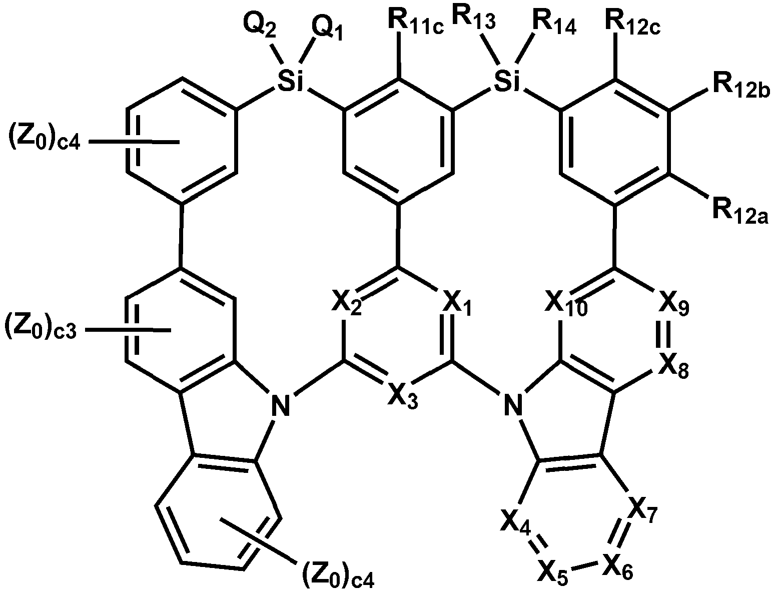 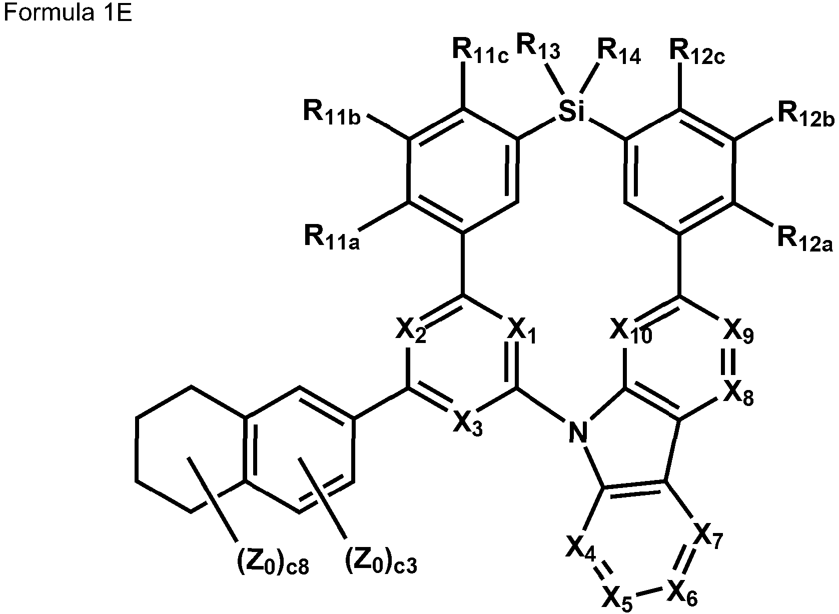 wherein, in Formulae 1A to 1E,
X₁ to X₁₀, L₁, a1, R₁₃, R₁₄, Q_{1,} and Q₂ are each as described in connection with Formula 1,
R₁₁ₐ to R_{11c} are each as described in connection with R₁₁ in Formula 1,
R₁₂ₐ to R_{12c} are each as described in connection with R₁₂ in Formula 1,
Z₀ is deuterium, -F, a cyano group, a C₁-C₆₀ (e.g. C₁-C₂₀) alkyl group, a C₁-C₆₀ (e.g. C₁-C₂₀) alkoxy group, a phenyl group, or a biphenyl group,
c3 is an integer from 0 to 3,
c4 is an integer from 0 to 4,
c5 is an integer from 0 to 5, and
c8 is an integer from 0 to 8.

The components shown in Formulae 1A to 1E are not to be construed as being optionally combinable with each other. Components that are shown as not to be bonded to each other are not to be construed as being bonded to each other and are not to be construed as being capable of being bonded to each other. For example, regarding Formula 1 described above, "R₁₁ and (L₁)ₐ₁-R₁₅ may optionally be bonded to each other." This wording may indicate the case where each of Formula 1A to 1C and 1E is an example of "R₁₁ and (L₁)ₐ₁-R₁₅ are not bonded to each other" and Formula 1D is an example of "R₁₁ and (L₁)ₐ₁-R₁₅ are bonded to each other."

According to an embodiment, the organic compound may be one of Compounds 1 to 144:

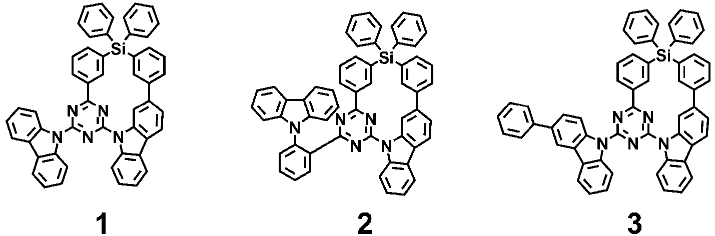

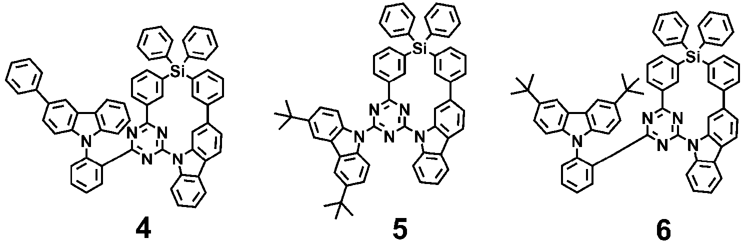

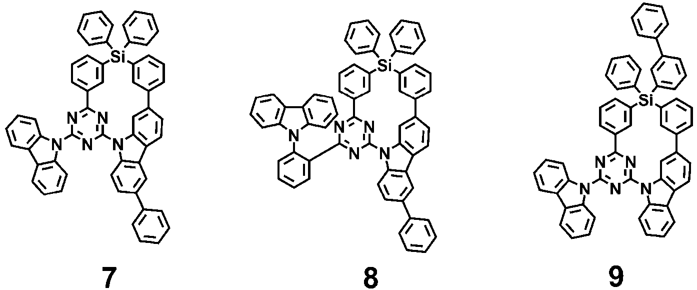

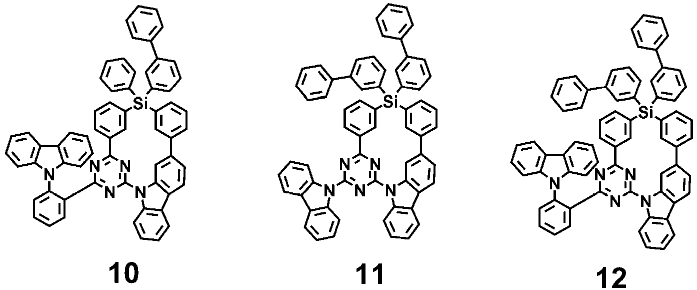

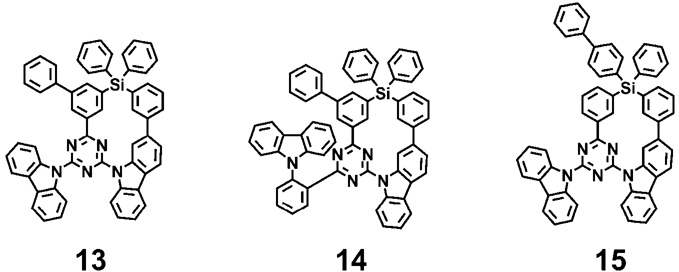

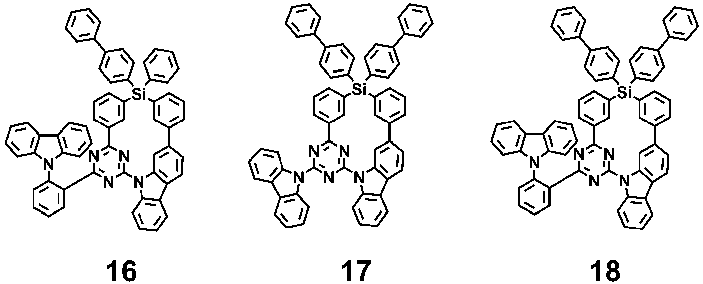

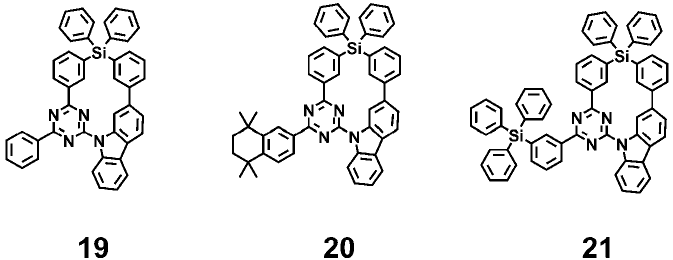

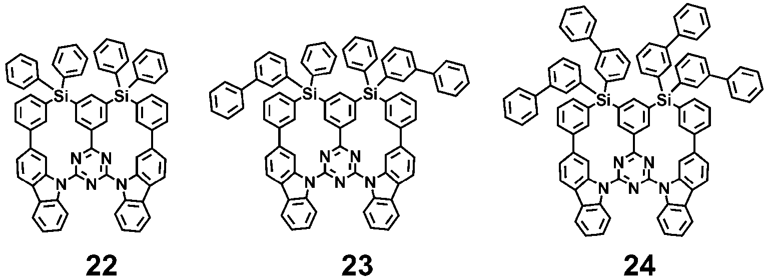

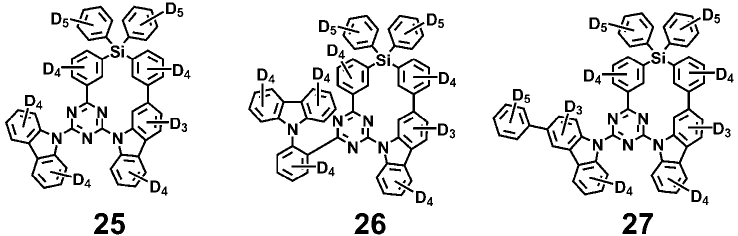

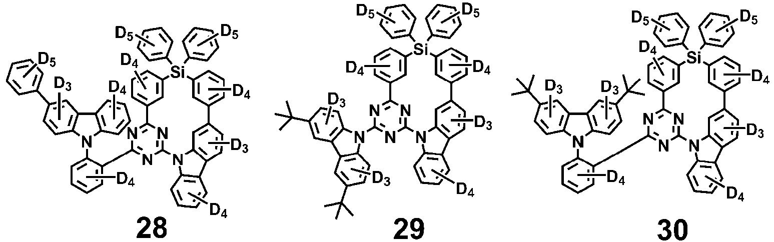

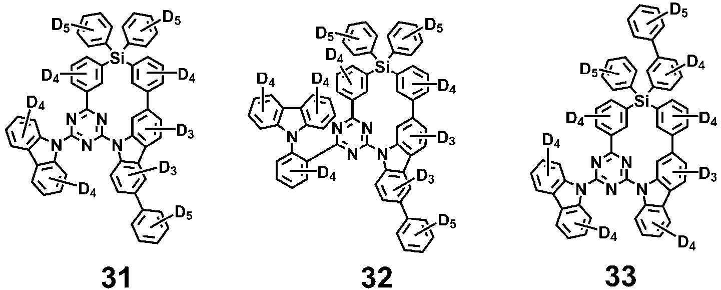

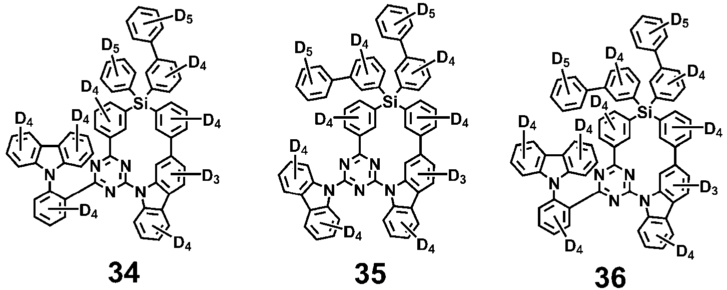

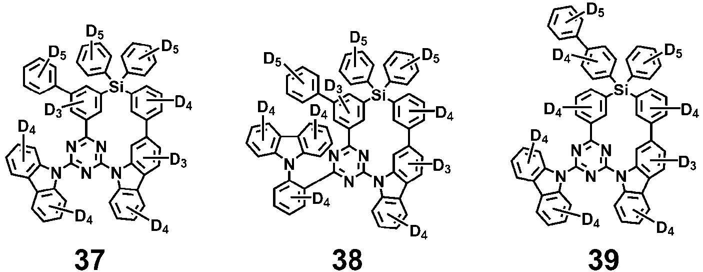

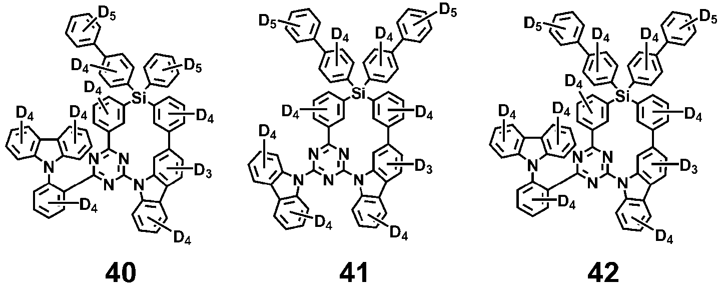

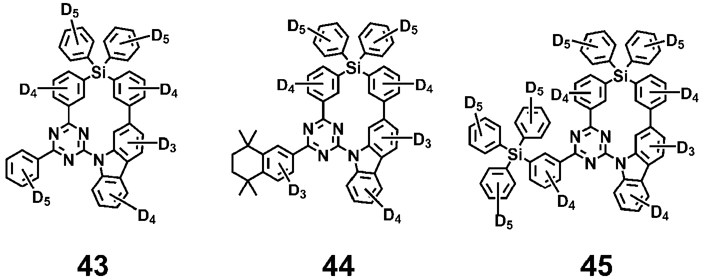

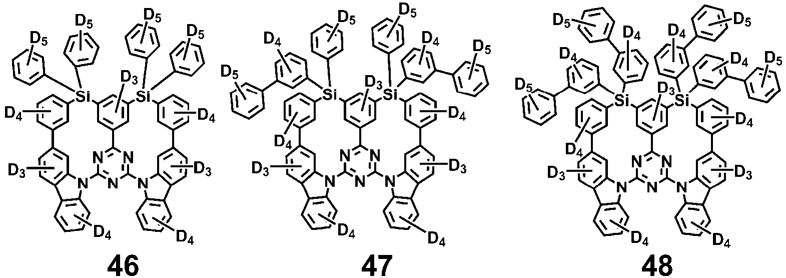

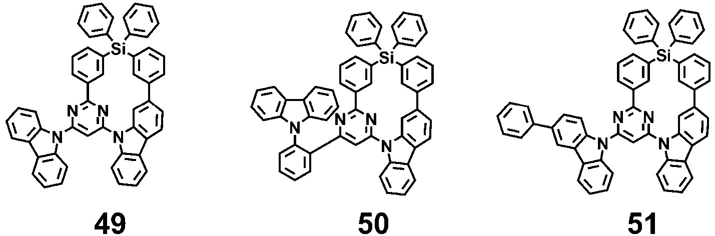

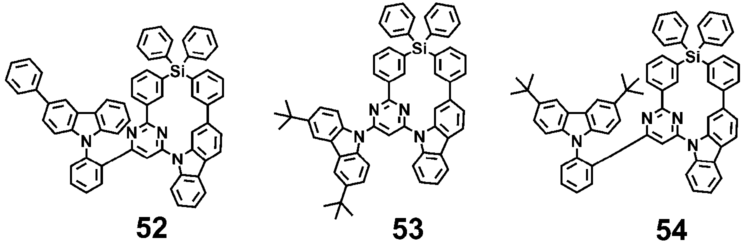

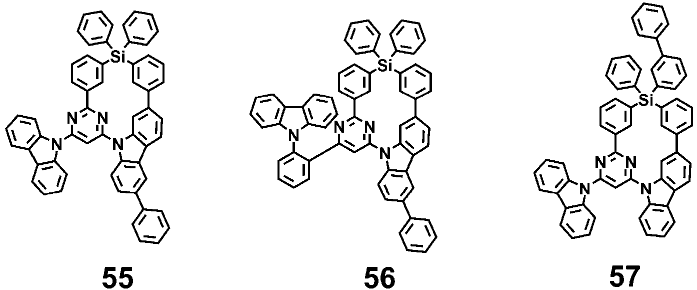

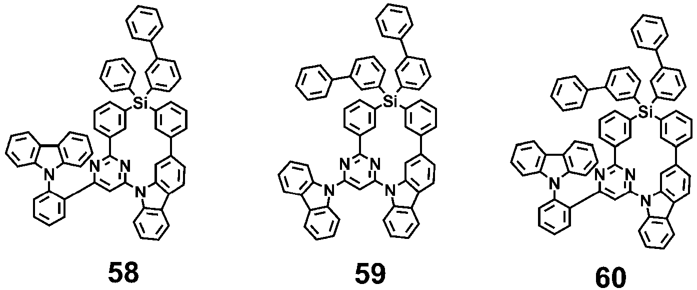

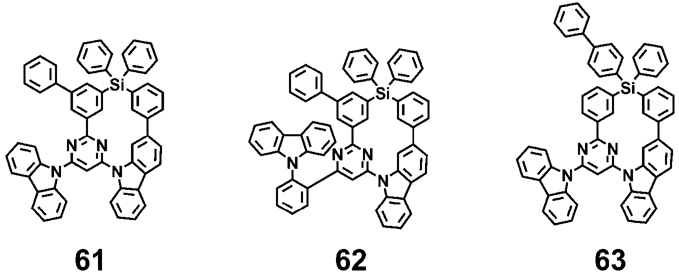

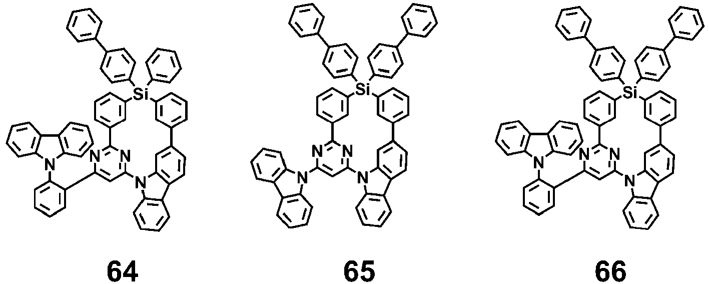

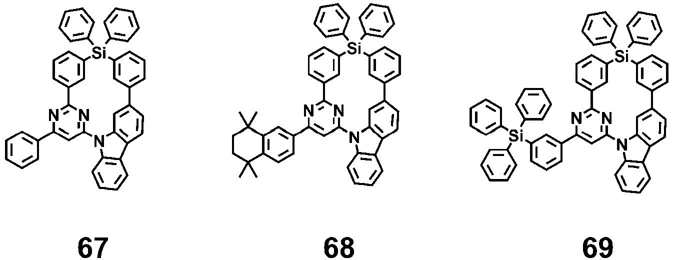

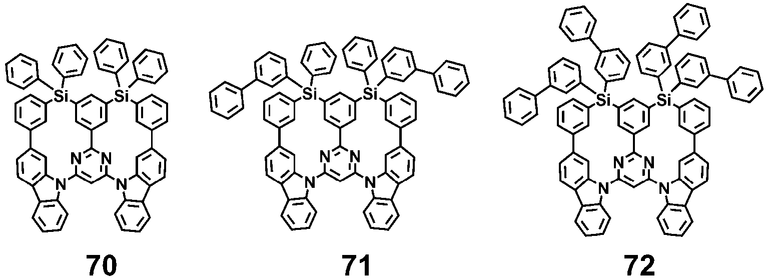

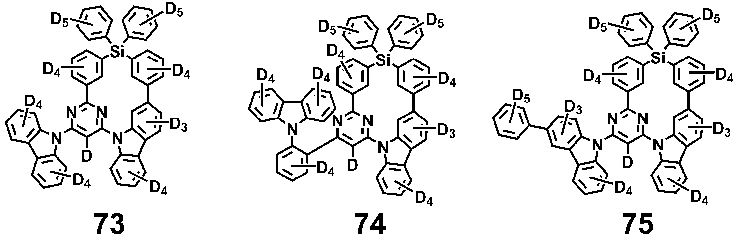

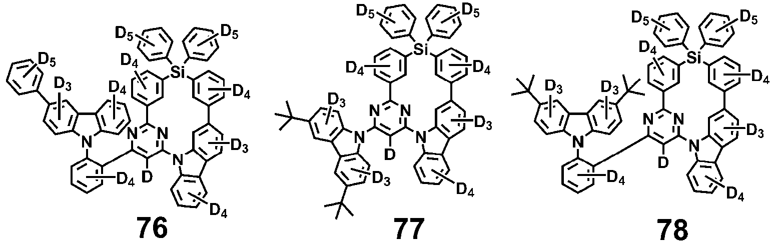

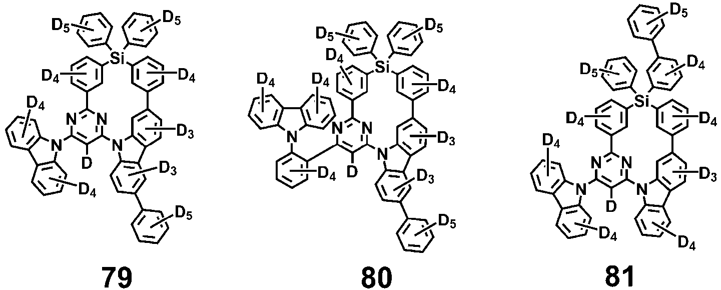

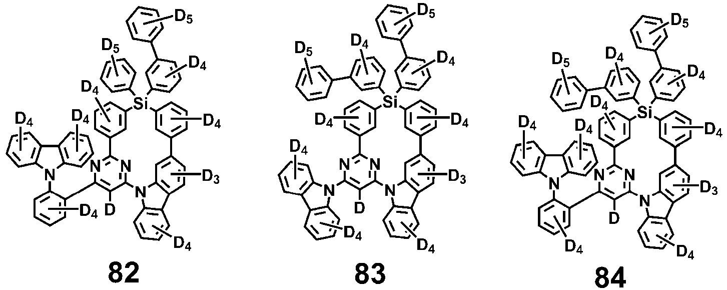

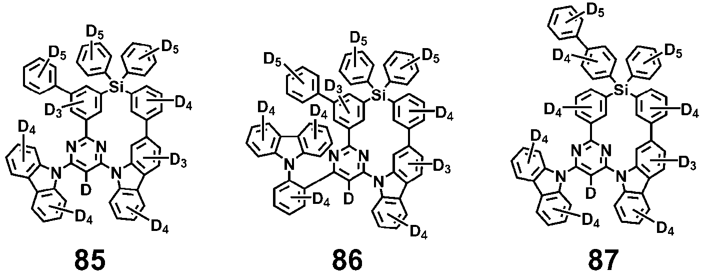

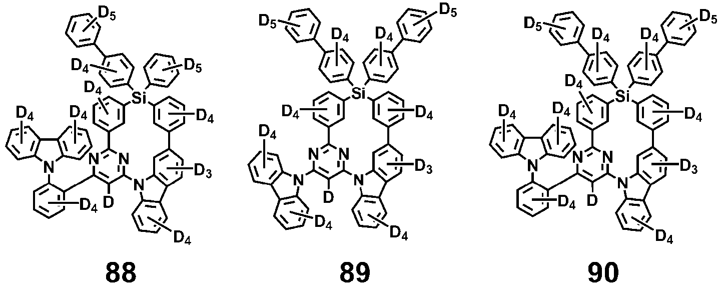

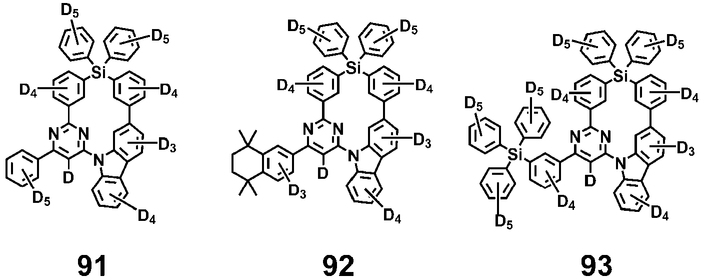

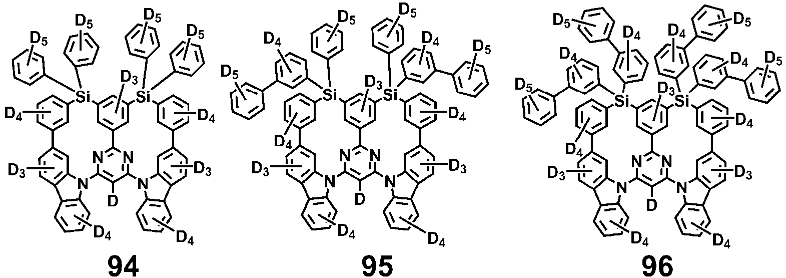

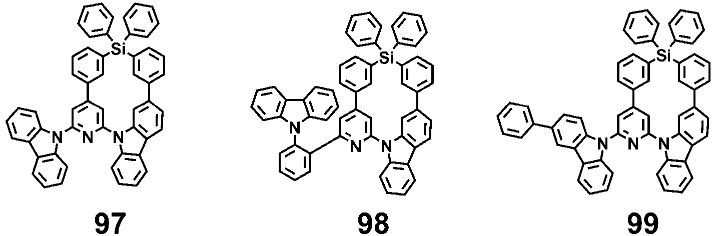

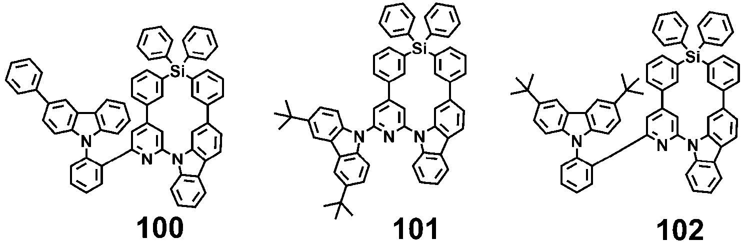

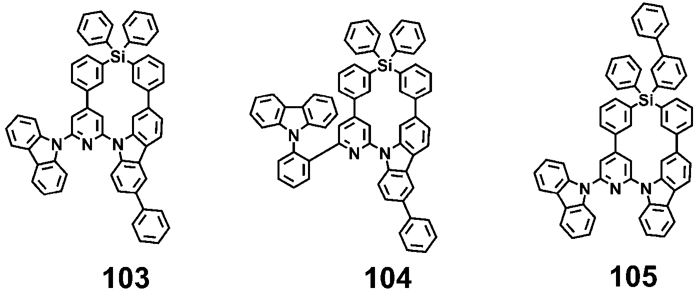

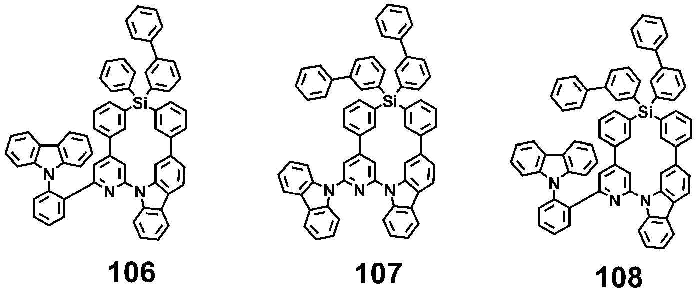

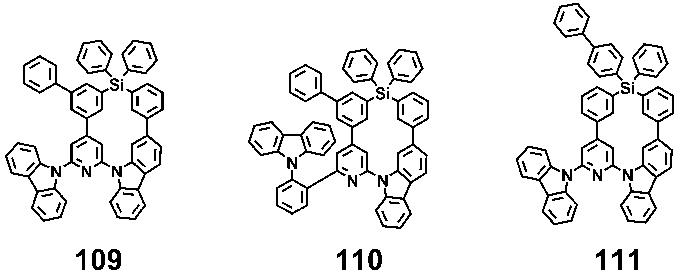

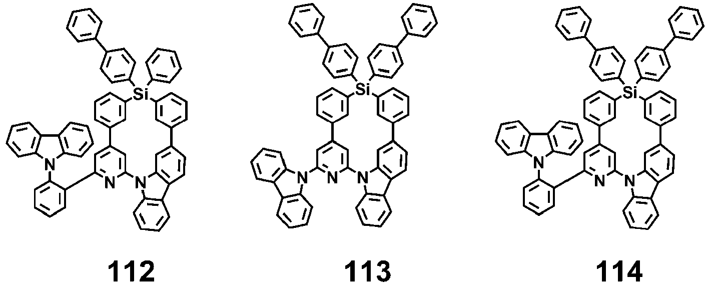

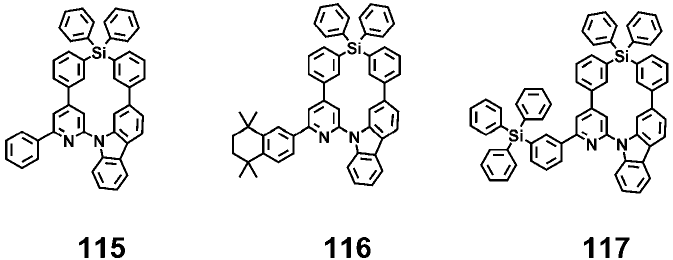

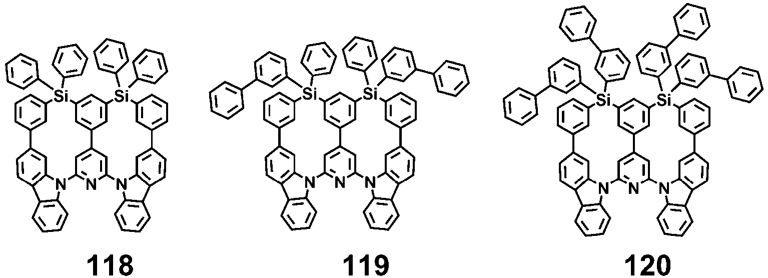

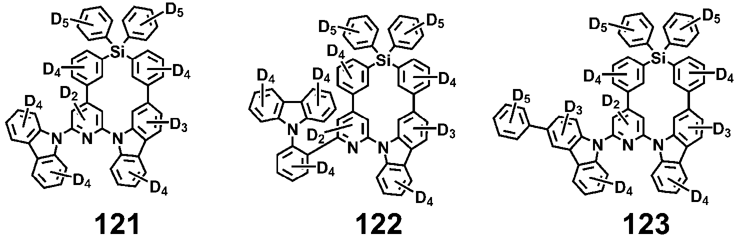

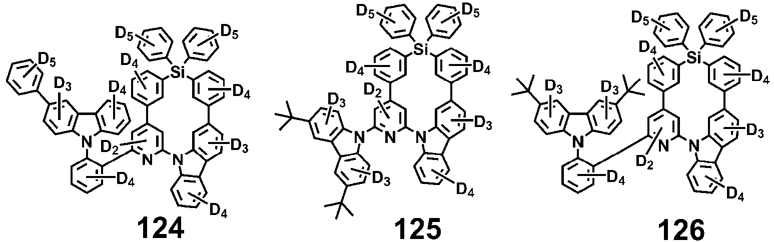

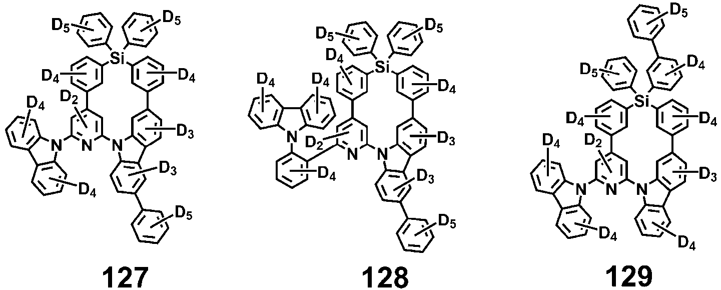

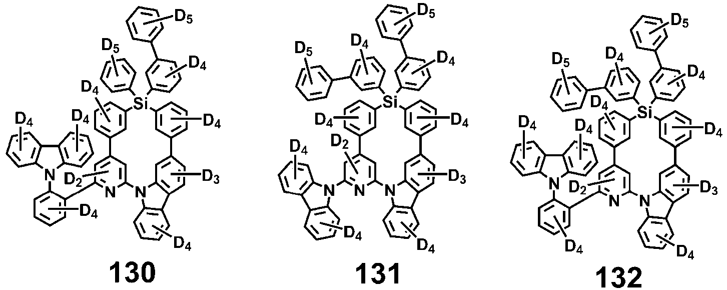

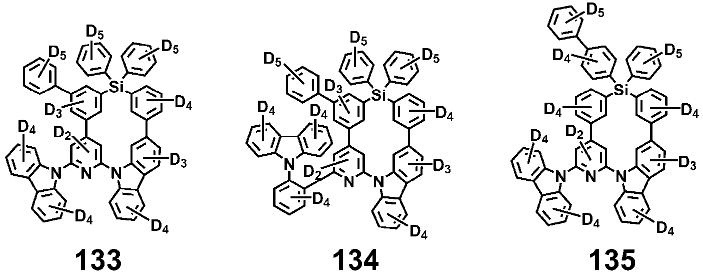

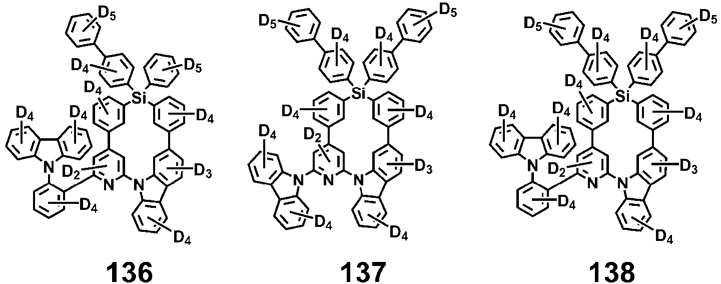

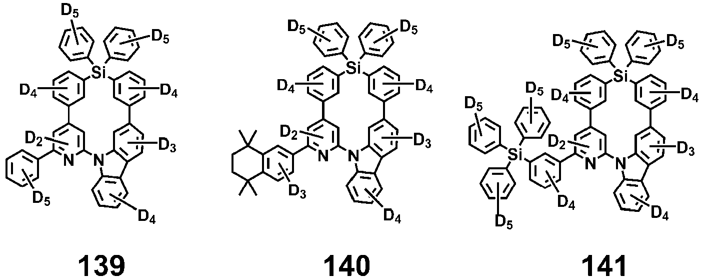

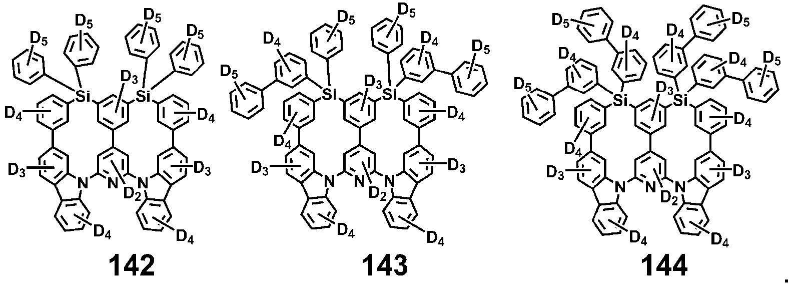

Regarding Compounds 1 to 144, D indicates deuterium, D₂ indicates a substitution with two deuterium, D₃ indicates a substitution with three deuterium, D₄ indicates a substitution with four deuterium, and D₅ indicates a substitution with five deuterium. Compounds 1 to 144 include compounds 1 to 24, 49 to 72, 97 to 120 that are not substituted with deuterium and compounds 25 to 48, 73 to 96, 121 to 144 in which all hydrogen atoms are substituted with deuterium. However, organic compounds according to embodiments may include a compound in which some of a plurality of hydrogen atoms may be substituted with deuterium.

Because such organic compounds satisfy the structure of Formula 1 described above, the organic compound may have a 14-membered ring. The 14-membered ring refers to ring CY₃ in Formula 1T which is substantially identical to Formula 1, and the ring forming atom consists of X₁-T₁-T₂-T₃-T₄-Si-T₅-T₆-T₇-T₈-X₁₀-T₉-N-T₁₀: 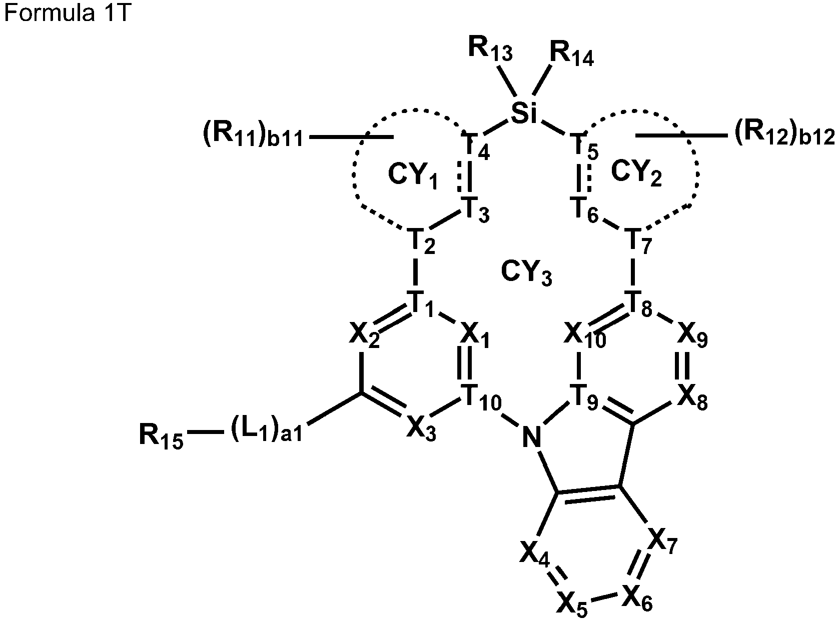 wherein, in Formula 1T,
T₁ to T₁₀ each indicate a carbon atom at a corresponding position in Formula 1, and
the bond represented by 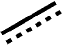 , CY₁, CY₂, X₁ to X₁₀, L₁, a1, R₁₁ to R₁₅, b11, and b12 are each as described in connection with Formula 1.

The organic compound has a ring containing X₁ to X₃ having electron-attracting properties so that the lowest unoccupied molecular orbital (LUMO) is located in the ring, and has the 14-membered ring so that the electron transfer properties are improved, and the structural stability, photochemical stability and robustness are enhanced, and the steric hindrance effect may incur, thereby suppressing or reducing the formation of an exciplex with different compounds. For example, when the organic compound is used as a host, the possibility of exciplex formation between the organic compound and the dopant can be effectively reduced. Therefore, the organic compound having the structure as described above may have excellent luminescence properties and properties suitable for use as a high-color purity luminescent material. For example, a light-emitting device including the organic compound may exhibit low driving voltage, high efficiency, and/or long life.

According to another aspect of embodiments, a light-emitting device is provided, including: a first electrode; a second electrode facing the first electrode; and an interlayer between the first electrode and the second electrode and including an emission layer; wherein the interlayer includes at least one of the organic compounds represented by Formula 1.

According to an embodiment, the emission layer may include the organic compound described above.

According to an embodiment, the emission layer may further include a dopant selected from a fluorescent dopant, a phosphorescent dopant, a delayed fluorescent dopant, and any suitable combination thereof, and the amount of the organic compound may be greater than the amount of the dopant. For example, the organic compound may act as a host.

According to an embodiment, the emission layer may emit red light, green light, or blue light. For example, the emission layer including the organic compound may emit blue light.

According to an embodiment, the light-emitting device may further include at least one selected from a first capping layer on an outer side of the first electrode; and a second capping layer on an outer side of the second electrode; wherein at least one selected from the first capping layer and the second capping layer may include the organic compound.

For example, the light-emitting device may further include a first capping layer on an outer side of the first electrode, and the first capping layer may include the organic compound represented by Formula 1.

In some embodiments, the light-emitting device may further include a second capping layer on an outer side of the second electrode, and the second capping layer may include the organic compound represented by Formula 1.

In some embodiments, the light-emitting device may further include a first capping layer on an outer side of the first electrode and a second capping layer on an outer side of the second electrode, and at least one selected from the first capping layer and the second capping layer each of which may include the organic compound represented by Formula 1.

The wording "(the interlayer, the emission layer and/or the capping layer) includes at least one organic compound" in this specification may be interpreted as "(the interlayer, the emission layer and/or the capping layer) may include one organic compound falling within the scope of Formula 1 or two or more different organic compounds falling within the scope of Formula 1."

For example, the interlayer may include only Compound 1 as the organic compound. In this regard, Compound 1 may be present in the emission layer of the light-emitting device. In one or more embodiments, the interlayer may include, as the organic compound, Compound 1 and Compound 2. In this regard, Compound 1 and Compound 2 may exist in the same layer (for example, both Compound 1 and Compound 2 may exist in the emission layer).

The term "interlayer" in this specification refers to a single and/or a plurality of layers between the first electrode and the second electrode of a light-emitting device. The "interlayer" may include not only the organic compounds described above, but also an organometallic complex containing a metal.

According to another aspect of embodiments, a display device is provided, including: the light-emitting device described above; and a thin film transistor electrically connected to the light-emitting device.

In an embodiment, the display device may further include a color filter, a color conversion layer, a touch screen layer, a polarizing layer, or a combination thereof.

According to another aspect of embodiments, an electronic device is provided, including: the display device; and a processor that transmits signals to the display device, wherein the electronic device is one selected from a flat panel display, a curved display, a computer monitor, a medical monitor, a television, a billboard, indoor or outdoor lighting and/or signaling lights, a head-up display, a fully or partially transparent display, a flexible display, a rollable display, a foldable display, a stretchable display, smart glasses, a head-mounted display, a smart watch, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, an augmented reality display, a vehicle dashboard, a center information display (CID) for a vehicle, a head-up display for a vehicle, a rearview mirror display, a video wall including a plurality of displays that are tiled together, a theater screen, a stadium screen, a light therapy device, and a signage.

Hereinafter, the structures of the light-emitting device, the display device, and the electronic device are described with reference to the drawings.

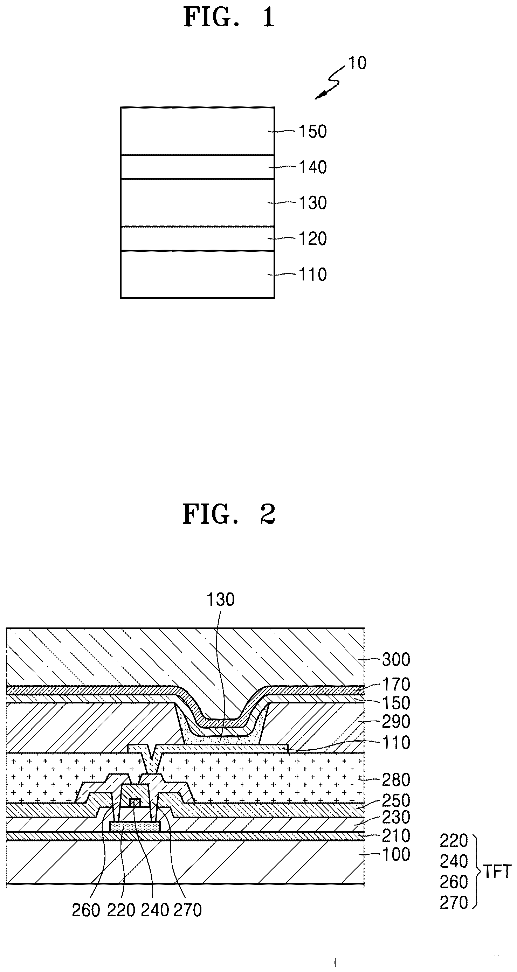

FIG. 1 is a schematic cross-sectional view of a light-emitting device 10 according to an embodiment. The light-emitting device 10 may include a first electrode 110, an interlayer, and a second electrode 150. The interlayer may include a hole transport region 120, an emission layer 130, and an electron transport region 140. In some embodiments, the light-emitting device 10 may include a first capping layer on an outer side of the first electrode 110, and thus have a structure of first capping layer/first electrode 110/interlayer/second electrode 150. In some embodiments, the light-emitting device 10 may include a second capping layer on an outer side of the second electrode 150 and thus, have a structure of first electrode 110/interlayer/second electrode 150/second capping layer. In embodiments, the light-emitting device 10 may include a first capping layer on an outer side of the first electrode 110 and a second capping layer on an outer side of the second electrode 150 and thus, have a structure of first capping layer/first electrode 110/interlayer/second electrode 150/second capping layer.

### First electrode 110

In FIG. 1, a substrate may be provided under the first electrode 110 and/or on the second electrode 150. As the substrate, a glass substrate and/or a plastic substrate may be used. The substrate may be a flexible substrate. For example, the substrate may include plastics (e.g., polymers) having excellent heat resistance and durability, such as polyimide, polyethylene terephthalate (PET), polycarbonate, polyethylene naphthalate, polyarylate (PAR), polyetherimide, or any suitable combination thereof.

The first electrode 110 may be formed by depositing and/or sputtering a material to form the first electrode 110 on the substrate. When the first electrode 110 is an anode, a high-work function material that facilitates injection of holes may be used as a material to form the first electrode 110.

The first electrode 110 may be a reflective electrode, a semi-transmissive electrode, or a transmissive electrode. When the first electrode 110 is a transmissive electrode, a material to form the first electrode 110 may include indium tin oxide (ITO), indium zinc oxide (IZO), tin oxide (SnO₂), zinc oxide (ZnO), or any suitable combination thereof. When the first electrode 110 is a semi-transmissive electrode or a reflective electrode, magnesium (Mg), silver (Ag), aluminium (Al), aluminium-lithium (Al-Li), calcium (Ca), magnesium-indium (Mg-In), magnesium-silver (Mg-Ag), or any suitable combination thereof may be used as a material to form the first electrode 110.

The first electrode 110 may have a single-layered structure consisting of a single layer or a multi-layered structure including a plurality of layers. For example, the first electrode 110 may have a three-layer structure of ITO/Ag/ITO.

### Interlayer

The interlayer may be on the first electrode 110. The interlayer may include the hole transport region 120, the emission layer 130, and the electron transport region 140.

The interlayer may include various suitable organic materials, a metal-containing compound such as an organometallic compound, an inorganic material such as quantum dots, and/or the like.

In one or more embodiments, the interlayer may include i) at least two emitting units sequentially stacked between the first electrode 110 and the second electrode 150 and ii) a charge generation layer between the at least two emitting units. When the interlayer includes the emitting units and the charge generation layer as described above, the light-emitting device 10 may be a tandem light-emitting device.

### Hole transport region 120

The hole transport region 120 may have i) a single-layer structure consisting of a single layer including a single material, ii) a single-layer structure consisting of a single layer including a plurality of materials that are different from each other, or iii) a multi-layer structure consisting of a plurality of layers including a plurality of different materials that are different from each other.

The hole transport region 120 may include a hole injection layer, a hole transport layer, an emission auxiliary layer, an electron-blocking layer, or any suitable combination thereof.

For example, the hole transport region 120 may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, wherein constituent layers of each structure are stacked sequentially from the first electrode 110.

The hole transport region 120 may include a compound represented by Formula 201, a compound represented by Formula 202, or any suitable combination thereof: 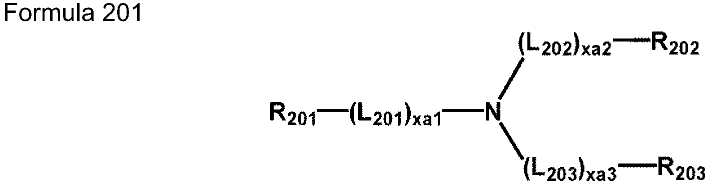 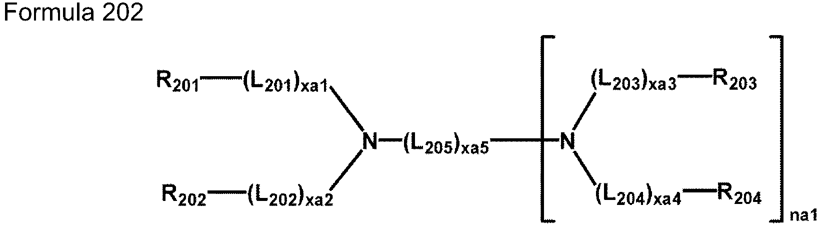 wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ polycyclic group (for example, a carbazole group) that is unsubstituted or substituted with at least one R₁₀ₐ (for example, Compound HT16),
R₂₀₃ and R₂₀₄ may optionally be linked to each other via a single bond (e.g., a single covalent bond), a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

In an embodiment, each of Formulae 201 and 202 may include at least one selected from groups represented by Formulae CY201 to CY217:

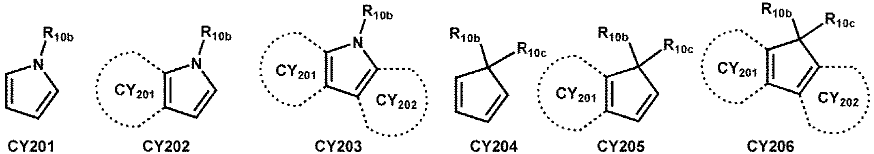

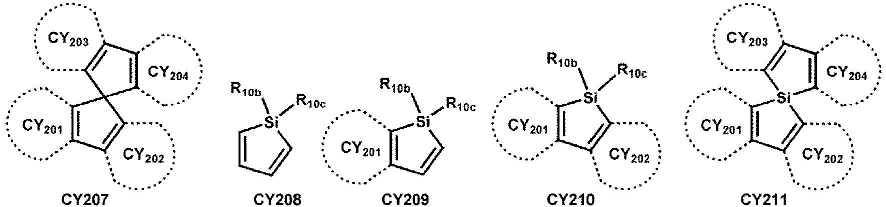

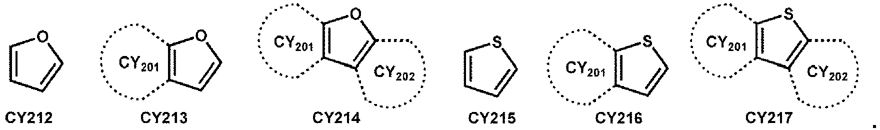

In Formulae CY201 to CY217, R_{10b} and R_{10c} are each the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In an embodiment, in Formulae CY201 to CY217, ring CY₂₀₁ to ring CY₂₀₄ may each independently be a benzene group, a naphthalene group, a phenanthrene group, or an anthracene group.

In an embodiment, each of Formulae 201 and 202 may include at least one selected from groups represented by Formulae CY201 to CY203.

According to another embodiment, Formula 201 may include at least one selected from the groups represented by Formulae CY201 to CY203 and at least one selected from groups represented by Formulae CY204 to CY217.

In an embodiment, in Formula 201, xa1 may be 1, R₂₀₁ may be a group represented by one selected from Formulae CY201 to CY203, xa2 may be 0, and R₂₀₂ may be a group represented by one selected from Formulae CY204 to CY207.

In an embodiment, each of Formulae 201 and 202 may not include groups represented by Formulae CY201 to CY203.

In one or more embodiments, Formulae 201 and 202 may each not include the groups represented by Formulae CY201 to CY203, and may include at least one selected from groups represented by Formulae CY204 to CY217.

In an embodiment, each of Formulae 201 and 202 may not include groups represented by Formulae CY201 to CY217.

For example, the hole transport region 120 may include one selected from Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any suitable combination thereof:

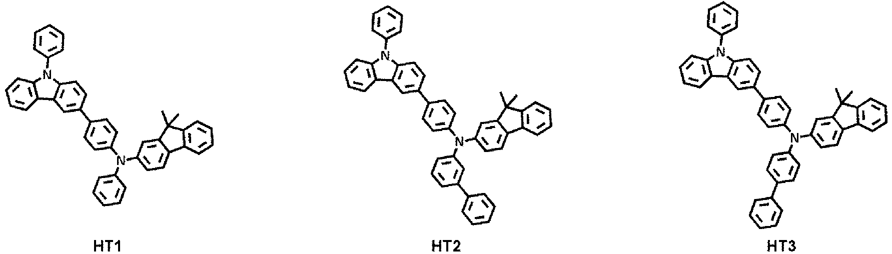

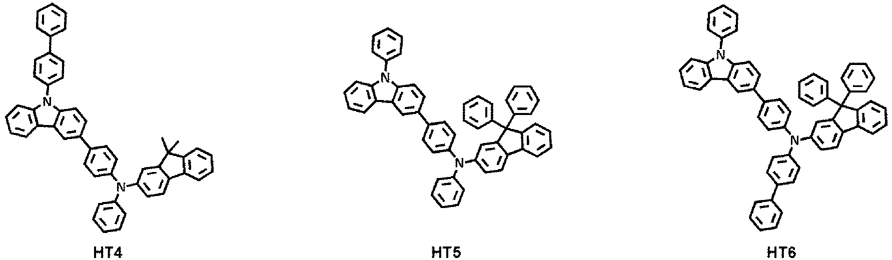

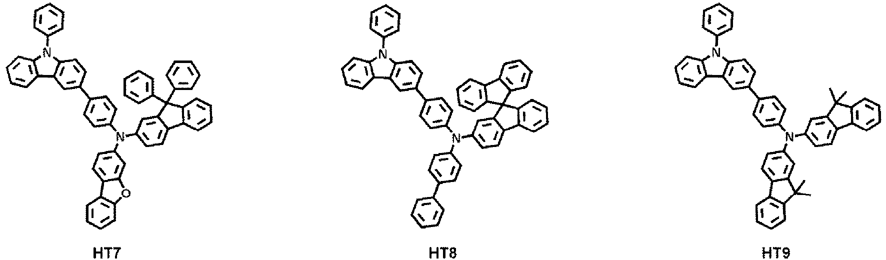

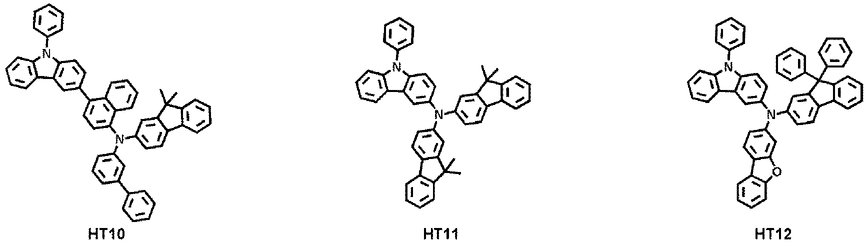

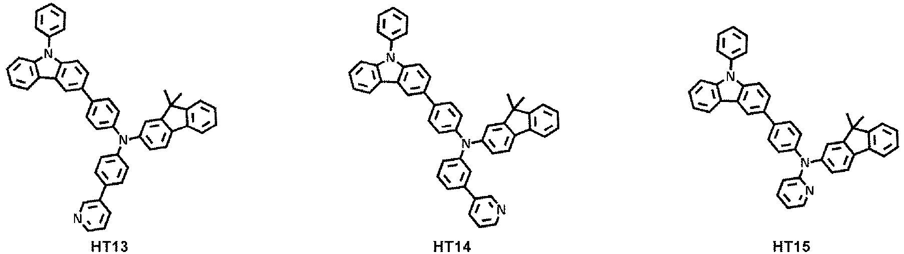

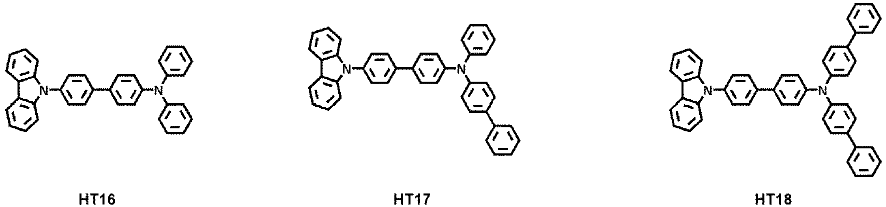

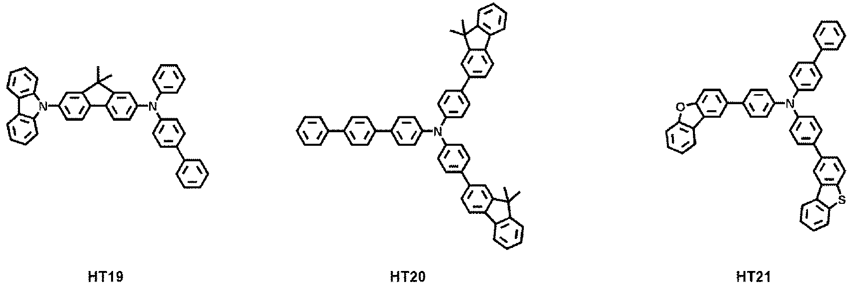

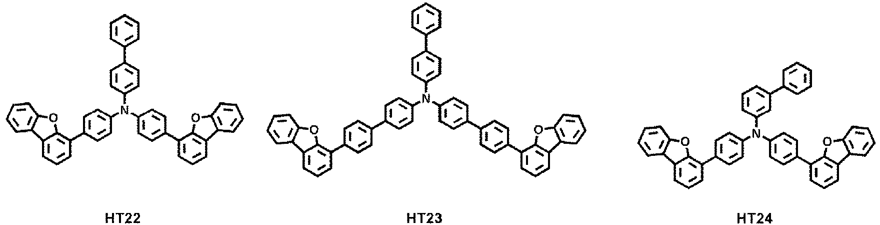

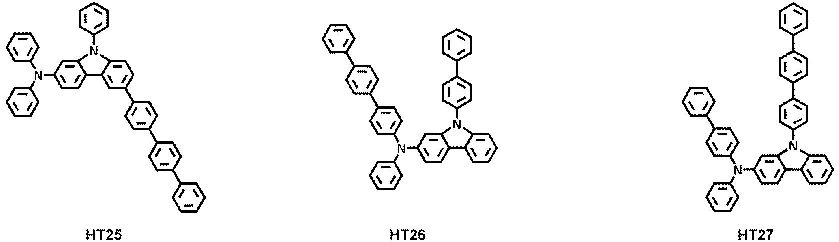

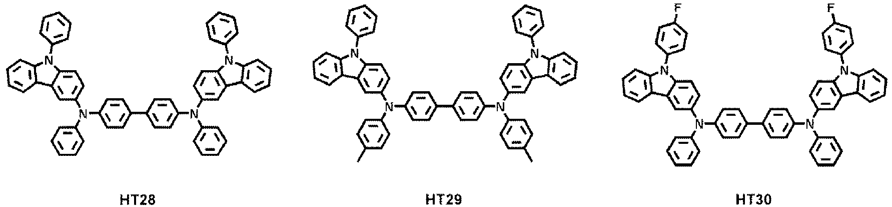

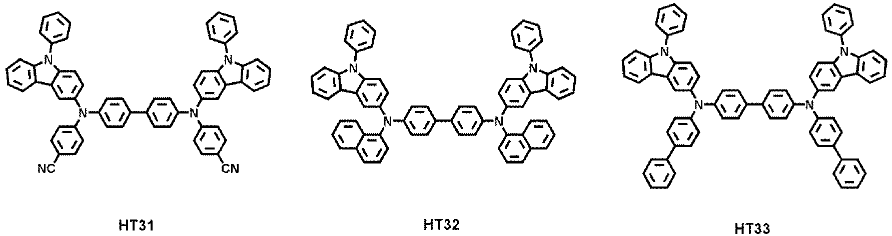

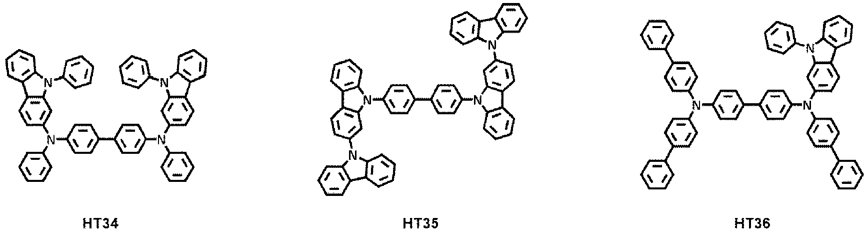

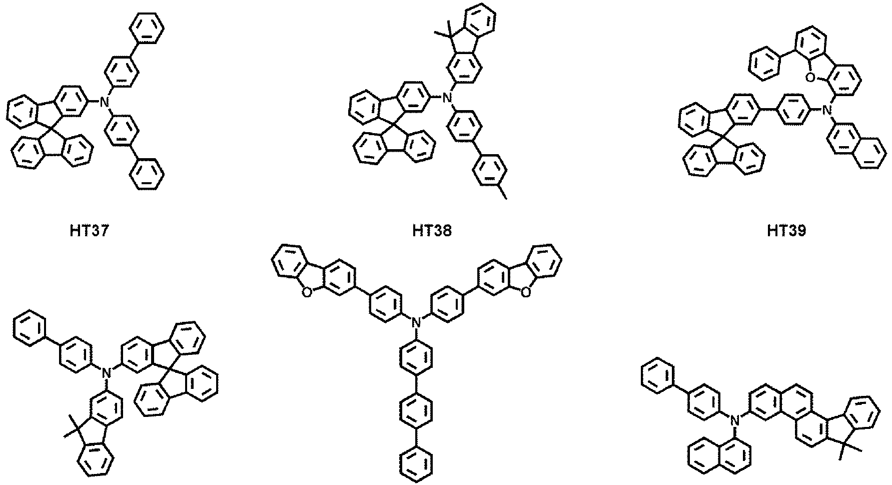

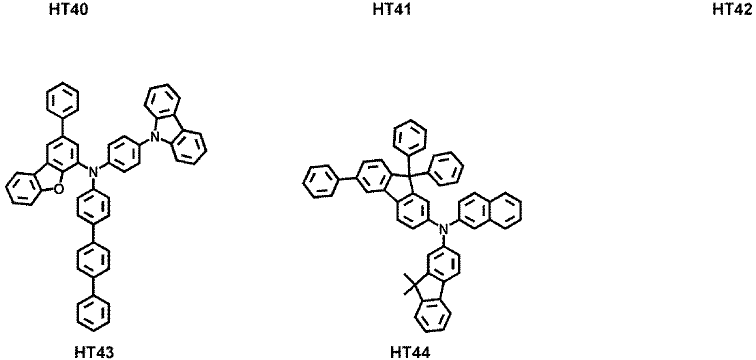

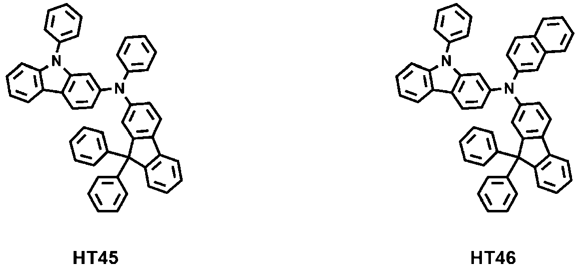

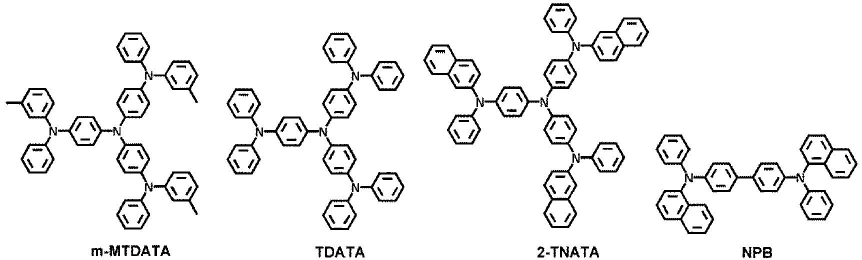

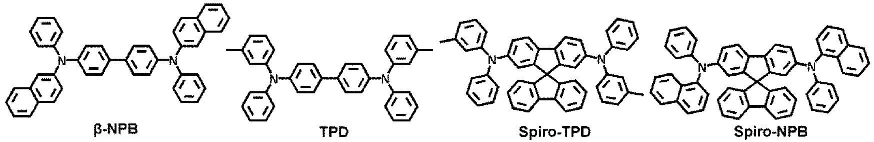

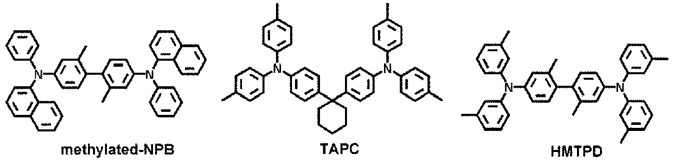

A thickness of the hole transport region 120 may be in a range of about 50 Å to about 10,000 Å, for example, about 100 Å to about 4,000 Å. When the hole transport region 120 includes a hole injection layer, a hole transport layer, or any suitable combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within the ranges described above, suitable or satisfactory hole transporting characteristics may be obtained without a substantial increase in driving voltage.

The emission auxiliary layer may serve to increase light-emission efficiency by compensating for an optical resonance distance according to the wavelength of light emitted by the emission layer. The electron blocking layer may serve to prevent or reduce electron leakage from the emission layer to the hole transport region. Materials that may be included in the hole transport region 120 may be included in the emission auxiliary layer and the electron blocking layer.

### p-dopant

The hole transport region 120 may further include, in addition to the aforementioned materials, a charge-generation material for the improvement of conductive properties (e.g., electrically conductive properties). The charge-generating material may be substantially homogeneously or non-homogeneously dispersed (for example, as a single layer consisting of charge generating material) in the hole transport region 120.

The charge-generation material may be, for example, a p-dopant.

For example, the p-dopant may have a lowest unoccupied molecular orbital (LUMO) energy level of about -3.5 eV or less.

In an embodiment, the p-dopant may include a quinone derivative, a cyano group-containing compound, a compound including an element EL1 and an element EL2, or any suitable combination thereof.

Examples of the quinone derivative are TCNQ and F4-TCNQ.

Examples of the cyano group-containing compound are HAT-CN and a compound represented by Formula 221.

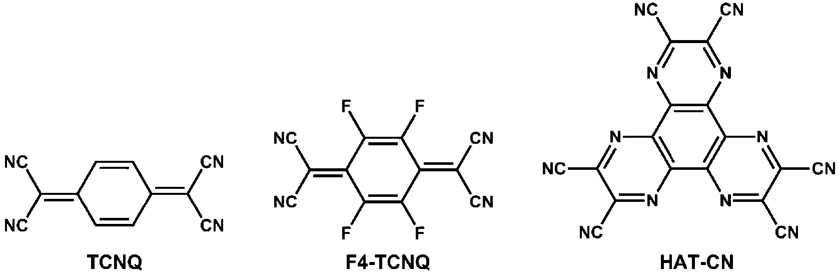

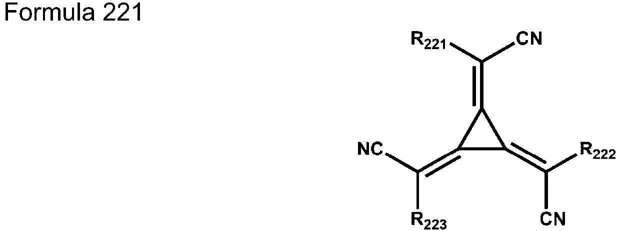

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one selected from R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or any suitable combination thereof; or any suitable combination thereof.

In the compound including the element EL1 and the element EL2, the element EL1 may be a metal, a metalloid, or a combination thereof, and the element EL2 may be a non-metal, a metalloid, or a combination thereof.

Examples of the metal are an alkali metal (for example, lithium (Li), sodium (Na), potassium (K), rubidium (Rb), cesium (Cs), and/or the like); an alkaline earth metal (for example, beryllium (Be), magnesium (Mg), calcium (Ca), strontium (Sr), barium (Ba), and/or the like); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); a post-transition metal (for example, zinc (Zn), indium (In), tin (Sn), and/or the like); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like).

Examples of the metalloid are silicon (Si), antimony (Sb), and tellurium (Te).

Examples of the non-metal are oxygen (O) and halogen (for example, F, Cl, Br, I, and/or the like).

Examples of the compound including the element EL1 and the element EL2 are a metal oxide, a metal halide (for example, a metal fluoride, a metal chloride, a metal bromide, a metal iodide, and/or the like), a metalloid halide (for example, a metalloid fluoride, a metalloid chloride, a metalloid bromide, a metalloid iodide, and/or the like), a metal telluride, or any suitable combination thereof.

Examples of the metal oxide are a tungsten oxide (for example, WO, W₂O₃, WO₂, WO₃, W₂O₅, and/or the like), a vanadium oxide (for example, VO, V₂O₃, VO₂, V₂O₅, and/or the like), a molybdenum oxide (for example, MoO, Mo₂O₃, MoO₂, MoO₃, Mo₂O₅, and/or the like), a rhenium oxide (for example, ReO₃, and/or the like), and/or the like.

Examples of the metal halide are an alkali metal halide, an alkaline earth metal halide, a transition metal halide, a post-transition metal halide, and a lanthanide metal halide.

Examples of the alkali metal halide are LiF, NaF, KF, RbF, CsF, LiCl, NaCl, KCI, RbCl, CsCl, LiBr, NaBr, KBr, RbBr, CsBr, Lil, Nal, KI, Rbl, and Csl.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and BaI₂.

Examples of the transition metal halide are a titanium halide (for example, TiF₄, TiCl₄, TiBr₄, TiI₄, and/or the like), a zirconium halide (for example, ZrF₄, ZrCl₄, ZrBr₄, ZrI₄, and/or the like), a hafnium halide (for example, HfF₄, HfCl₄, HfBr₄, HfI₄, and/or the like), a vanadium halide (for example, VF₃, VCl₃, VBr₃, VI₃, and/or the like), a niobium halide (for example, NbF₃, NbCl₃, NbBr₃, NbI₃, and/or the like), a tantalum halide (for example, TaF₃, TaCl₃, TaBr₃, TaI₃, and/or the like), a chromium halide (for example, CrF₃, CrCl₃, CrBr₃, CrI₃, and/or the like), a molybdenum halide (for example, MoF₃, MoCl₃, MoBr₃, MoI₃, and/or the like), a tungsten halide (for example, WF₃, WCl₃, WBr₃, WI₃, and/or the like), a manganese halide (for example, MnF₂, MnCl₂, MnBr₂, MnI₂, and/or the like), a technetium halide (for example, TcF₂, TcCl₂, TcBr₂, TcI₂, and/or the like), a rhenium halide (for example, ReF₂, ReCl₂, ReBr₂, ReI₂, and/or the like), an iron halide (for example, FeF₂, FeCl₂, FeBr₂, FeI₂, and/or the like), a ruthenium halide (for example, RuF₂, RuCl₂, RuBr₂, RuI₂, and/or the like), an osmium halide (for example, OsF₂, OsCl₂, OsBr₂, OsI₂, and/or the like), a cobalt halide (for example, CoF₂, CoCl₂, CoBr₂, CoI₂, and/or the like), a rhodium halide (for example, RhF₂, RhCl₂, RhBr₂, RhI₂, and/or the like), an iridium halide (for example, IrF₂, IrCl₂, IrBr₂, IrI₂, and/or the like), a nickel halide (for example, NiF₂, NiCl₂, NiBr₂, NiI₂, and/or the like), a palladium halide (for example, PdF₂, PdCl₂, PdBr₂, PdI₂, and/or the like), a platinum halide (for example, PtF₂, PtCl₂, PtBr₂, PtI₂, and/or the like), a copper halide (for example, CuF, CuCl, CuBr, Cul, and/or the like), a silver halide (for example, AgF, AgCl, AgBr, Agl, and/or the like), and a gold halide (for example, AuF, AuCl, AuBr, Aul, and/or the like).

Examples of the post-transition metal halide are a zinc halide (for example, ZnF₂, ZnCl₂, ZnBr₂, ZnI₂, and/or the like), an indium halide (for example, InI₃, and/or the like), a tin halide (for example, SnI₂, and/or the like), and/or the like.

Examples of the lanthanide metal halide are YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, and/or the like.

Examples of the metalloid halide are an antimony halide (for example, SbCl₅, and/or the like).

Examples of the metal telluride are alkali metal telluride (for example, Li₂Te, Na₂Te, K₂Te, Rb₂Te, Cs₂Te, and/or the like), alkaline earth metal telluride (for example, BeTe, MgTe, CaTe, SrTe, BaTe, and/or the like), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and/or the like), post-transition metal telluride (for example, ZnTe, and/or the like), and lanthanide metal telluride (for example, LaTe, CeTe, PrTe, NdTe, PmTe, EuTe, GdTe, TbTe, DyTe, HoTe, ErTe, TmTe, YbTe, LuTe, and/or the like).

### Emission layer

When the light-emitting device 10 is a full-color light-emitting device, the emission layer 130 may be patterned into a red emission layer, a green emission layer, and/or a blue emission layer, according to a subpixel. In one or more embodiments, the emission layer 130 may have a stacked structure of two or more layers of a red emission layer, a green emission layer, and a blue emission layer, in which the two or more layers contact each other or are separated from each other to emit white light. In one or more embodiments, the emission layer may include two or more materials of a red light-emitting material, a green light-emitting material, and a blue light-emitting material, in which the two or more materials are mixed with each other in a single layer to emit white light.

The emission layer 130 may include a host and a dopant. The dopant may include a phosphorescent dopant, a fluorescent dopant, or any suitable combination thereof.

The amount of the dopant in the emission layer 130 may be from about 0.01 part by weight to about 15 parts by weight with respect to 100 parts by weight of the host.

The emission layer 130 may include a quantum dot.

The emission layer 130 may include a delayed fluorescence material. The delayed fluorescence material may act as a host or a dopant in the emission layer.

The thickness of the emission layer 130 may be in a range of about 100 Å to about 1,000 Å, and in some embodiments, about 200 Å to about 600 Å. When the thickness of the emission layer is within the ranges described above, excellent luminescence characteristics may be obtained without a substantial increase in driving voltage.

### Host

The host may include a compound represented by Formula 301:

Formula 301 [Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ,-Si(Q₃₀₁)(Q₃₀₂)(Q₃₀₃₎, -N(Q₃₀₁)(Q₃₀₂), -B(Q₃₀₁)(Q₃₀₂), -C(=O)(Q₃₀₁), -S(=O)₂(Q₃₀₁), or - P(=O)(Q₃₀₁)(Q₃₀₂),
xb21 may be an integer from 1 to 5, and
Q₃₀₁ to Q₃₀₃ are each as described in connection with Q₁.

In an embodiment, when xb11 in Formula 301 is 2 or more, two or more of Ar₃₀₁ may be linked to each other via a single bond (e.g., a single covalent bond).

In an embodiment, the host may include a compound represented by Formula 301-1, a compound represented by Formula 301-2, or any suitable combination thereof: 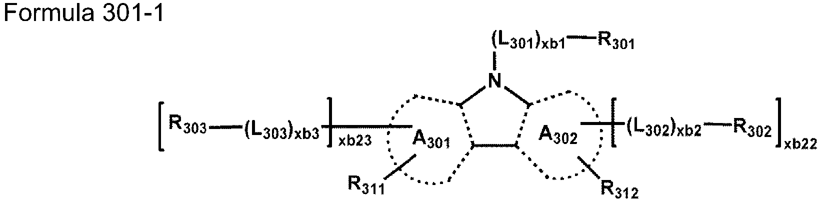 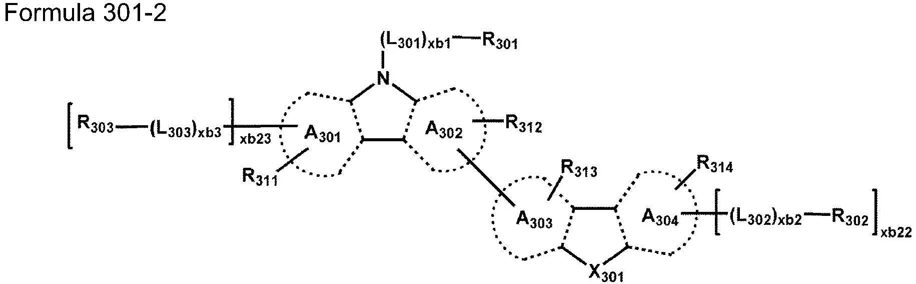 wherein, in Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ are each as described in the present specification,
L₃₀₂ to L₃₀₄ are each independently as described in connection with L₃₀₁,
xb2 to xb4 are each independently as described in connection with xb1, and
R₃₀₂ to R₃₀₅ and R₃₁₁ to R₃₁₄ are each as described in connection with R₃₀₁.

In an embodiment, the host may include an alkali earth metal complex, a post-transition metal complex, or any suitable combination thereof. In an embodiment, the host may include a Be complex (for example, Compound H55), an Mg complex, a Zn complex, or any suitable combination thereof.

In an embodiment, the host may include: one selected from Compounds H1 to H128; 9,10-di(2-naphthyl)anthracene (ADN); 2-methyl-9,10-bis(naphthalen-2-yl)anthracene (MADN); 9,10-di-(2-naphthyl)-2-t-butyl-anthracene (TBADN); 4,4'-bis(N-carbazolyl)-1,1'-biphenyl (CBP); 1,3-di(carbazol-9-yl)benzene (mCP); 1,3,5-tri(carbazol-9-yl)benzene (TCP); or any suitable combination thereof:

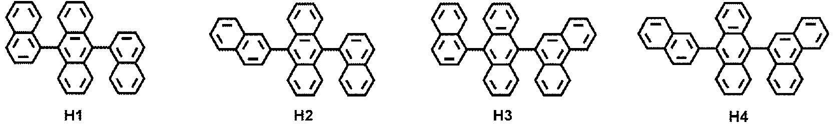

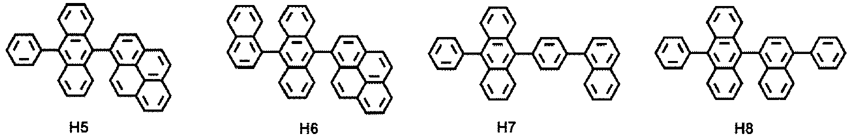

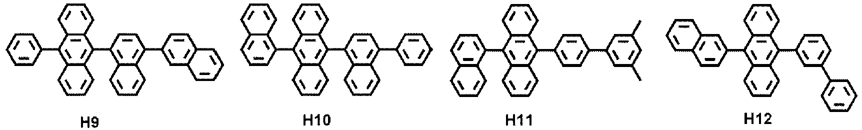

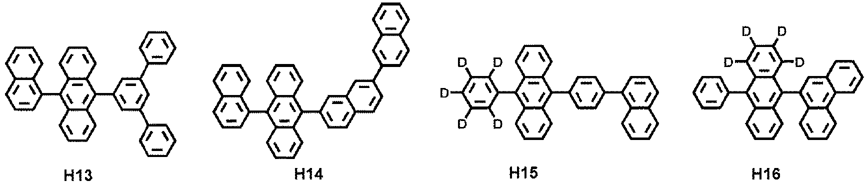

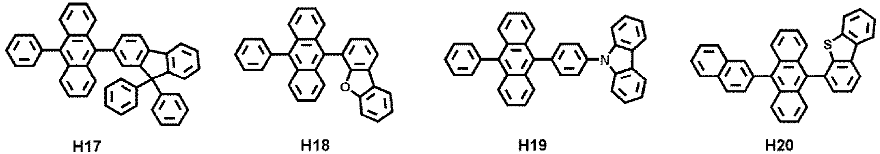

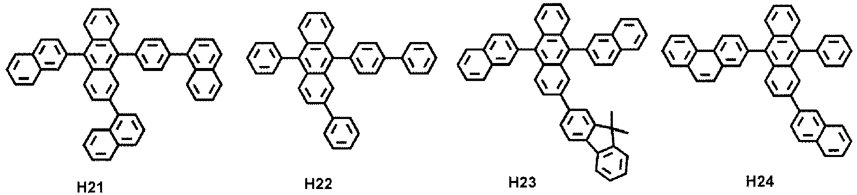

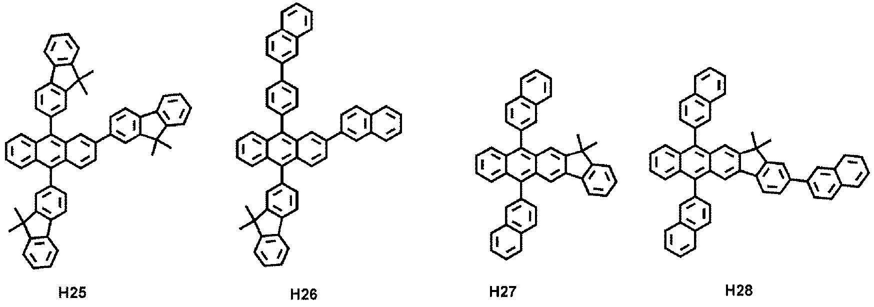

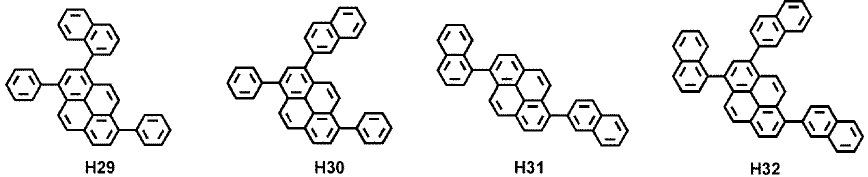

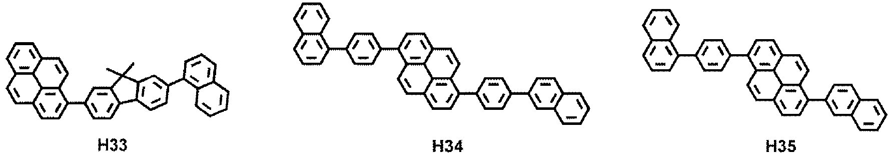

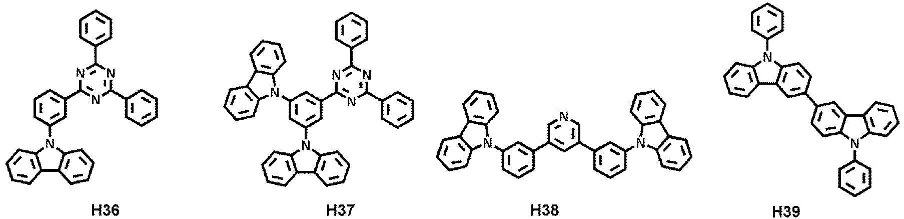

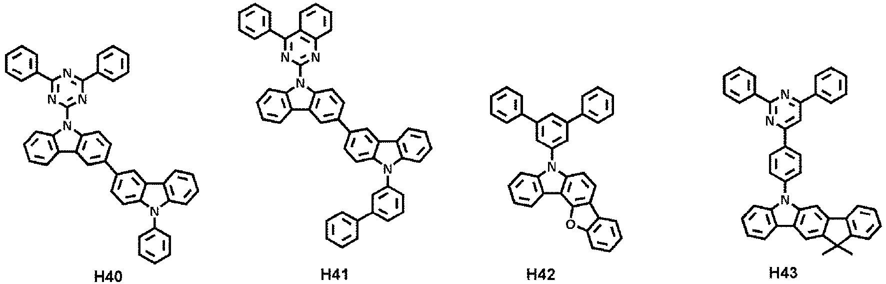

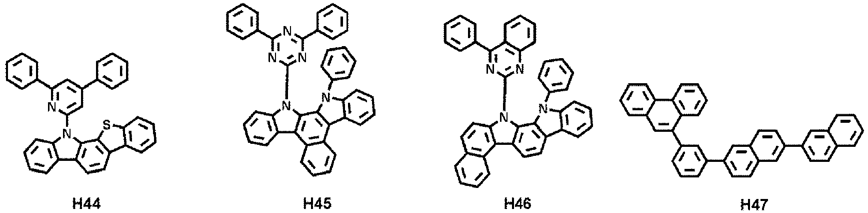

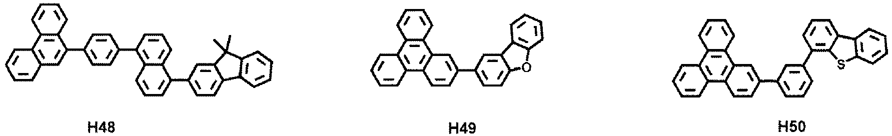

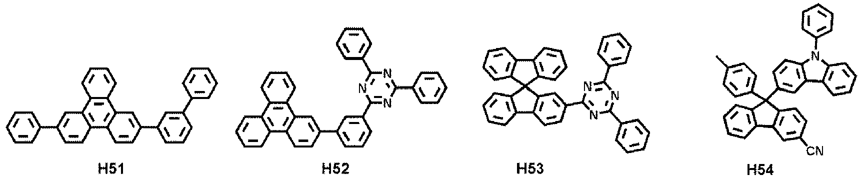

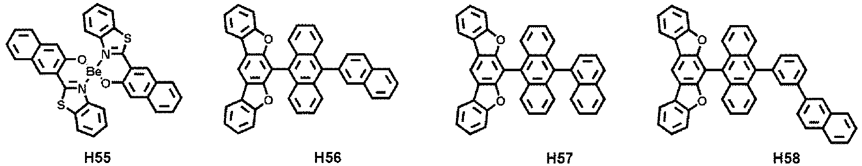

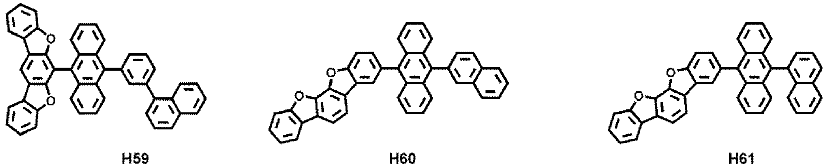

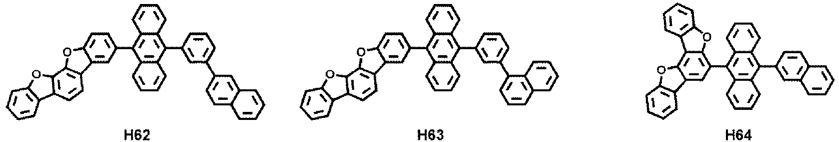

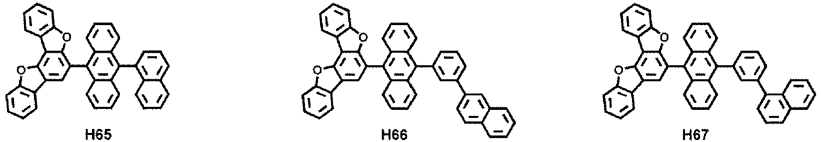

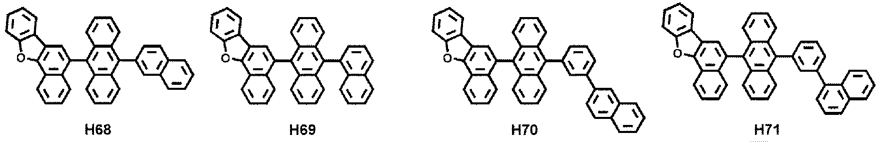

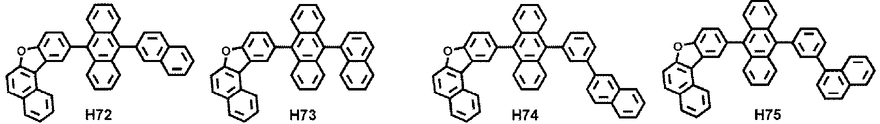

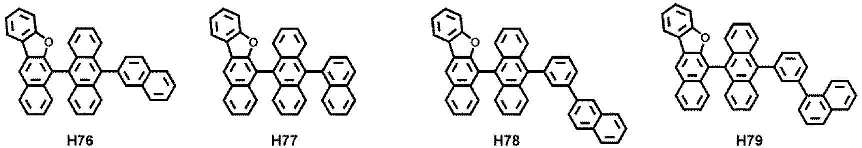

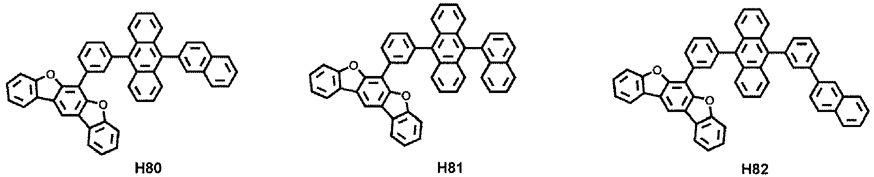

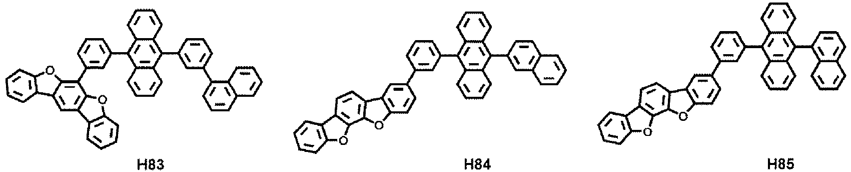

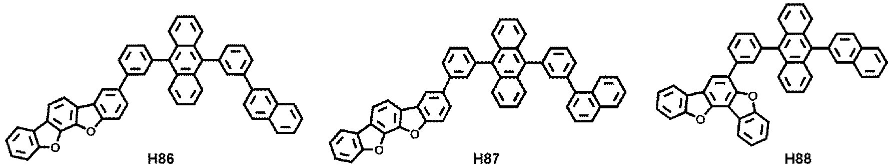

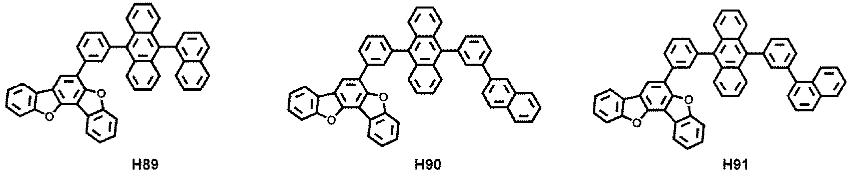

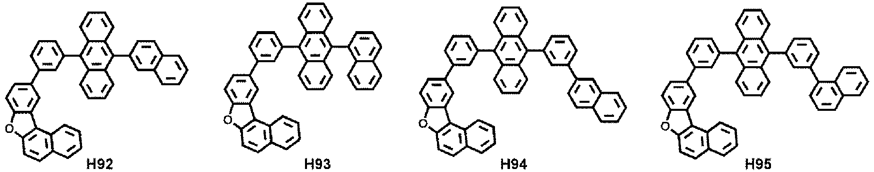

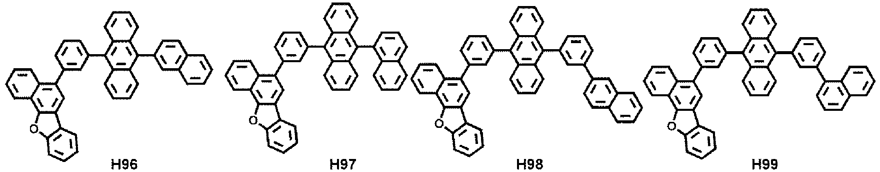

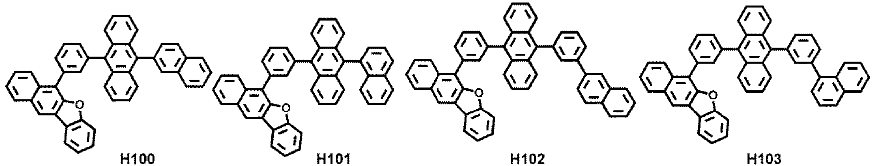

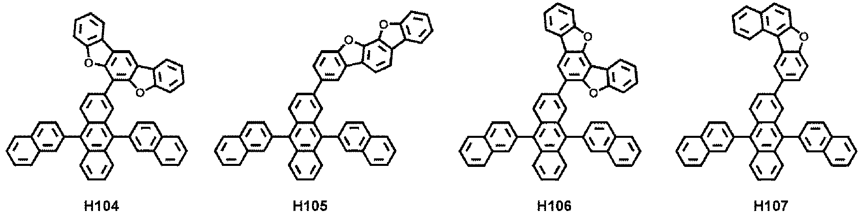

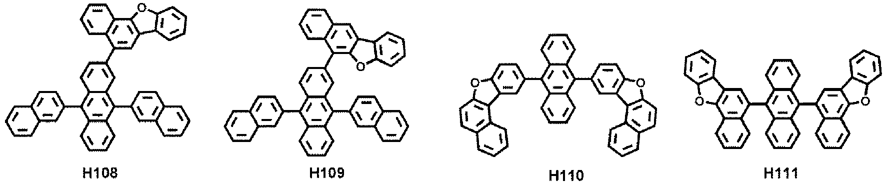

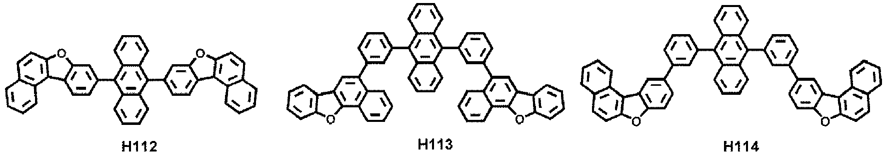

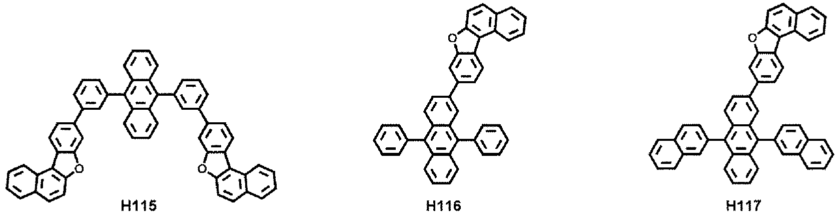

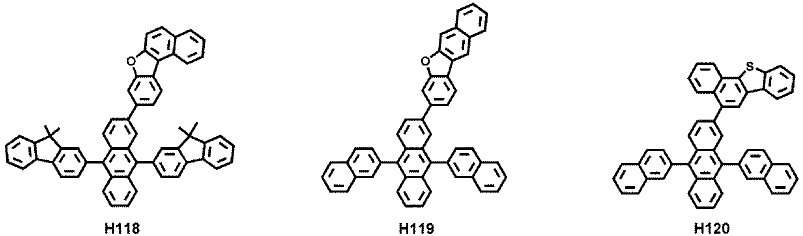

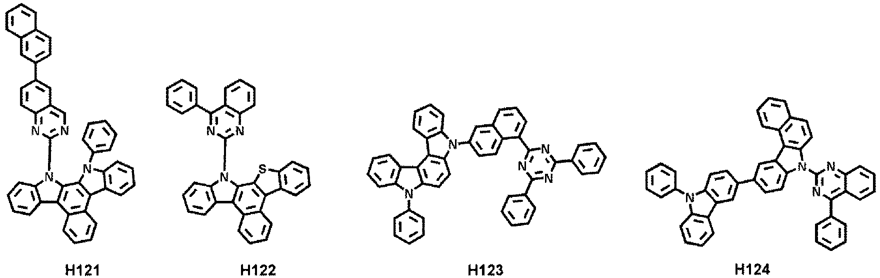

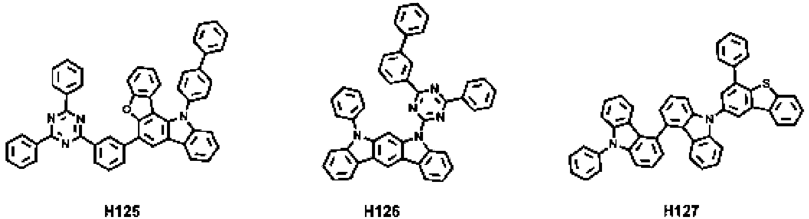

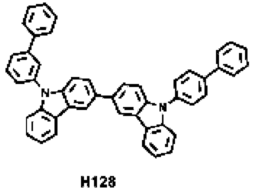

### Phosphorescent dopant

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any suitable combination thereof.

The phosphorescent dopant may be electrically neutral.

In an embodiment, the phosphorescent dopant may include an organometallic compound represented by Formula 401:

Formula 401 M(L₄₀₁)_{xc1}(L₄₀₂)_{xc2}

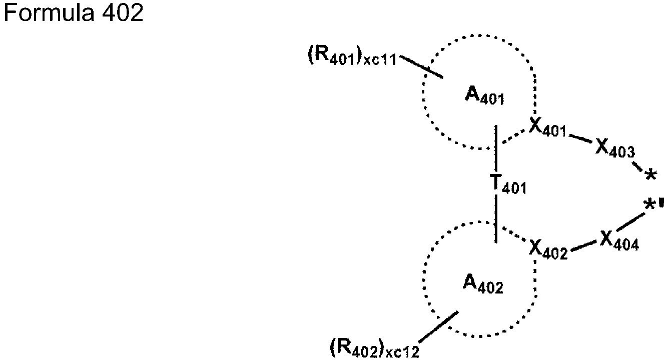

wherein, in Formulae 401 and 402,
M may be a transition metal (e.g., Ir, Pt, Pd, Os, Ti, Au, Hf, Eu, Tb, Rh, Re, or Tm),
L₄₀₁ may be a ligand represented by Formula 402, and xc1 is 1, 2, or 3, wherein, when xc1 is 2 or more, two or more of L₄₀₁ may be identical to or different from each other,
L₄₀₂ may be an organic ligand, and xc2 may be 0, 1, 2, 3, or 4, wherein, when xc2 is 2 or more, two or more of L₄₀₂ may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond (e.g., a single covalent bond), *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordinate bond, which may be referred to as a coordinate covalent bond or a dative bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ are each as described in connection with Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), or -P(=O)(Q₄₀₁)(Q₄₀₂),
Q₄₀₁ to Q₄₀₃ are each as described in connection with Q₁,
xc11 and xc12 may each independently be an integer from 0 to 10, and
* and *' in Formula 402 each indicate a binding site to M in Formula 401.

In an embodiment, in Formula 402, i) X₄₀₁ may be nitrogen, and X₄₀₂ may be carbon, or ii) each of X₄₀₁ and X₄₀₂ may be nitrogen.

In an embodiment, when xc1 in Formula 401 is 2 or more, two ring A₄₀₁ among two or more of L₄₀₁ may be optionally linked together via T₄₀₂, which is a linking group, and two ring A₄₀₂ may be optionally linked together via T₄₀₃, which is a linking group (see Compounds PD1 to PD4 and PD7). T₄₀₂ and T₄₀₃ are each as described in connection with T₄₀₁.

L₄₀₂ in Formula 401 may be an organic ligand. In an embodiment, L₄₀₂ may include a halogen group, a diketone group (for example, an acetylacetonate group), a carboxylic acid group (for example, a picolinate group), -C(=O), an isonitrile group, a - CN, a phosphorus-containing group (for example, a phosphine group, a phosphite group, and/or the like), or any suitable combination thereof.

The phosphorescent dopant may include, for example, one of compounds PD1 to PD39, or any suitable combination thereof:

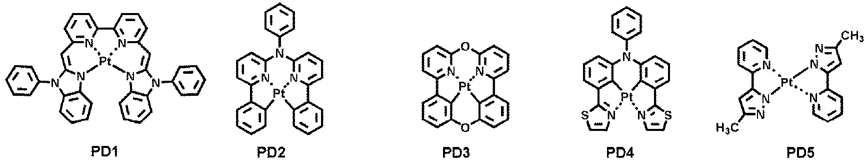

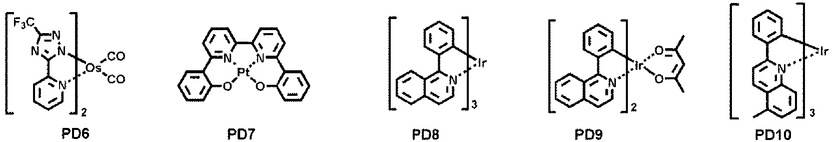

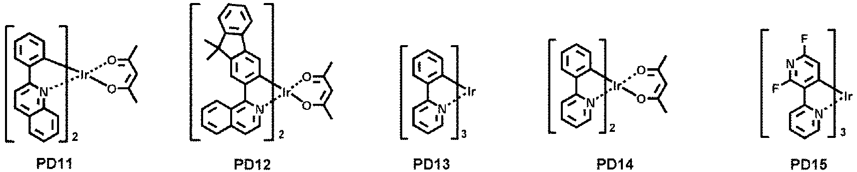

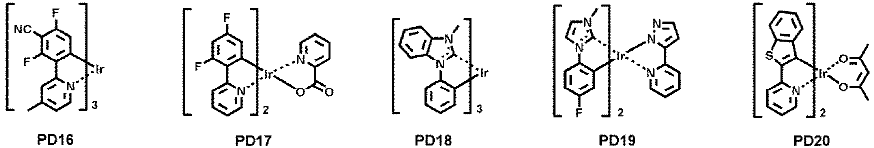

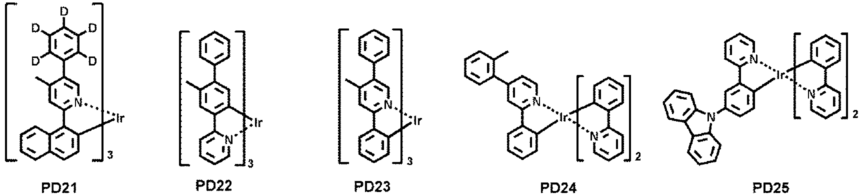

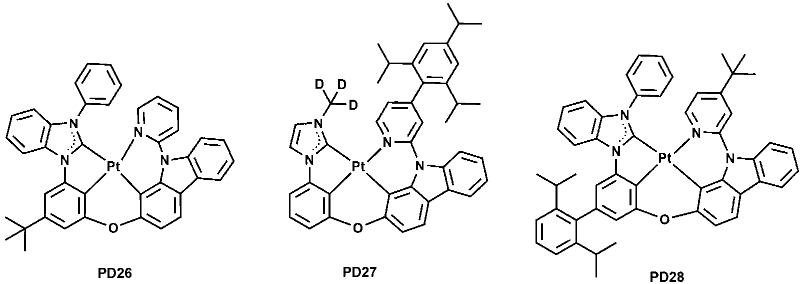

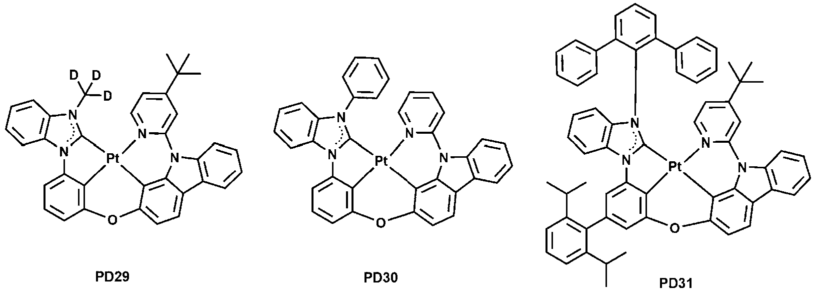

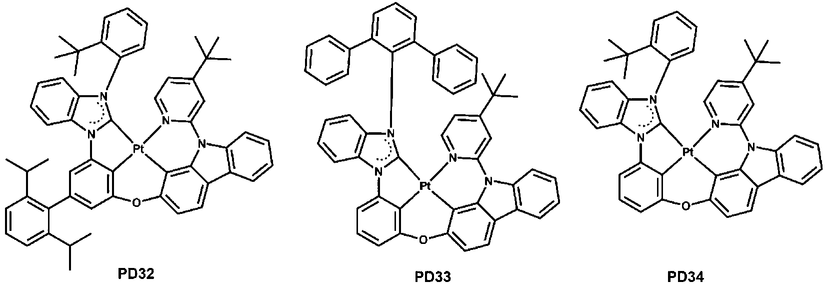

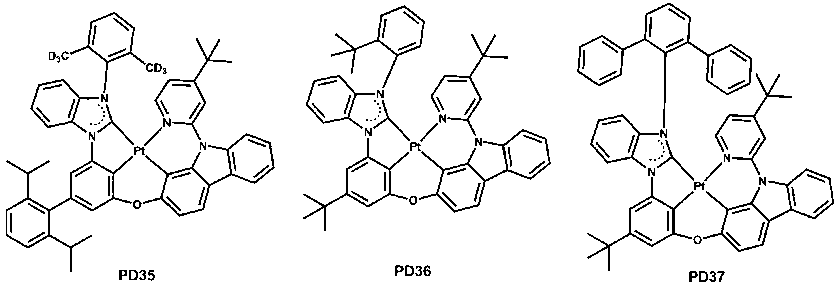

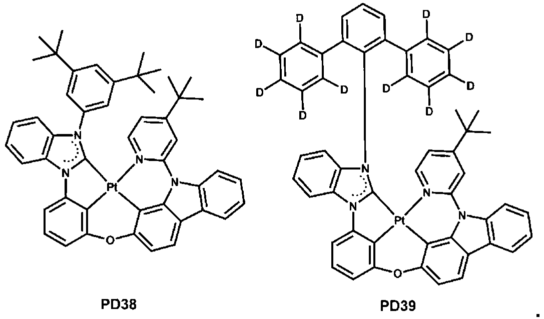

### Fluorescent dopant

The fluorescent dopant may include an amine group-containing compound, a styryl group-containing compound, or any suitable combination thereof.

For example, the fluorescent dopant may include a compound represented by Formula 501: 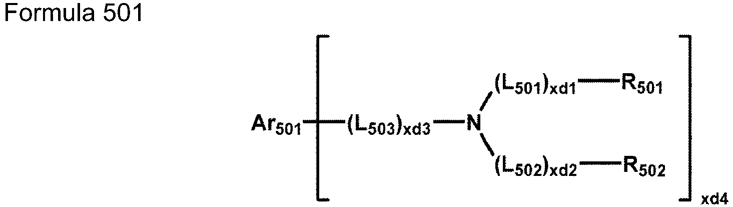 wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In an embodiment, Ar₅₀₁ in Formula 501 may be a condensed cyclic group (for example, an anthracene group, a chrysene group, a pyrene group, and/or the like) in which three or more monocyclic groups are condensed together.

In an embodiment, xd4 in Formula 501 may be 2.

In an embodiment, the fluorescent dopant may include: one selected from Compounds FD1 to FD37; DPVBi; DPAVBi; or any suitable combination thereof:

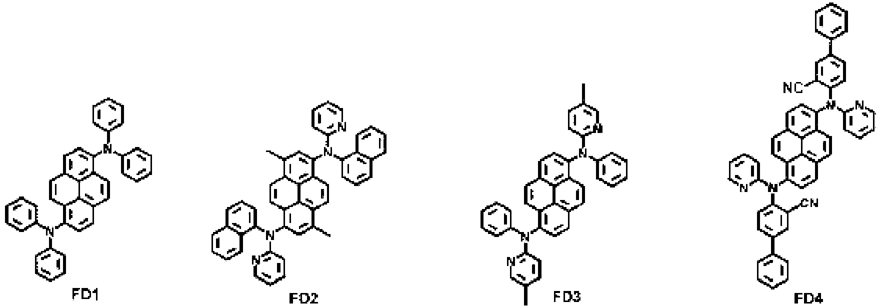

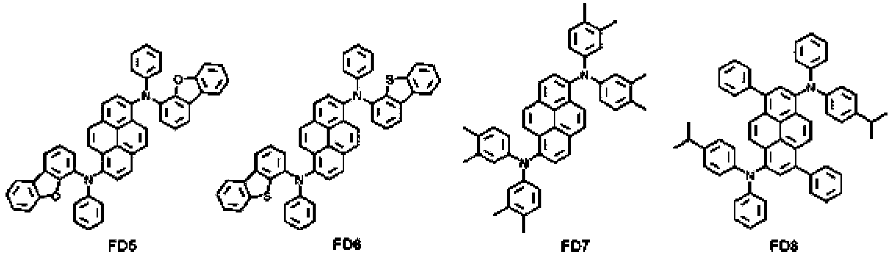

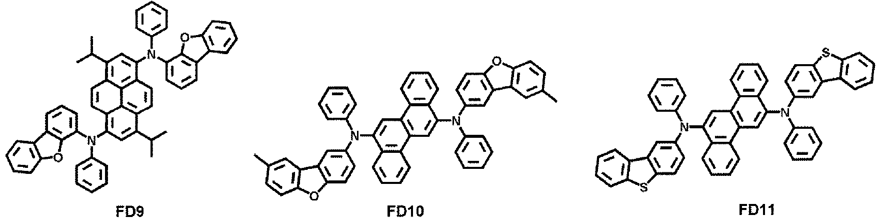

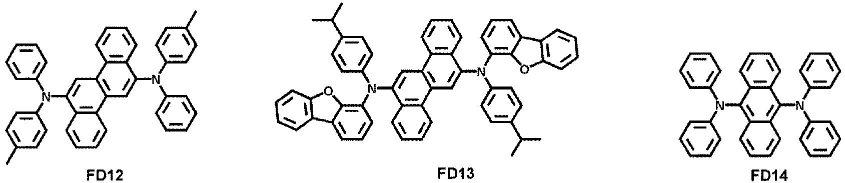

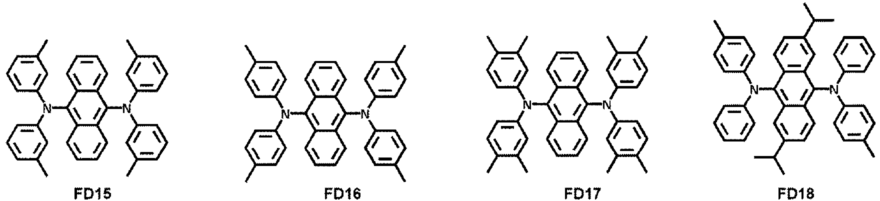

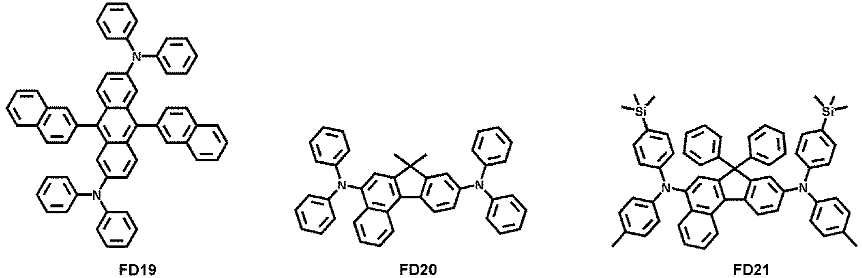

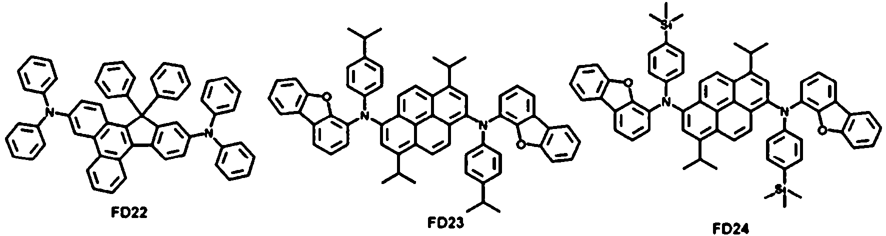

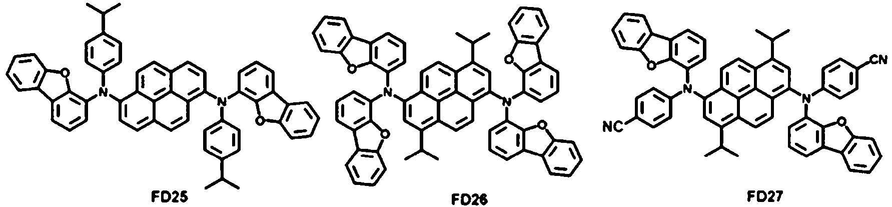

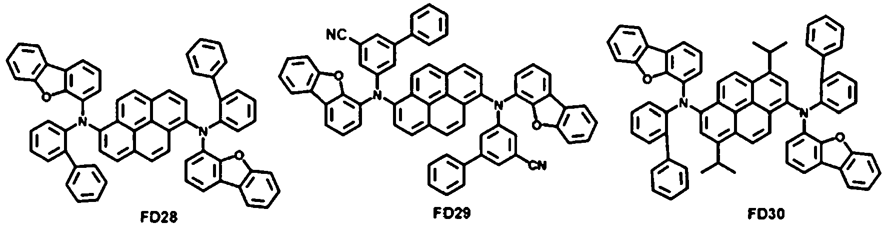

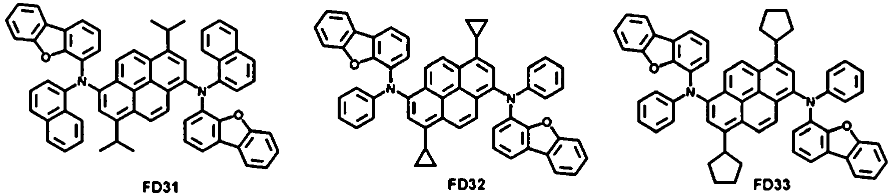

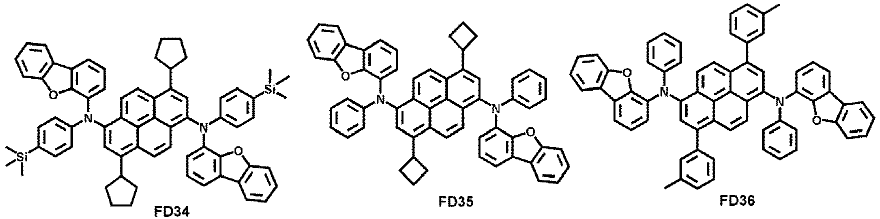

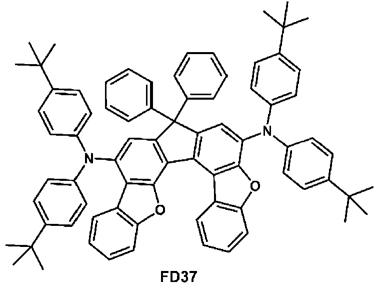

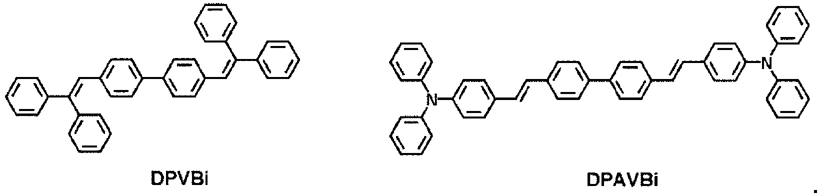

### Delayed fluorescence material

The emission layer 130 may include a delayed fluorescence material.

In embodiments, the delayed fluorescence material may be selected from compounds capable of emitting delayed fluorescence based on a delayed fluorescence emission mechanism.

The delayed fluorescence material included in the emission layer 130 may act as a host or a dopant, depending on the type or kind of other materials included in the emission layer 130.

In an embodiment, a difference between a triplet energy level (eV) of the delayed fluorescence material and a singlet energy level (eV) of the delayed fluorescence material may be in a range of about 0 eV to about 0.5 eV. When the difference between the triplet energy level (eV) of the delayed fluorescence material and the singlet energy level (eV) of the delayed fluorescence material is satisfied within the range above, up-conversion from the triplet state to the singlet state of the delayed fluorescence materials may effectively occur, and thus, the light-emitting device 10 may have improved luminescence efficiency.

In an embodiment, the delayed fluorescence material may include: i) a material including at least one electron donor (for example, a π electron-rich C₃-C₆₀ cyclic group such as a carbazole group) and at least one electron acceptor (for example, a sulfoxide group, a cyano group, a π electron-deficient nitrogen-containing C₁-C₆₀ cyclic group, and/or the like), ii) a material including a C₈-C₆₀ polycyclic group including at least two cyclic groups that are condensed with each other while sharing boron (B).

Examples of the delayed fluorescence material are at least one selected from Compounds DF1 to DF14:

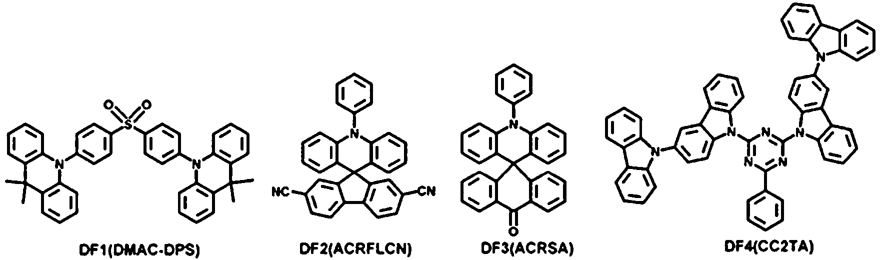

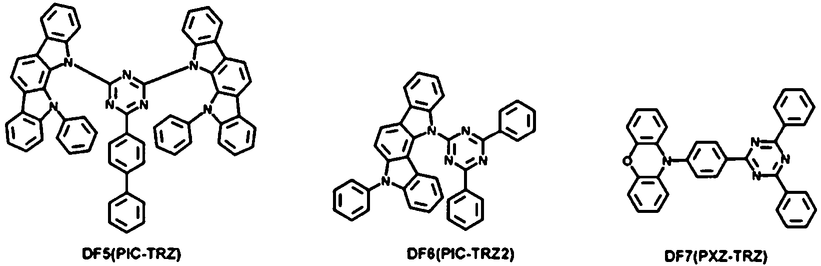

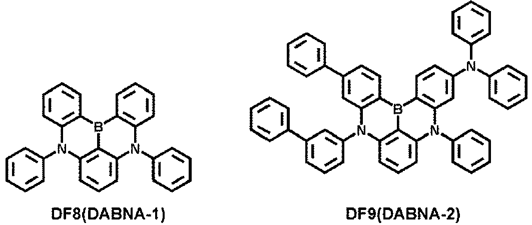

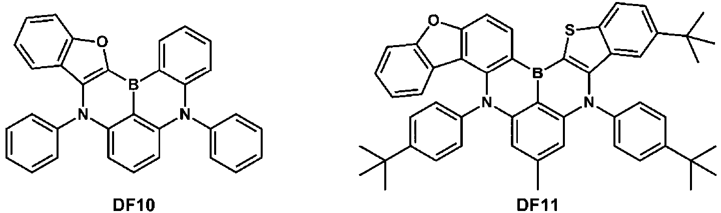

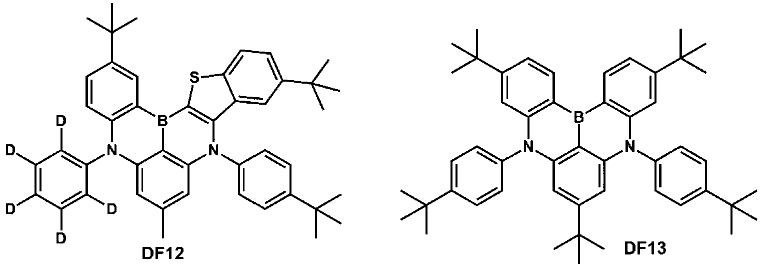

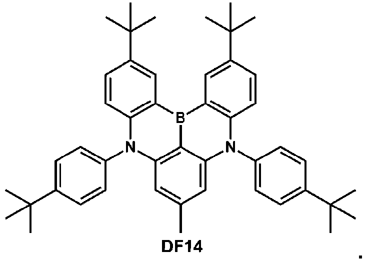

### Quantum dot

The emission layer 130 may include a quantum dot.

The term "quantum dot" as used herein refers to a crystal of a semiconductor compound. Quantum dots may emit light of various suitable emission wavelengths according to the size of the crystal. Quantum dots may also emit light of various suitable emission wavelengths by adjusting the ratio of elements constituting the quantum dots.

A diameter of the quantum dots may be, for example, in a range of about 1 nm to about 10 nm.

The quantum dot may be synthesized by a wet chemical process, a metal organic chemical vapor deposition process, a molecular beam epitaxy process, and/or any suitable process similar thereto.

The wet chemical process is a method including mixing a precursor material with an organic solvent and then growing a quantum dot particle crystal. When the crystal grows, the organic solvent naturally acts as a dispersant coordinated on the surface of the quantum dot crystal and controls the growth of the crystal so that the growth of quantum dot particles can be controlled through a process which costs lower, and is easier than vapor deposition methods, such as metal organic chemical vapor deposition (MOCVD) or molecular beam epitaxy (MBE).

The quantum dot may include Group II-VI semiconductor compounds, Group III-V semiconductor compounds, Group III-VI semiconductor compounds, Group I-III-VI semiconductor compounds, Group IV-VI semiconductor compounds, a Group IV element or compound, or a combination thereof.

Examples of the Group II-VI semiconductor compound are a binary compound, such as CdS, CdSe, CdTe, ZnS, ZnSe, ZnTe, ZnO, HgS, HgSe, HgTe, MgSe, and/or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, and/or MgZnS; a quaternary compound, such as CdZnSeS, CdZnSeTe, CdZnSTe, CdHgSeS, CdHgSeTe, CdHgSTe, HgZnSeS, HgZnSeTe, and/or HgZnSTe; or a combination thereof.

Examples of the Group III-V semiconductor compound are: a binary compound, such as GaN, GaP, GaAs, GaSb, AIN, AlP, AlAs, AlSb, InN, InP, InAs, and/or InSb; a ternary compound, such as GaNP, GaNAs, GaNSb, GaPAs, GaPSb, AINP, AlNAs, AlNSb, AlPAs, AlPSb, InGaP, InNP, InAlP, InNAs, InNSb, InPAs, and/or InPSb; a quaternary compound, such as GaAlNP, GaAINAs, GaAINSb, GaAlPAs, GaAlPSb, GalnNP, GalnNAs, GalnNSb, GalnPAs, GalnPSb, InAlNP, InAINAs, InAlNSb, InAIPAs, and/or InAlPSb; or any suitable combination thereof. In embodiments, the Group III-V semiconductor compound may further include a Group II element. Examples of the Group III-V semiconductor compound further including a Group II element are InZnP, InGaZnP, InAlZnP, and/or the like.

Examples of the Group III-VI semiconductor compound are: a binary compound, such as GaS, GaSe, Ga₂Se₃, GaTe, InS, InSe, In₂S₃, In₂Se₃, InTe, and/or the like; a ternary compound, such as InGaS₃, InGaSe₃, and/or the like; or any suitable combination thereof.

Examples of the Group I-III-VI semiconductor compound are: a ternary compound, such as AgInS, AgInS₂, AgInSe₂, AgGaS, AgGaS₂, AgGaSe₂, CulnS, CuInS₂, CuInSe₂, CuGaS₂, CuGaSe₂, CuGaO₂, AgGaO₂, AgAlO₂, and/or the like; a quaternary compound, such as CulnGaS, CuInGaS₂, AgInGaS, AgInGaS₂, AgInGaSe, AgInGaSe₂, and/or the like.

Examples of the Group IV-VI semiconductor compound are: a binary compound, such as SnS, SnSe, SnTe, PbS, PbSe, and/or PbTe; a ternary compound, such as SnSeS, SnSeTe, SnSTe, PbSeS, PbSeTe, PbSTe, SnPbS, SnPbSe, and/or SnPbTe; a quaternary compound, such as SnPbSSe, SnPbSeTe, and/or SnPbSTe; or a combination thereof.

Examples of the Group IV element or compound are: a single element, such as Si, Ge, and the like; a binary compound, such as SiC, SiGe, and the like; or any suitable combination thereof.

Each element included in a multi-element compound such as the binary compound, the ternary compound, and the quaternary compound may be present at a uniform concentration or non-uniform concentration in a particle. The above formulae refer to the types or kinds of elements included in each compound, and the element ratios in these compounds may be different from each other. For example, AgInGaS₂ may indicate AgInₓGa₁₋ₓS₂ (where x is a real number satisfying 0<x<1).

In embodiments, the quantum dot may have a single structure in which the concentration of each element in the quantum dot is uniform (e.g., substantially uniform), or a core-shell dual structure. For example, the material included in the core and the material included in the shell may be different from each other.

The shell of the quantum dot may act as a protective layer that prevents or reduces chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases along a direction toward the center of the core.

Examples of the shell of the quantum dot are an oxide of a metal, metalloid and/or non-metal, a semiconductor compound, and a combination thereof. Examples of the oxide of a metal and/or non-metal are: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO; a ternary compound, such as MgAl₂O₄, CoFe₂O₄, NiFe₂O₄, and/or CoMn₂O₄; and any suitable combination thereof. Examples of the semiconductor compound are: a Group III-VI semiconductor compound; a Group II-VI semiconductor compound; a Group III-V semiconductor compound; a Group I-III-VI semiconductor compound; a Group IV-VI semiconductor compound; or any suitable combination thereof, as described herein. For example, the semiconductor compound may include CdS, CdSe, CdTe, ZnS, ZnSe, ZnTe, ZnSeS, ZnTeS, GaAs, GaP, GaS, GaSe, AgGaS, AgGaS₂, GaSb, HgS, HgSe, HgTe, InAs, InP, InGaP, InSb, AlAs, AlP, AlSb, or any suitable combination thereof.

A full width at half maximum (FWHM) of the emission wavelength spectrum of the quantum dot may be about 45 nm or less, for example, about 40 nm or less, for example, about 30 nm or less, and within these ranges, color purity and/or color reproducibility may be increased. In embodiments, because the light emitted through the quantum dot is emitted in all (e.g., substantially all) directions, the wide viewing angle may be improved.

In embodiments, the quantum dot may be in the form of a spherical nanoparticle, a pyramidal nanoparticle, a multi-arm nanoparticle, a cubic nanoparticle, a nanotube, a nanowire, a nanofiber, and/or a nanoplate.

By adjusting the size of the quantum dots, the energy band gap may be adjusted, and thus, light of various suitable wavelengths may be obtained in a quantum dot emission layer. Thus, by using quantum dots as described above (by using quantum dots of different sizes or by suitably varying the ratio of elements in a quantum dot compound), a light-emitting device that emits light of various suitable wavelengths may be realized. In one or more embodiments, the size of the quantum dots or the ratio of elements in the quantum dot compound may be selected so that red light, green light, and/or blue light can be emitted. In one or more embodiments, the quantum dots may be configured to emit white light by combination of light of various suitable colors.

### Electron transport region 140

The electron transport region 140 may have i) a single-layer structure consisting of a single layer including a single material, ii) a single-layer structure consisting of a single layer including a plurality of materials that are different from each other, or iii) a multi-layer structure consisting of a plurality of layers including a plurality of different materials that are different from each other.

The electron transport region 140 may include a buffer layer, a hole-blocking layer, an electron control layer, an electron transport layer, an electron injection layer, or any suitable combination thereof.

In an embodiment, the electron transport region 140 may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein, for each structure, constituting layers are sequentially stacked from the emission layer 130.

In an embodiment, the electron transport region 140 (for example, the buffer layer, the hole-blocking layer, the electron control layer, or the electron transport layer in the electron transport region) may include a metal-free compound including at least one π electron-deficient nitrogen-containing C₁-C₆₀ cyclic group.

For example, the electron transport region 140 may include a compound represented by Formula 601:

Formula 601 [Ar₆₀₁]ₓₑ₁₁-[(L₆₀₁)ₓₑ₁-R₆₀₁]ₓₑ₂₁.

In Formula 601,
Ar₆₀₁ and L₆₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group that is unsubstituted or substituted with at least one R₁₀ₐ, a C₁-C₆₀ heterocyclic group that is unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or - P(=O)(Q₆₀₁)(Q₆₀₂),
Q₆₀₁ to Q₆₀₃ are each as described in connection with Q₁,
xe21 may be 1, 2, 3, 4, or 5, and
at least one selected from Ar₆₀₁, L₆₀₁, and R₆₀₁ may each independently be a π electron-deficient nitrogen-containing C₁-C₆₀ cyclic group unsubstituted or substituted with at least one R₁₀ₐ.

In an embodiment, when xe11 in Formula 601 is 2 or more, two or more of Ar₆₀₁ may be linked together via a single bond (e.g., a single covalent bond).

In an embodiment, Ar₆₀₁ in Formula 601 may be an anthracene group that is unsubstituted or substituted with at least one R₁₀ₐ.

In one or more embodiments, the electron transport region 140may include a compound represented by Formula 601-1: 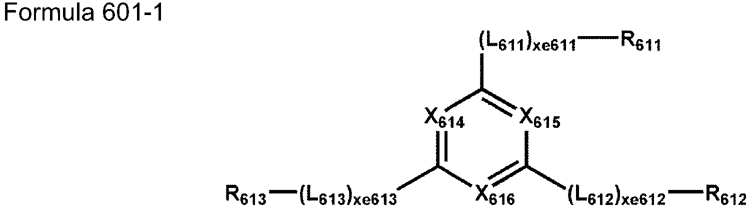 wherein, in Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ are each as described in connection with L₆₀₁,
xe611 to xe613 are each as described in connection with xe1,
R₆₁₁ to R₆₁₃ are each as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group that is unsubstituted or substituted with at least one R₁₀ₐ, or a C₁-C₆₀ heterocyclic group that is unsubstituted or substituted with at least one R₁₀ₐ.

In an embodiment, xe1 and xe611 to xe613 in Formulae 601 and 601-1 may each independently be 0, 1, or 2.

The electron transport region 140 may include one selected from compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, or any suitable combination thereof:

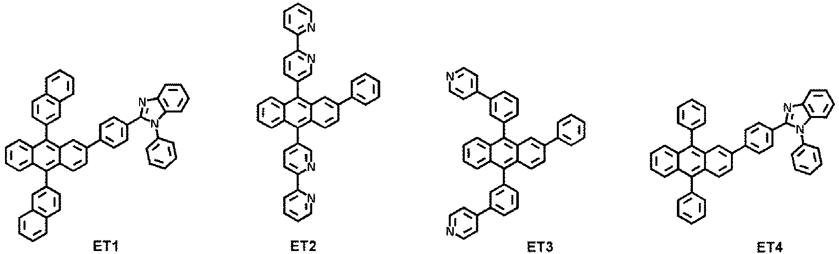

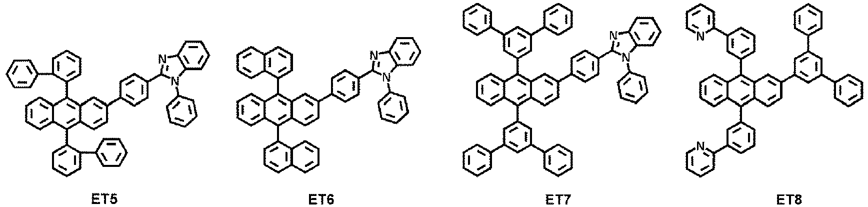

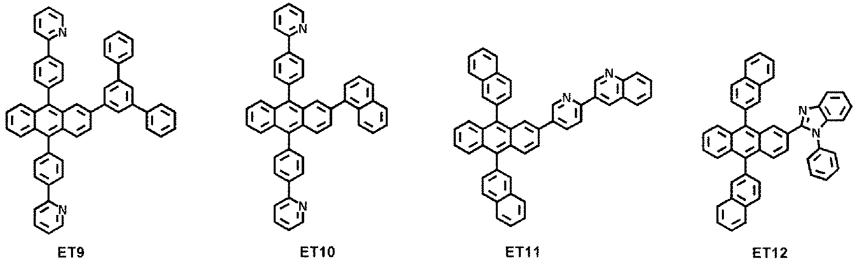

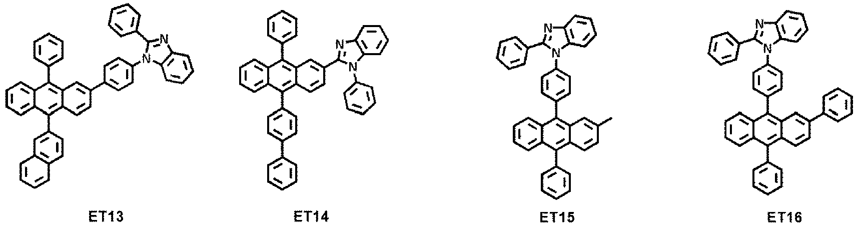

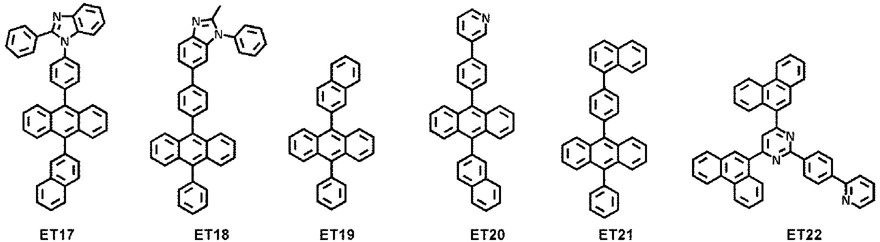

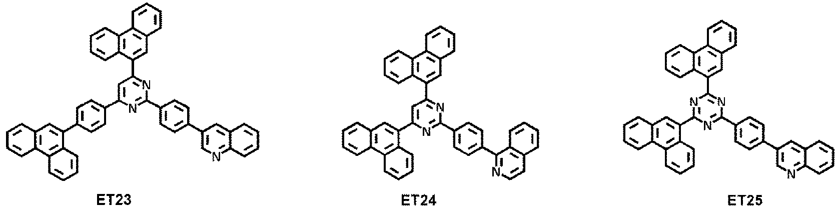

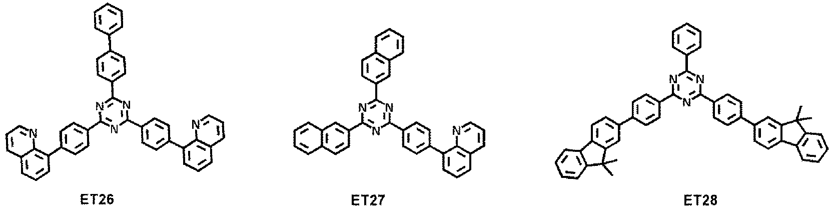

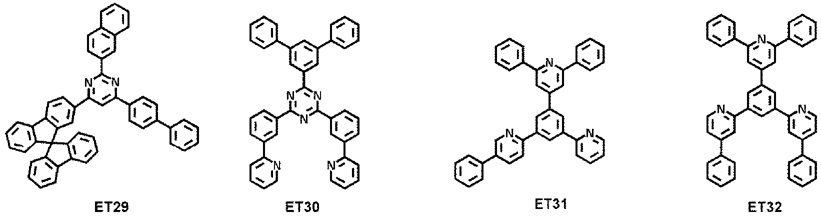

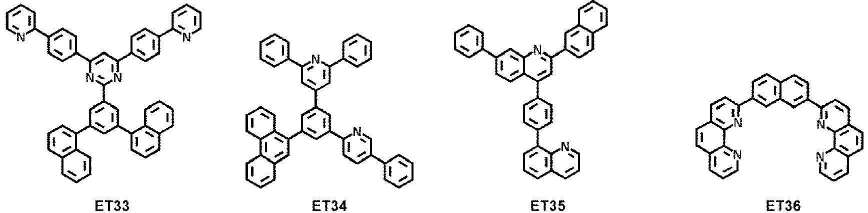

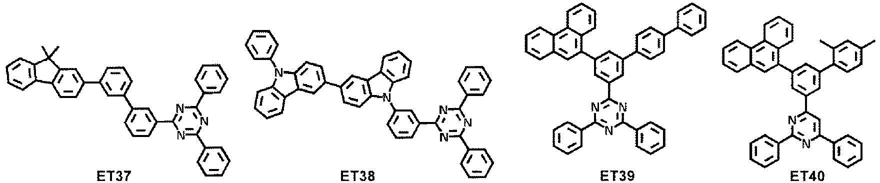

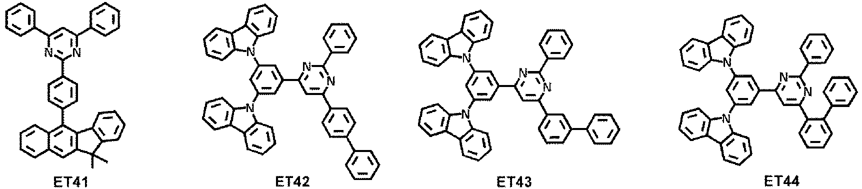

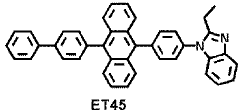

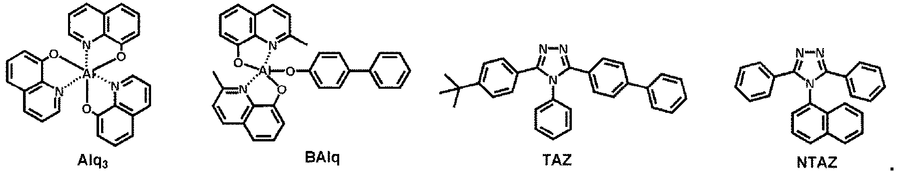

The thickness of the electron transport region 140 may be in a range of about 100 Å to about 5,000 Å, for example, about 160 Å to about 4,000 Å. When the electron transport region 140 includes a buffer layer, a hole-blocking layer, an electron control layer, an electron transport layer, or any suitable combination thereof, a thickness of the buffer layer, the hole-blocking layer, or the electron control layer may each independently be from about 20 Å to about 1,000 Å, for example, about 30 Å to about 300 Å, and a thickness of the electron transport layer may be from about 100 Å to about 1,000 Å, for example, about 150 Å to about 500 Å. When the thicknesses of the buffer layer, the hole blocking layer, the electron control layer, the electron transport layer, and/or the electron transport region are within the ranges described above, suitable or satisfactory electron transporting characteristics may be obtained without a substantial increase in driving voltage.

The electron transport region 140 (e.g., an electron transport layer in the electron transport region) may further include, in addition to the aforementioned materials, a metal-containing material.

The metal-containing material may include an alkali metal complex, an alkaline earth metal complex, or any suitable combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any suitable combination thereof.

In an embodiment, the metal-containing material may include a Li complex. The Li complex may include, for example, Compound ET-D1 (LiQ) and/or ET-D2:

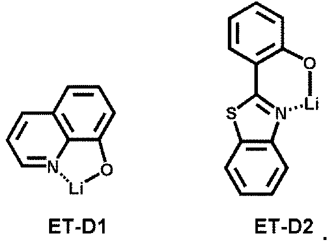

The electron transport region 140 may include an electron injection layer that facilitates the injection of electrons from the second electrode 150. The electron injection layer may directly contact the second electrode 150.

The electron injection layer may have: i) a single-layered structure consisting of a single layer consisting of a single material, ii) a single-layered structure consisting of a single layer including a plurality of different materials, or iii) a multilayer structure including a plurality of layers including a plurality of different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any suitable combination thereof.

The alkali metal may include Li, Na, K, Rb, Cs, or any suitable combination thereof. The alkaline earth metal may include Mg, Ca, Sr, Ba, or any suitable combination thereof. The rare earth metal may include Sc, Y, Ce, Tb, Yb, Gd, or any suitable combination thereof.

The alkali metal-containing compound, the alkaline earth metal-containing compound, and the rare earth metal-containing compound may include oxides, halides (for example, fluorides, chlorides, bromides, iodides, and/or the like), and/or tellurides of the alkali metal, the alkaline earth metal, and the rare earth metal, or any suitable combination thereof.

The alkali metal-containing compound may include: alkali metal oxides, such as Li₂O, Cs₂O, and/or K₂O; alkali metal halides, such as LiF, NaF, CsF, KF, Lil, Nal, Csl, and/or KI; or any suitable combination thereof. The alkaline earth metal-containing compound may include an alkaline earth metal compound, such as BaO, SrO, CaO, BaₓSr₁₋ₓO (x is a real number satisfying 0<x<1), and/or BaₓCa₁₋ₓO (x is a real number satisfying 0<x<1). The rare earth metal-containing compound may include YbF₃, ScF₃, Sc₂O₃, Y₂O₃, Ce₂O₃, GdF₃, TbF₃, YbI₃, ScI₃, TbI₃, or any suitable combination thereof. In an embodiment, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include i) one of ions of the alkali metal, the alkaline earth metal, and the rare earth metal and ii) a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any suitable combination thereof.

The electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any suitable combination thereof, as described above. In an embodiment, the electron injection layer may further include an organic material (for example, a compound represented by Formula 601).

In an embodiment, the electron injection layer may consist of i) an alkali metal-containing compound (for example, alkali metal halide), ii) a) an alkali metal-containing compound (for example, alkali metal halide); and b) an alkali metal, an alkaline earth metal, a rare earth metal, or any suitable combination thereof. In an embodiment, the electron injection layer may be a Kl:Yb co-deposited layer, an Rbl:Yb co-deposited layer, a LiF:Yb co-deposited layer, and/or the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any suitable combination thereof may be uniformly or non-uniformly dispersed in a matrix including the organic material.

The thickness of the electron injection layer may be about 1 Å to about 100 Å, and, for example, about 3 Å to about 90 Å. When the thickness of the electron injection layer is within the ranges as described above, suitable or satisfactory electron injection characteristics may be obtained without a substantial increase in driving voltage.

### Second electrode 150

The second electrode 150 may be on the electron transport region 140. The second electrode 150 may be a cathode, which is an electron injection electrode, and as a material to form the second electrode 150, a metal, an alloy, an electrically conductive compound, or any suitable combination thereof, each having a low-work function, may be used.

The second electrode 150 may include Li, Ag, Mg, Al, Al-Li, Ca, Mg-In, Mg-Ag, Yb, Ag-Yb, ITO, IZO, or any suitable combination thereof. The second electrode 150 may be a transmissive electrode, a semi-transmissive electrode, or a reflective electrode.

The second electrode 150 may have a single-layer structure or a multi-layer structure including a plurality of layers.

### Capping layer

The light-emitting device 10 may further include a capping layer on an outer side of the first electrode 110 and/or the second electrode 150.

According to an embodiment, the capping layer may include the organic compound described above.

For example, the light-emitting device 10 may further include a first capping layer on an outer side of the first electrode 110. The first capping layer may include the organic compound described above.

In some embodiments, the light-emitting device 10 may further include a second capping layer on an outer side of the second electrode 150. The second capping layer may include the organic compound described above.

In some embodiments, the light-emitting device 10 may further include a first capping layer on an outer side of the first electrode 110 and a second capping layer on an outer side of the second electrode 150. At least one selected from the first capping layer and the second capping layer may include the organic compound described above.

Light generated in the emission layer 130 of the light-emitting device 10 may pass through the first electrode 110, which is a semi-transmissive electrode or a transmissive electrode, and through the first capping layer to the outside. Light generated in the emission layer 130 of the light-emitting device 10 may pass through the second electrode 150, which is a semi-transmissive electrode or a transmissive electrode, and through the second capping layer to the outside.

The first capping layer and the second capping layer may increase external emission efficiency according to the principle of constructive interference. Accordingly, the light extraction efficiency of the light-emitting device 10 is increased so that the luminescence efficiency of the light-emitting device 10 can be improved.

Each of the first capping layer and the second capping layer may include a material having a refractive index of about 1.2 or higher (at a wavelength of 420 nm).

The first capping layer and the second capping layer may each independently be an organic capping layer including an organic material, an inorganic capping layer including an inorganic material, or an organic-inorganic composite capping layer including an organic material and an inorganic material.

At least one selected from the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any suitable combination thereof. The carbocyclic compound, the heterocyclic compound, and the amine group-containing compound may optionally be substituted with a substituent including O, N, S, Se, Si, F, CI, Br, I, or any suitable combination thereof. In an embodiment, at least one selected from the first capping layer and the second capping layer may each independently include an amine group-containing compound.

In an embodiment, at least one selected from the first capping layer and the second capping layer may each independently include a compound represented by Formula 201, a compound represented by Formula 202, or any suitable combination thereof.

In an embodiment, at least one selected from the first capping layer and the second capping layer may each independently include one selected from Compounds HT28 to HT33, one selected from Compounds CP1 to CP6, β-NPB, or any suitable combination thereof:

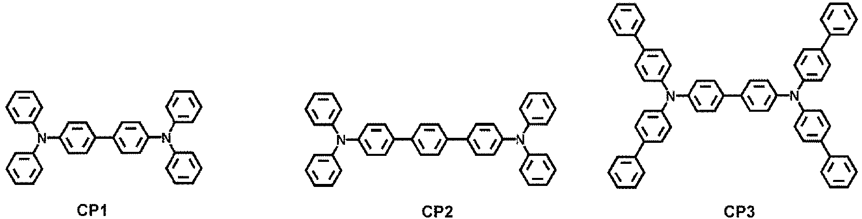

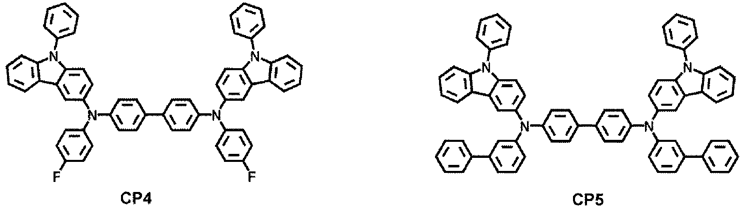

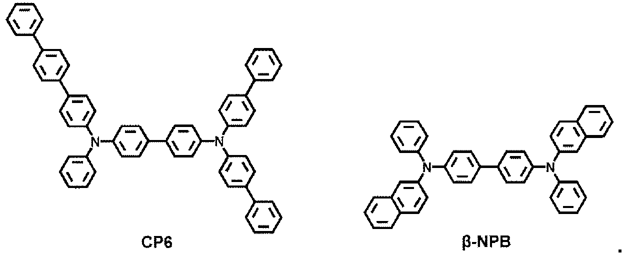

### Film

The display device may further include a film. The film may be, for example, an optical member (or a light control means) (for example, a color filter, a color conversion layer, a capping layer, a light extraction efficiency enhancement layer, a selective light absorbing layer, a polarizing layer, a quantum dot-containing layer, and/or the like), a light-blocking member (for example, a light reflective layer, a light absorbing layer, and/or the like), a protective member (for example, an insulating layer (e.g., an electrically insulating layer), a dielectric layer, and/or the like).

### Display device

The light-emitting device 10 may be included in various suitable display devices.

The above display device may further include, in addition to the light-emitting device 10, i) a color filter, ii) a color conversion layer, or iii) a color filter and a color conversion layer. The color filter and/or the color-conversion layer may be provided in at least one direction in which light emitted from the light-emitting device 10 travels. For example, the light emitted from the light-emitting device 10 is blue light and/or white light. The light-emitting device 10 is as described above.

The display device may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be provided among the subpixel areas to define each of the subpixel areas.

The color filter may further include a plurality of color filter areas and light-shielding patterns provided among the color filter areas, and the color conversion layer may further include a plurality of color conversion areas and light-shielding patterns provided among the color conversion areas.

The plurality of color filter areas (or the plurality of color conversion areas) may include a first area that emits first color light, a second area that emits second color light, and/or a third area that emits third color light, wherein the first color light, the second color light, and/or the third color light may have different maximum emission wavelengths. In an embodiment, the first color light may be red light, the second color light may be green light, and the third color light may be blue light. In an embodiment, the plurality of color filter areas (or the plurality of color conversion areas) may include quantum dots. In more detail, the first area may include red quantum dots, the second area may include green quantum dots, and the third area may not include quantum dots. A detailed description of the quantum dots is provided herein. The first area, the second area, and/or the third area may each further include a scatterer (e.g., a light scatterer).

For example, the light-emitting device 10 may emit a first light, the first area may absorb the first light to emit a first-1 color light, the second area may absorb the first light to emit a second-1 color light, and the third area may absorb the first light to emit a third-1 color light. In embodiments, the first-1 color light, the second-1 color light, and the third-1 color light may have different maximum emission wavelengths. In more detail, the first light may be blue light, the first-1 color light may be red light, the second-1 color light may be green light, and the third-1 color light may be blue light.

The above display device may further include a thin film transistor in addition to the light-emitting device 10 described above. The thin-film transistor may include a source electrode, a drain electrode, and an activation layer, wherein any one selected from the source electrode and the drain electrode may be electrically connected to any one selected from the first electrode and the second electrode of the light-emitting device 10.

The thin-film transistor may further include a gate electrode, a gate insulating film (e.g., a gate electrically insulating film), and/or the like.

The activation layer may include crystalline silicon, amorphous silicon, an organic semiconductor, an oxide semiconductor, and/or the like.

The display device may further include a sealing member that seals the light-emitting device 10. The sealing member may be between the color filter and/or color conversion layer and the light-emitting device 10. The sealing member may allow light from the light-emitting device 10 to be emitted to the outside, while at the same time blocking external air and moisture from penetrating into the light-emitting device 10. The sealing member may be a sealing substrate including a transparent glass substrate and/or a plastic substrate. The sealing member may be a thin-film encapsulation layer including at least one layer of an organic layer and/or an inorganic layer. When the sealing member is a thin film encapsulation layer, the display device may be flexible.

On the sealing member, various suitable functional layers in addition to the color filter and/or color conversion layer may be additionally provided depending on the purpose of the display device. Examples of the functional layers are a touch screen layer and a polarizing layer. The touch screen layer may be a pressure-sensitive touch screen layer, a capacitive touch screen layer, and/or an infrared touch screen layer. The above display device may include, for example, a biometric authentication device that authenticates an individual using biometric information (e.g., fingertips, pupils, and/or the like).

The authentication device may further include, in addition to the light-emitting device as described above, a biometric information collector.

The display device may be applied to various suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devicees, pulse wave measurement devicees, electrocardiogram displays, ultrasonic diagnostic devicees, and/or endoscope devicees), fish finders, various suitable measuring instruments, meters (for example, meters for a vehicle, an aircraft, and/or a vessel), projectors, and/or the like.

### Electronic device

The light-emitting device 10 may be included in various suitable electronic devices. For example, the display device including the light-emitting device 10 may be included in various suitable electronic devices.

For example, an electronic device including the light-emitting device 10 may be one selected from a flat panel display, a curved display, a computer monitor, a medical monitor, a television, a billboard, indoor or outdoor lighting and/or signaling lights, a head-up display, a fully or partially transparent display, a flexible display, a rollable display, a foldable display, a stretchable display, smart glasses, a head-mounted display, a smart watch, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, an augmented reality display, a vehicle dashboard, a center information display (CID) for a vehicle, a head-up display for a vehicle, a rearview mirror display, a video wall including a plurality of displays that are tiled together, a theater screen, a stadium screen, a light therapy device, and/or a signage.

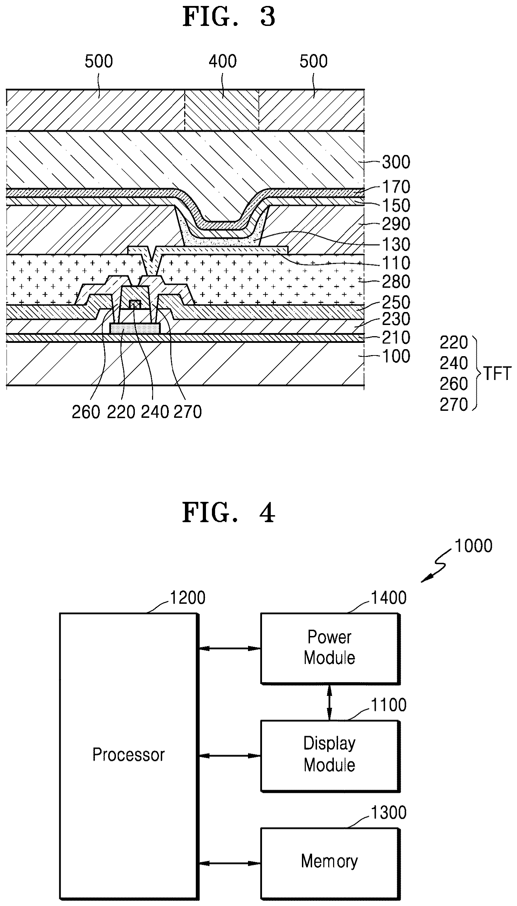

### Description of FIGS. 2 and 3

FIG. 2 is a cross-sectional view showing a display device according to an embodiment.

The display device of FIG. 2 may include a substrate 100, a thin film transistor TFT, a light-emitting device, and an encapsulation part 300.

The substrate 100 may be a flexible substrate, a glass substrate, and/or a metal substrate. A buffer layer 210 may be on the substrate 100. The buffer layer 210 may prevent or reduce penetration of impurities through the substrate 100 and may provide a flat surface on the substrate 100.

The TFT may be on the buffer layer 210. The TFT may include an activation layer 220, a gate electrode 240, a source electrode 260, and a drain electrode 270.

The activation layer 220 may include an inorganic semiconductor, such as silicon or polysilicon, an organic semiconductor, or an oxide semiconductor, and may include a source region, a drain region, and a channel region.

A gate insulating film 230 for insulating (e.g., electrically insulating) the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be between the gate electrode 240 and the source electrode 260 to insulate (e.g., electrically insulate) the gate electrode 240 from the source electrode 260 and between the gate electrode 240 and the drain electrode 270 to insulate (e.g., electrically insulate) the gate electrode 240 from the drain electrode 270.

The source electrode 260 and the drain electrode 270 may be on the interlayer insulating film 250. The interlayer insulating film 250 and the gate insulating film 230 may expose the source region and the drain region of the activation layer 220, and the source electrode 260 and the drain electrode 270 may be in contact with the exposed portions of the source region and the drain region of the activation layer 220.

The TFT may be electrically connected to a light-emitting device to drive the light-emitting device, and may be covered and protected by a passivation layer 280. The passivation layer 280 may include an inorganic insulating film (e.g., an inorganic electrically insulating film), an organic insulating film (e.g., an organic electrically insulating film), or any suitable combination thereof. A light-emitting device may be provided on the passivation layer 280. The light-emitting device includes the first electrode 110, the interlayer, and the second electrode 150.

The first electrode 110 may be on the passivation layer 280. The passivation layer 280 may expose a portion of the drain electrode 270, not fully covering the drain electrode 270, and the first electrode 110 may be connected to the exposed portion of the drain electrode 270.

The pixel-defining film 290 including an insulating material (e.g., an electrically insulating material) may be on the first electrode 110. The pixel-defining film 290 may expose a set or certain region of the first electrode 110, and the interlayer may be formed in the exposed region of the first electrode 110. The pixel-defining film 290 may be a polyimide-based organic film and/or a polyacrylic organic film. In embodiments, at least some layers of the interlayer may extend to the upper portion of the pixel-defining film 290 and may be provided in the form of a common layer.

The second electrode 150 may be on the interlayer, and a capping layer 170 may be further on the second electrode 150. The capping layer 170 may cover the second electrode 150.

The encapsulation part 300 may be on the capping layer 170. The encapsulation part 300 may be on a light-emitting device to protect the light-emitting device from moisture and/or oxygen. The encapsulation part 300 may include: an inorganic film including silicon nitride (SiNx), silicon oxide (SiOx), indium tin oxide, indium zinc oxide, or any suitable combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or any suitable combination thereof; or a combination of the inorganic film and the organic film.

FIG. 3 shows a cross-sectional view showing a display device according to an embodiment.

The display device of FIG. 3 is the same display device as the display device of FIG. 2, except that a light-shielding pattern 500 and a functional area 400 are additionally on the encapsulation part 300. The functional area 400 may be i) a color filter area, ii) a color conversion area, or iii) a combination of a color filter area and a color conversion area. According to an embodiment, the light-emitting device included in the display device of FIG. 3 may be a tandem light-emitting device.

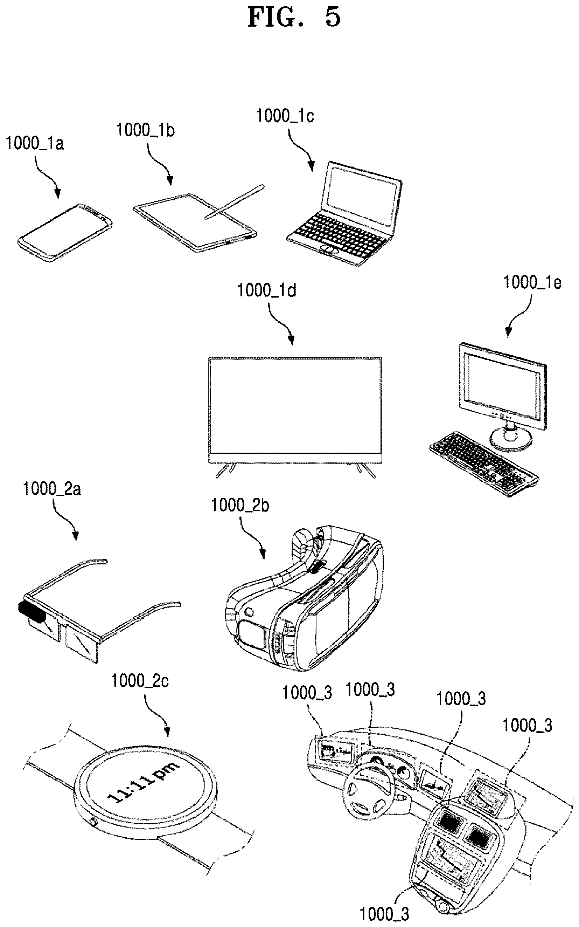

### Description of FIGS. 4 and 5

FIG. 4 is a block diagram illustrating an electronic device including a display device according to an embodiment.

A display device including a light-emitting device 10 according to an embodiment may be applied to an electronic device 1000. The electronic device 1000 according to an embodiment includes the display device described above, and may further include a module and/or device having additional functions in addition to the display device.

Referring to FIG. 4, the electronic device 1000 according to an embodiment may include a display module 1100, a processor 1200, a memory 1300, and a power module 1400.

The display module 1100 may emit light to display images such as moving images or still images, and may include, for example, the display device described above.

The processor 1200 may include at least one of a central processing unit (CPU), an application processor (AP), a graphic processing unit (GPU), a communication processor (CP), an image signal processor (ISP), and a controller.

Data information for the operation of the processor 1200 or the display module 1100 may be stored in the memory 1300. When the processor 1200 executes an application stored in the memory 1300, image data signals and/or input control signals are transmitted to the display module 1100, and the display module 1100 can process the received signals and output image information through a display screen.

The power module 1400 may include a power supply module, such as a power adapter and/or a battery device, and a power conversion module that converts power supplied by the power supply module to generate power utilized or required for the operation of the electronic device 1000.

At least one of the components of the electronic device 1000 may be included in a display device according to an embodiment. In some embodiments, some of the individual modules functionally included within a single module may be included within the display device, while others may be provided separately from the display device. For example, the display device may include a display module 1100, and the processor 1200, the memory 1300, and the power module 1400 may be provided in the form of other devices within the electronic device 1000 other than the display device.

According to an embodiment, the electronic device 1000 may be one selected from a flat panel display, a curved display, a computer monitor, a medical monitor, a television, a billboard, indoor or outdoor lighting and/or signaling lights, a head-up display, a fully or partially transparent display, a flexible display, a rollable display, a foldable display, a stretchable display, smart glasses, a head-mounted display, a smart watch, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, an augmented reality display, a vehicle dashboard, a center information display (CID) for a vehicle, a head-up display for a vehicle, a rearview mirror display, a video wall including a plurality of displays that are tiled together, a theater screen, a stadium screen, a light therapy device, and a signage.

FIG. 5 is a schematic diagram of an electronic device 1000 according to various embodiments.

Referring to FIG. 5, the electronic device 1000, to which electronic devices according to embodiments are applied, may include not only image display electronic devices such as a smart phone 1000_1a, a tablet PC 1000_1b, a laptop 1000_1c, a TV 1000_1d, and a desk monitor 1000_1e, but also wearable electronic devices including display modules such as smart glasses 1000_2a, a head mounted display 1000_2b, and a smart watch 1000_2c, and vehicle electronic devices 1000_3 including display modules such as a dashboard, center fascia, a center information display (CID) on the instrument panel of an automobile, and a room mirror display.

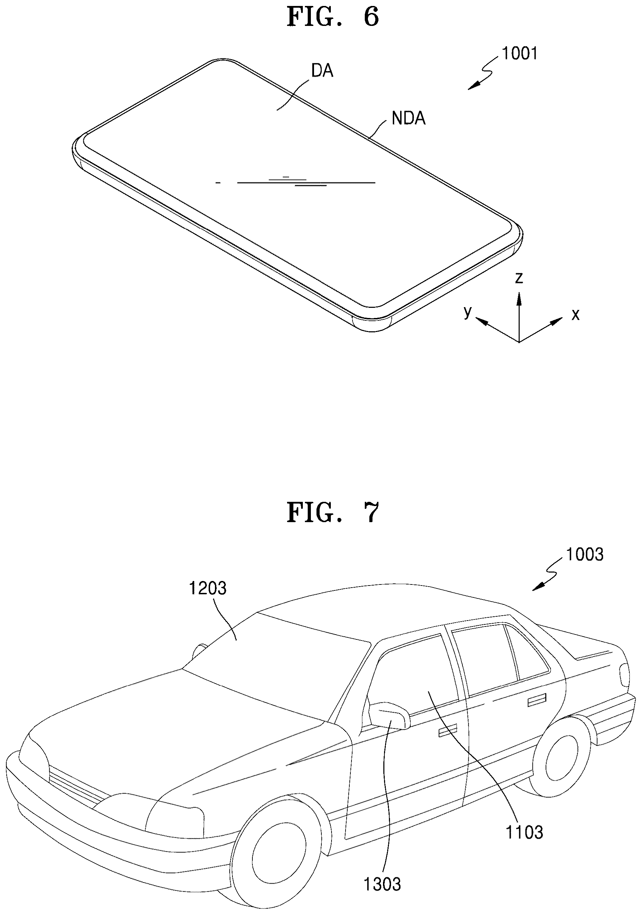

### Description of FIG. 6

FIG. 6 shows a perspective view schematically illustrating an electronic device 1001 including a light-emitting device according to an embodiment. The electronic device 1001 may be, as a device that displays a moving image and/or still image, a portable electronic device, such as a mobile phone, a smart phone, a tablet personal computer (PC), a mobile communication terminal, an electronic notebook, an electronic book, a portable multimedia player (PMP), a navigation, and/or a ultra mobile PC (UMPC) as well as various products, such as a television, a laptop, a monitor, a billboards and/or an Internet of things (IOT) device. The electronic device 1001 may be such a product above or a part thereof. In embodiments, the electronic device 1001 may be a wearable device such as a smart watch, a watch phone, a glasses-type display, and/or a head mounted display (HMD), or a part thereof. However, embodiments are not limited thereto. For example, the electronic device 1001 may be an instrument panel for a vehicle and a center fascia for a vehicle, a center information display (CID) on a dashboard, a room mirror display instead of a side mirror of a vehicle, an entertainment display for the rear seat of a car and/or a display placed on the back of the front seat, a head up display (HUD) installed in front of a vehicle and/or projected on a front window glass, and/or a computer generated hologram augmented reality head up display (CGH AR HUD). FIG. 6 illustrates a case in which the electronic device 1001 is a smart phone for convenience of explanation.

The electronic device 1001 may include a display area DA and a non-display area NDA outside the display area DA. The electronic device 1001 may implement an image through an array of a plurality of pixels that are two-dimensionally provided in the display area DA.

The non-display area NDA is an area that does not display an image, and may entirely surround the display area DA. On the non-display area NDA, a driver to provide electrical signals and/or power to display devices on the display area DA may be provided. On the non-display area NDA, a pad, which is an area to which an electronic element and/or a printed circuit board may be electrically connected, may be provided.

The electronic device 1001 may have different lengths in the x-axis direction and in the y-axis direction. In an embodiment, as shown in FIG. 6, the length in the x-axis direction may be less than the length in the y-axis direction. In an embodiment, the length in the x-axis direction may be the same as the length in the y-axis direction. In an embodiment, the length in the x-axis direction may be greater than the length in the y-axis direction.

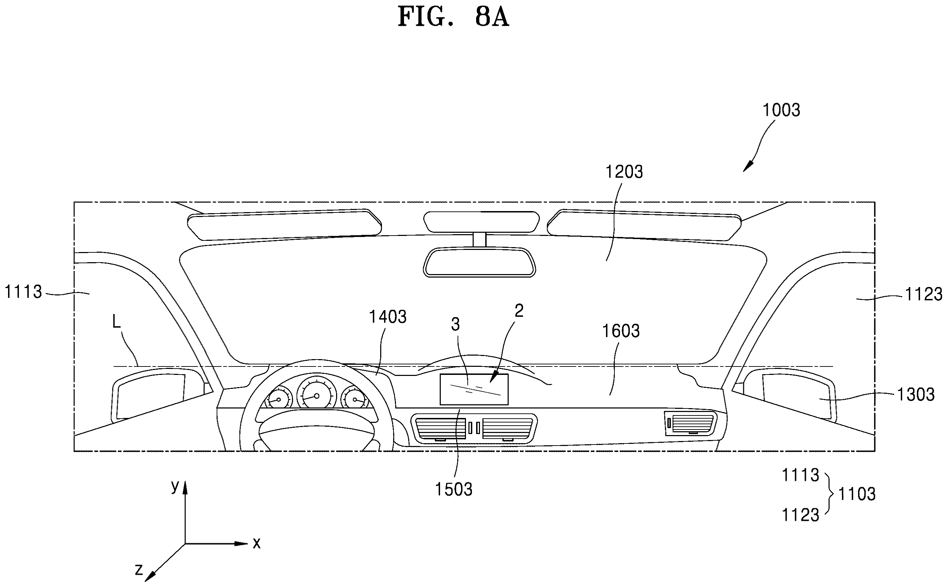

### Description of FIGS. 7 and 8A to 8C

FIG. 7 is a diagram illustrating the exterior of a vehicle 1003 as an electronic device including a light-emitting device according to an embodiment. FIGS. 8A to 8C are each a schematic view of the interior of the vehicle 1003 according to one or more embodiments.

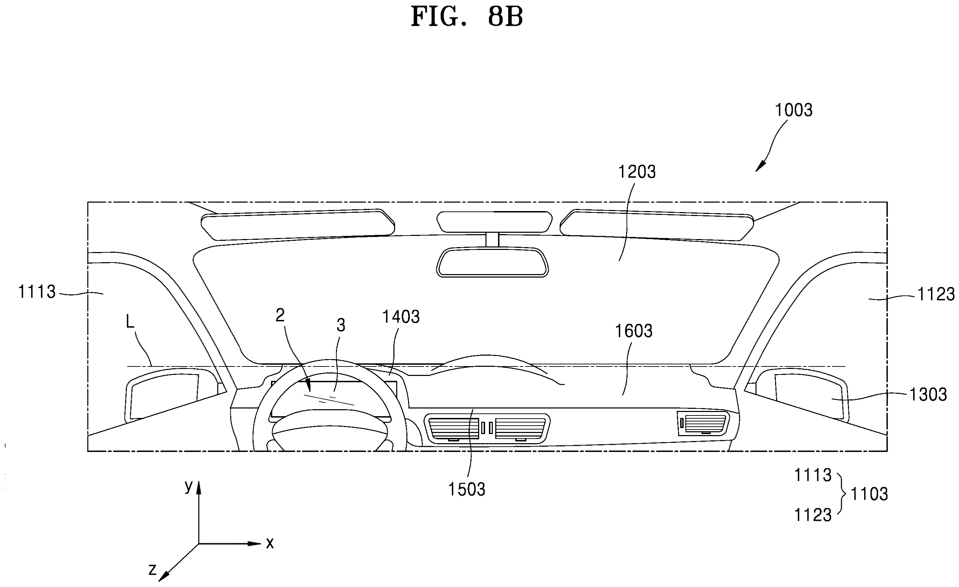

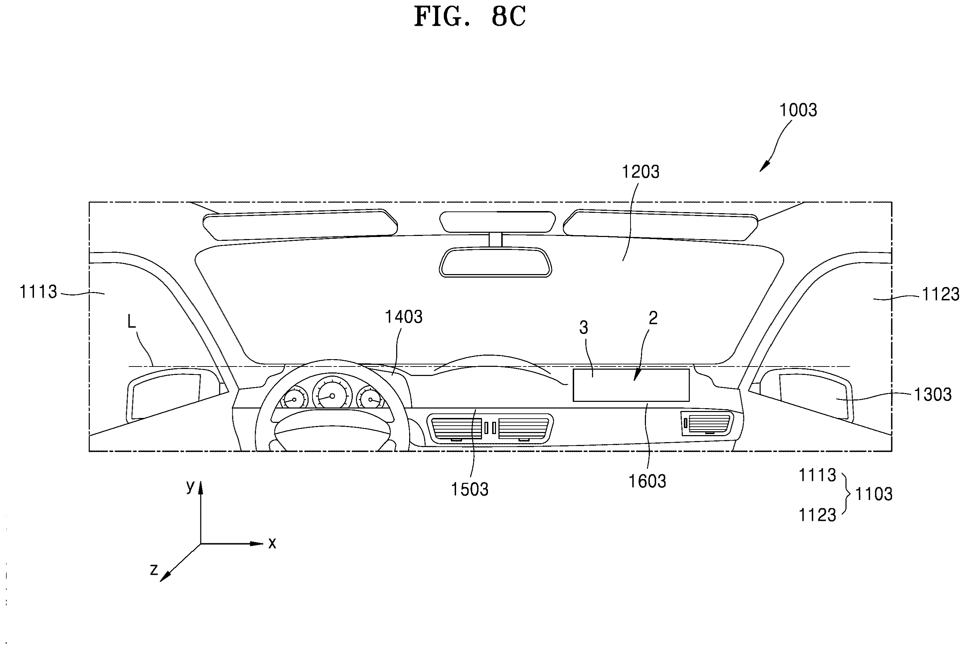

Referring to FIGS. 8A, 8B, and 8C, the vehicle 1003 may refer to various suitable devices for moving a subject object to be transported, such as a human, an object, and/or an animal, from a departure point to a destination. The vehicle 1003 may include a vehicle that travels on a road and/or a track, a vessel that moves over the sea and/or river, an airplane that flies in the sky using the action of air, and/or the like.

The vehicle 1003 may travel on a road and/or a track. The vehicle 1003 may move in a set or certain direction according to rotation of at least one wheel. In an embodiment, the vehicle 1003 may include a three-wheeled or four-wheeled vehicle, a construction machine, a two-wheeled vehicle, a prime mover device, a bicycle, and a train that travels on a track.

The vehicle 1003 may include a body having an interior and an exterior, and a chassis in which mechanical devicees necessary or useful to drive are installed as other parts except for the body of the vehicle 1003. The exterior of the body of the vehicle may include a front panel, a bonnet, a roof panel, a rear panel, a trunk, a pillar provided at a boundary between doors, and/or the like. The chassis of the vehicle 1003 may include a power generating device, a power transmitting device, a driving device, a steering device, a braking device, a suspension device, a transmission device, a fuel device, front and/or rear wheels, left and/or right wheels, and/or the like.

The vehicle 1003 may include a side window glass 1103, a front window glass 1203, a side-view mirror 1303, a cluster 1403, a center fascia 1503, a passenger seat dashboard 1603, and a display device 2.

The side window glass 1103 and the front window glass 1203 may be partitioned by a pillar between the side window glass 1103 and the front window glass 1203.

The side window glass 1103 may be on the side of the vehicle 1003. In an embodiment, the side window glass 1103 may be on a door of the vehicle 1003. A plurality of side window glasses 1103 may be provided and may face each other. In an embodiment, the side window glass 1103 may include a first side window glass 1113 and a second side window glass 1123. In an embodiment, the first side window glass 1113 may be adjacent to the cluster 1403. The second side window glass 1123 may be adjacent to the passenger seat dashboard 1603.

In an embodiment, the side window glasses 1103 may be spaced apart from each other in an x direction or a -x direction. In an embodiment, the first side window glass 1113 and the second side window glass 1123 may be spaced apart from each other in the x direction or the -x direction. In embodiments, an imaginary straight line L connecting the side window glasses 1103 may extend in the x direction or the -x direction. In an embodiment, an imaginary straight line L connecting the first side window glass 1113 and the second side window glass 1123 to each other may extend in the x direction or the -x direction.

The front window glass 1203 may be in front of the vehicle 1003. The front window glass 1203 may be between the side window glasses 1103 facing each other.

The side-view mirror 1303 may provide a rear view of the vehicle 1003. The side-view mirror 1303 may be installed on the exterior of the body of the vehicle. In an embodiment, a plurality of side-view mirrors 1300 may be provided. Any one of the plurality of side-view mirrors 1303 may be outside the first side window glass 1113. Another of the plurality of side-view mirrors 1303 may be outside the second side window glass 1123.

The cluster 1403 may be in front of a steering wheel. The cluster 1403 may include a tachometer, a speedometer, a coolant thermometer, a fuel gauge, a turn signal indicator, a high beam indicator, a warning light, a seat belt warning light, an odometer, a tachograph, an automatic shift selector indicator, a door open warning light, an engine oil warning light, and/or a low fuel warning light.

The center fascia 1503 may include a control panel on which a plurality of buttons to adjust an audio device, an air conditioning device, and/or a seat heater are provided. The center fascia 1503 may be on one side of the cluster 1403.

The passenger seat dashboard 1603 may be spaced apart from the cluster 1403, and the center fascia 1503 may be between the cluster 1403 and the passenger seat dashboard 1603. In an embodiment, the cluster 1403 may correspond to a driver seat, and the passenger seat dashboard 1600 may be correspond to a passenger seat. In an embodiment, the cluster 1403 may be adjacent to the first side window glass 1113, and the passenger seat dashboard 1603 may be adjacent to the second side window glass 1123.

In an embodiment, the display device 2 may include a display panel 3, and the display panel 3 may display an image. The display device 2 may be inside the vehicle 1003. In an embodiment, the display device 2 may be between the side window glasses 1103 facing each other. The display device 2 may be on at least one of the cluster 1403, the center fascia 1503, and the passenger seat dashboard 1603.

The display device 2 may include an organic light-emitting display device, an inorganic electroluminescent (EL) display device, a quantum dot display device, and/or the like. Hereinafter, as the display device 2 according to an embodiment, an organic light-emitting display device including the light-emitting device according to the disclosure will be described as an example, but various suitable types or kinds of display devices as described above may be used in embodiments of the disclosure.

Referring to FIG. 8A, the display device 2 may be on the center fascia 1503. In an embodiment, the display device 2 may display navigation information. In an embodiment, the display device 2 may display information regarding audio settings, video setting, and/or vehicle settings.

Referring to FIG. 8B, the display device 2 may be on the cluster 1403. In embodiments, the cluster 1403 may display driving information and/or the like through the display device 2. In embodiments, the cluster 1403 may be implemented digitally. The cluster 1403 implemented in a digital manner may display vehicle information and/or driving information as images. In an embodiment, a needle and a gauge of a tachometer and various suitable warning light icons may be displayed by a digital signal.

Referring to FIG. 8C, the display device 2 may be on the dashboard 1603 of the passenger seat. The display device 2 may be embedded in the passenger seat dashboard 1603 and/or on the passenger seat dashboard 1603. In an embodiment, the display device 2 on the passenger seat dashboard 1603 may display an image related to information displayed on the cluster 1403 and/or information displayed on the center fascia 1503. In one or more embodiments, the display device 2 on the passenger seat dashboard 1603 may display information different from information displayed on the cluster 1403 and/or information displayed on the center fascia 1503.

### Manufacturing method

Respective layers included in a hole transport region 120, an emission layer 130, and respective layers included in an electron transport region 140 may be formed in a set or certain region by using various suitable methods such as vacuum deposition, spin coating, casting, a Langmuir-Blodgett (LB) method, ink-jet printing, laser-printing, and/or laser-induced thermal imaging (LITI).

When the layers constituting the hole transport region 120, the emission layer 130, and the layers constituting the electron transport region 140 are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of terms

The term "C₅-C₆₀ carbocyclic group" as used herein refers to a cyclic group consisting of carbon only as a ring-forming atom and having 5 to 60 carbon atoms.

The term "C₃-C₆₀ heterocyclic group" as used herein refers to a cyclic group that has 3 to 60 carbon atoms and further has, in addition to carbon, a heteroatom as a ring-forming atom.

The C₅-C₆₀ carbocyclic group and the C₃-C₆₀ heterocyclic group may each be: a monocyclic group consisting of one ring; or a polycyclic group in which two or more rings are condensed with each other. For example, the C₃-C₆₀ heterocyclic group may have 4 to 61 ring-forming atoms.

The "cyclic group" as used herein may include the C₅-C₆₀ carbocyclic group and the C₃-C₆₀ heterocyclic group.

The term "π electron-rich C₃-C₆₀ cyclic group" as used herein refers to a cyclic group that has 3 to 60 carbon atoms and does not include *-N=*' as a ring-forming moiety.

The term "π electron-deficient nitrogen-containing C₁-C₆₀ cyclic group" as used herein refers to a heterocyclic group that has 1 to 60 carbon atoms and includes *-N=*' as a ring-forming moiety.

In an embodiment, the C₅-C₆₀ carbocyclic group may be i) Group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (e.g., a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, a xanten group, or the like).

The π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (e.g., the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, or the like).

the π electron-deficient nitrogen-containing C₁-C₆₀ cyclic group may be i) Group T4, ii) a condensed cyclic group in which two or more Groups T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and the like).

Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group.

Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group.

Group T3 may be a furan group, a thiophene group, a 1H-pyrrole group, a silole group, or a borole group.

Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₅-C₆₀ carbocyclic group, the C₃-C₆₀ heterocyclic group, the π electron-rich C₃-C₆₀ cyclic group, or the π electron-deficient nitrogen-containing C₁-C₆₀ cyclic group" as used herein refer to i) a group condensed to any cyclic group, ii) a monovalent group, or iii) a polyvalent group (e.g., a divalent group, a trivalent group, a tetravalent group, or the like) according to the structure of a formula for which the corresponding term is used.

In an embodiment, the "benzene group" may be a benzo group, a phenyl group, a phenylene group, or the like, which may be easily understood by those of ordinary skill in the art according to the structure of a formula including the "benzene group."

For example, examples of a monovalent C₅-C₆₀ carbocyclic group and a monovalent C₃-C₆₀ heterocyclic group are a C₅-C₁₀ cycloalkyl group, a C₃-C₁₀ heterocycloalkyl group, a C₅-C₁₀ cycloalkenyl group, a C₃-C₁₀ heterocycloalkenyl group, a C₆-C₆₀ aryl group, a C₃-C₆₀ heteroaryl group, a monovalent non-aromatic condensed polycyclic group, and a monovalent non-aromatic condensed heteropolycyclic group.

Examples of a divalent C₅-C₆₀ carbocyclic group and a divalent C₃-C₆₀ heterocyclic group are a C₅-C₁₀ cycloalkylene group, a C₃-C₁₀ heterocycloalkylene group, a C₅-C₁₀ cycloalkenylene group, a C₃-C₁₀ heterocycloalkenylene group, a C₆-C₆₀ arylene group, a C₃-C₆₀ heteroarylene group, a divalent non-aromatic condensed polycyclic group, and a divalent non-aromatic condensed heteropolycyclic group.

The term "C₁-C₆₀ alkyl group" as used herein refers to a linear or branched aliphatic hydrocarbon monovalent group that has one to sixty carbon atoms, and examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group.

The term "C₁-C₆₀ alkylene group" as used herein refers to a divalent group having substantially the same structure as the C₁-C₆₀ alkyl group.

The term "C₂-C₆₀ alkenyl group" as used herein refers to a monovalent hydrocarbon group having at least one carbon-carbon double bond at a main chain (e.g., in the middle) or at a terminus (e.g., the terminus) of the C₂-C₆₀ alkyl group, and examples thereof are an ethenyl group, a propenyl group, and a butenyl group.

The term "C₂-C₆₀ alkenylene group" as used herein refers to a divalent group having substantially the same structure as the C₂-C₆₀ alkenyl group.

The term "C₂-C₆₀ alkynyl group" as used herein refers to a monovalent hydrocarbon group having at least one carbon-carbon triple bond at a main chain (e.g., in the middle) or at a terminal end (e.g., the terminus) of the C₂-C₆₀ alkyl group, and examples thereof are an ethynyl group and a propynyl group.

The term "C₂-C₆₀ alkynylene group" as used herein refers to a divalent group having substantially the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof are a methoxy group, an ethoxy group, and an isopropyloxy group.

The term "C₃-C₁₀ cycloalkyl group" as used herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and the like.

The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a monovalent cyclic group that has one to ten carbon atoms and further includes, in addition to the carbon atoms, at least one heteroatom as a ring-forming atom, and examples thereof are a 1,2,3,4-oxatriazolidinyl group, a tetrahydrofuranyl group, and a tetrahydrothiophenyl group.

The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity (e.g., is not aromatic), and examples thereof are a cyclopentenyl group, a cyclohexenyl group, and a cycloheptenyl group.

The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent cyclic group that has one to ten carbon atoms, further includes, in addition to the carbon atoms, at least one heteroatom as a ring-forming atom, and has at least one double bond in the ring thereof. Examples of the C₁-C₁₀ heterocycloalkenyl group are a 4,5-dihydro-1,2,3,4-oxatriazolyl group, a 2,3-dihydrofuranyl group, and a 2,3-dihydrothiophenyl group.

The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system of 6 to 60 carbon atoms.

The term "C₆-C₆₀ arylene group" as used herein refers to a divalent group having a carbocyclic aromatic system of 6 to 60 carbon atoms.

Examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group.

When the C₆-C₆₀ aryl group and the C₆-C₆₀ arylene group each include two or more rings, the two or more rings may be condensed with each other.

The term "C₁-C₆₀ heteroaryl group" as used herein refers to a monovalent group having a heterocyclic aromatic system of 1 to 60 carbon atoms, further including, in addition to carbon atoms, at least one heteroatom, as ring-forming atoms.

The term "C₁-C₆₀ heteroarylene group" as used herein refers to a divalent group having a heterocyclic aromatic system of 1 to 60 carbon atoms, further including, in addition to carbon atoms, at least one heteroatom, as ring-forming atoms.

Examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group.

When the C₁-C₆₀ heteroaryl group and the C₁-C₆₀ heteroarylene group each include two or more rings, the two or more rings may be condensed with each other.

The term "monovalent non-aromatic condensed polycyclic group" as used herein refers to a monovalent group having two or more rings condensed with each other, only carbon atoms (for example, eight to sixty carbon atoms) as ring-forming atoms, and no aromaticity in its molecular structure when considered as a whole (e.g., is not aromatic when its molecular structure is considered as a whole). Examples of the monovalent non-aromatic condensed polycyclic group are an indenyl group, a fluorenyl group, a spiro-bifluorenyl group, a benzofluorenyl group, an indenophenanthrenyl group, and an indeno anthracenyl group.

The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more rings condensed with each other, further includes, in addition to carbon atoms (for example, one to sixty carbon atoms), at least one heteroatom as a ring-forming atom, and has no aromaticity in its molecular structure when considered as a whole (e.g., is not aromatic when its molecular structure is considered as a whole). Examples of the monovalent non-aromatic condensed heteropolycyclic group are a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group.

The term "divalent non-aromatic condensed heteropolycyclic group" as used herein refers to a divalent group having substantially the same structure as the monovalent non-aromatic condensed heteropolycyclic group.

The term "C₆-C₆₀ aryloxy group" as used herein indicates -OA₁₀₂ (wherein A₁₀₂ is the C₆-C₆₀ aryl group).

The term "C₆-C₆₀ arylthio group" as used herein indicates -SA₁₀₃ (wherein A₁₀₃ is the C₆-C₆₀ aryl group).

The term "C₇-C₆₀ arylalkyl group" as used herein refers to -A₁₀₄A₁₀₅ (wherein A₁₀₄ is a C₁-C₅₄ alkylene group, and A₁₀₅ is a C₆-C₅₉ aryl group).

The term "C₂-C₆₀ heteroarylalkyl group" as used herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₅-C₆₀ carbocyclic group, a C₃-C₆₀ heterocyclic group, a C₆-C₆₀ aryloxy group, a C₆-C₆₀ arylthio group, a C₇-C₆₀ arylalkyl group, a C₃-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or a combination thereof;
a C₅-C₆₀ carbocyclic group, a C₃-C₆₀ heterocyclic group, a C₆-C₆₀ aryloxy group, a C₆-C₆₀ arylthio group, a C₇-C₆₀ arylalkyl group, or a C₃-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₅-C₆₀ carbocyclic group, a C₃-C₆₀ heterocyclic group, a C₆-C₆₀ aryloxy group, a C₆-C₆₀ arylthio group, a C₇-C₆₀ arylalkyl group, a C₃-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any suitable combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃, and Q₃₁ to Q₃₃ as used herein may each independently be:
   hydrogen, deuterium, -F, -Cl, -Br, -I, a hydroxyl group, a cyano group, or a nitro group; or
   a C₁-C₆₀ alkyl group, a C₂-C₆₀ alkenyl group, a C₂-C₆₀ alkynyl group, a C₁-C₆₀ alkoxy group, a C₅-C₆₀ carbocyclic group, or a C₃-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any suitable combination thereof.

The term "heteroatom" as used herein refers to any atom other than a carbon atom and a hydrogen atom. Examples of the heteroatom are O, S, N, P, Si, B, Ge, Se, or any suitable combination thereof.

The term "transition metal" as used herein may include Hf, Ta, W, Re, Os, Ir, Pt, Au, and the like.

"D" may refer to deuterium, "Ph" may refer to a phenyl group, "Me" may refer to a methyl group, "Et" may refer to an ethyl group, "tert-Bu", "^{t}Bu" or "Bu^{t}" may refer to a tert-butyl group, and "OMe" may refer to a methoxy group.

For example, the group represented by 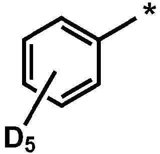 may refer to a group represented by 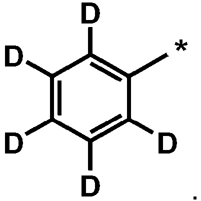 In some embodiments, the group represented by 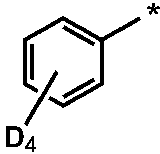 may refer to a group represented by 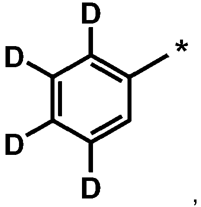 a group represented by 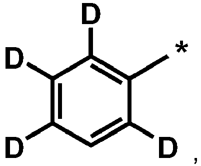 or a group represented by

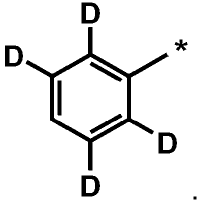

The term "biphenyl group" as used herein refers to "a phenyl group that is substituted with a phenyl group." In embodiments, the "biphenyl group" may be a substituted phenyl group having a C₆-C₆₀ aryl group as a substituent.

The term "terphenyl group" as used herein refers to "a phenyl group substituted with a biphenyl group." The term "terphenyl group" as used herein may refer to i) a substituted phenyl group wherein the substituent is a C₆-C₆₀ aryl group substituted with a C₆-C₆₀ aryl group, and ii) a substituted phenyl group wherein two substituents are present, and each substituent is a C₆-C₆₀ aryl group.

The symbols * and *' as used herein, unless defined otherwise, each refer to a binding site to a neighboring atom in a corresponding formula or moiety.

The terms "x-axis", "y-axis", and "z-axis" as used herein are not limited to three axes in an orthogonal coordinate system, and may be interpreted in a broader sense than the aforementioned three axes in an orthogonal coordinate system. For example, the x-axis, y-axis, and z-axis may describe axes that are orthogonal to each other, or may describe axes that are in different directions that are not orthogonal to each other.

Hereinafter, organic compounds and light-emitting devices including the same according to an embodiment are described in more detail with reference to Synthesis Examples and Examples.

### Synthesis Example 1 (Synthesis of Compound 6)

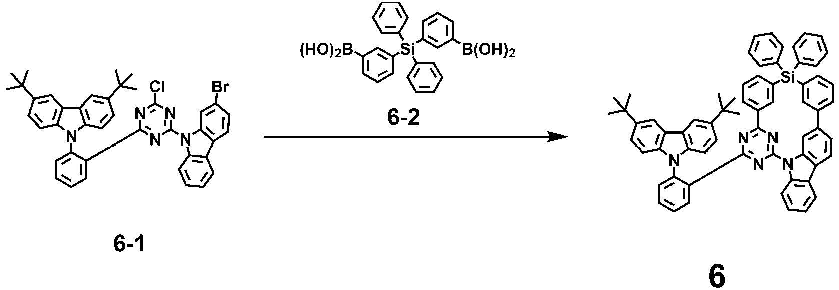

2.3 g of Compound 6-1, 1.78 g of compound 6-2, 1.16 g of potassium carbonate, and 0.05 g of tetrakis(triphenylphosphine)palladium(0) were placed in a round bottom (RB) flask and dissolved in 40 ml of tetrahydrofuran (THF) and 10 ml of distilled water (DW), and refluxed for 12 hours. After the reaction was completed, the resultant reaction solution was extracted with ethyl acetate and the resultant organic layer was collected. The organic layer was dried using magnesium sulfate to obtain a residue. The residue was separated and purified by silica gel column chromatography to obtain 2.61 g (yield: 77%) of compound 6. Compound 6 was confirmed by liquid chromatography-mass spectrometry (LC-MS).
C₆₅H₅₃N₅Si M+1: 807.43

### Synthesis Example 2 (Synthesis of compound 7)

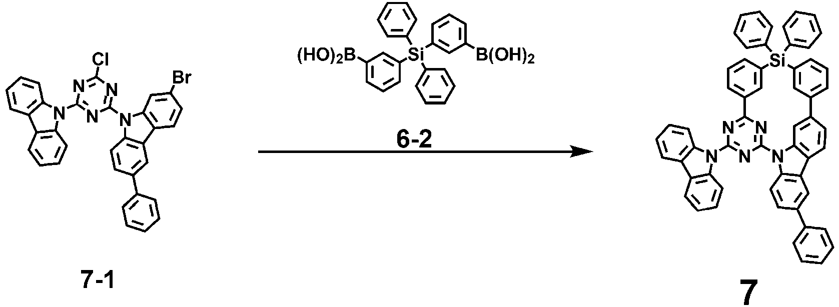

3.5 g of Compound 7-1, 2.47 g of compound 6-2, 1.16 g of potassium carbonate, and 0.07 g of tetrakis(triphenylphosphine)palladium(0) were placed in a RB flask and dissolved in 60 ml of tetrahydrofuran (THF) and 15 ml of distilled water (DW), and refluxed for 12 hours. After the reaction was completed, the resultant reaction solution was extracted with ethyl acetate and the resultant organic layer was collected. The organic layer was dried using magnesium sulfate to obtain a residue. The residue was separated and purified by silica gel column chromatography to obtain 2.82 g (yield: 59%) of compound 7. Compound 7 was confirmed by LC-MS.
C₅₇H₃₇N₅Si M+1: 820.29

### Synthesis Example 3 (Synthesis of compound 15)

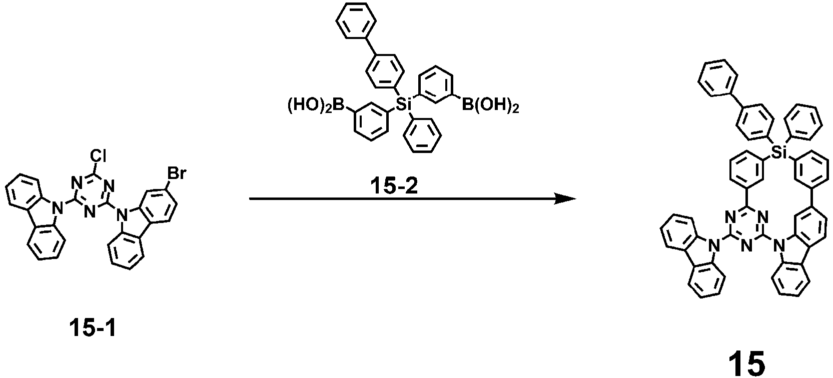

3.4 g of Compound 15-1, 3.24 g of compound 15-2, 1.79 g of potassium carbonate, and 0.07 g of tetrakis(triphenylphosphine)palladium(0) were placed in a RB flask and dissolved in 65 ml of tetrahydrofuran (THF) and 15 ml of distilled water (DW), and refluxed for 12 hours. After the reaction was completed, the resultant reaction solution was extracted with ethyl acetate and the resultant organic layer was collected. The organic layer was dried using magnesium sulfate to obtain a residue. The residue was separated and purified by silica gel column chromatography to obtain 3.08 g (yield: 58%) of compound 15. Compound 15 was confirmed by LC-MS.
C₅₇H₃₇N₅Si M+1: 820.29

### Synthesis Example 4 (Synthesis of compound 21)

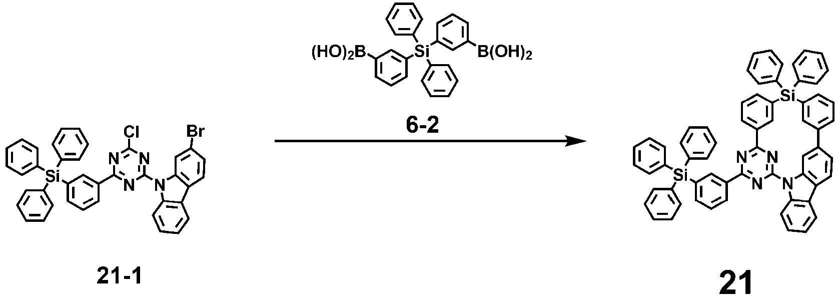

2.5 g of Compound 21-1, 1.53 g of compound 6-2, 1.00 g of potassium carbonate, and 0.04 g of tetrakis(triphenylphosphine)palladium(0) were placed in a RB flask and dissolved in 35 ml of tetrahydrofuran (THF) and 10 ml of distilled water (DW), and refluxed for 12 hours. After the reaction was completed, the resultant reaction solution was extracted with ethyl acetate and the resultant organic layer was collected. The organic layer was dried using magnesium sulfate to obtain a residue. The residue was separated and purified by silica gel column chromatography to obtain 2.37 g (yield: 72%) of compound 21. Compound 21 was confirmed by LC-MS.
C₆₃H₄₄N₄Si₂ M+1: 913.39

### Synthesis Example 5 (Synthesis of compound 22)

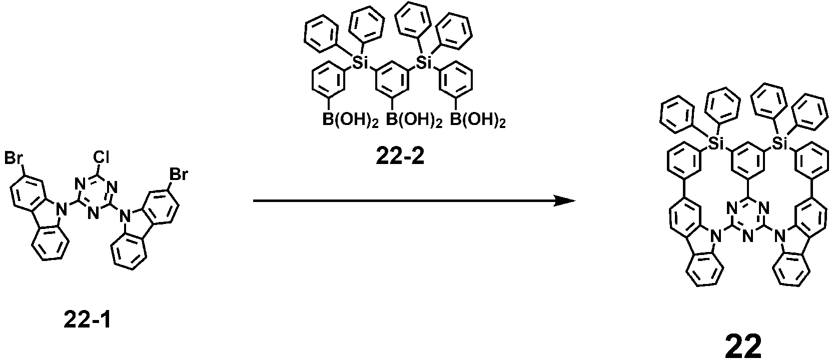

7.7 g of Compound 22-1, 9.26 g of compound 22-2, 3.53 g of potassium carbonate, and 0.15 g of tetrakis(triphenylphosphine)palladium(0) were placed in a RB flask and dissolved in 130 ml of tetrahydrofuran (THF) and 35 ml of distilled water (DW), and refluxed for 12 hours. After completion of the reaction, an extraction process was performed thereon by using ethyl acetate, and an organic layer was collected. The organic layer was dried by using magnesium sulfate to obtain a residue. The residue was separated and purified by silica gel column chromatography to obtain 4.97 g (yield: 39%) of compound 22. Compound 22 was confirmed by LC-MS.
C₆₉H₄₅N₅Si₂ M+1: 1000.25

### Synthesis Example 6 (Synthesis of compound 43)

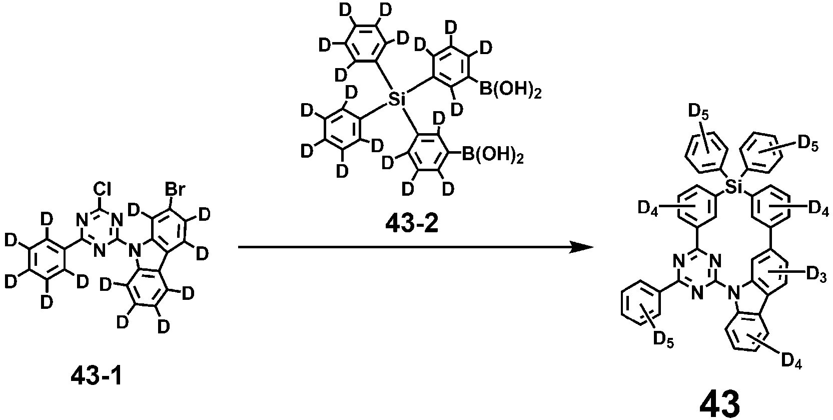

4.00 g of Compound 43-1, 3.95 g of compound 43-2, 2.47 g of potassium carbonate, and 0.10 g of tetrakis(triphenylphosphine)palladium(0) were placed in a RB flask and dissolved in 90 ml of tetrahydrofuran (THF) and 25 ml of distilled water (DW), and refluxed for 12 hours. After the reaction was completed, the resultant reaction solution was extracted with ethyl acetate and the resultant organic layer was collected. The organic layer was dried using magnesium sulfate to obtain a residue. The residue was separated and purified by silica gel column chromatography to obtain 3.73 g (yield: 61%) of compound 43. Compound 43 was confirmed by LC-MS.
C₄₅D₃₀N₄Si M+1: 685.59

### Synthesis Example 7 (Synthesis of compound 49)

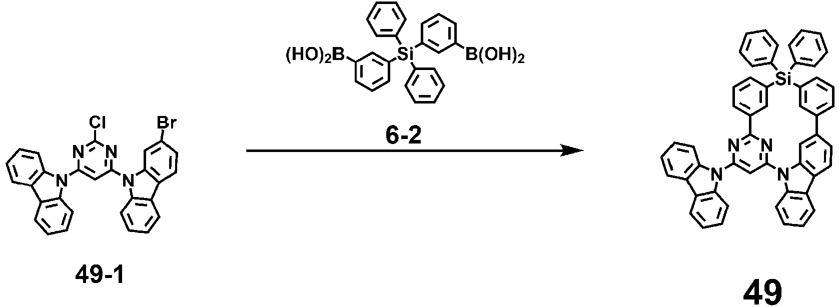

3.50 g of Compound 49-1, 2.83 g of compound 6-2, 1.85 g of potassium carbonate, and 0.08 g of tetrakis(triphenylphosphine)palladium(0) were placed in a RB flask and dissolved in 65 ml of tetrahydrofuran (THF) and 20 ml of distilled water (DW), and refluxed for 12 hours. After the reaction was completed, the resultant reaction solution was extracted with ethyl acetate and the resultant organic layer was collected. The organic layer was dried using magnesium sulfate to obtain a residue. The residue was separated and purified by silica gel column chromatography to obtain 3.42 g (yield: 69%) of compound 49. Compound 49 was confirmed by LC-MS.
C₅₂H₃₄N₄Si M+1: 743.54

Other compounds besides those synthesized in Synthesis Examples 1 to 7 can be readily recognized by those skilled in the art by referring to the synthetic routes as described above and raw materials.

### Example 1

An ITO-patterned glass substrate as an anode was cut to a size of 50 mm x 50 mm x 0.7 mm, ultrasonically cleaned for 5 minutes each using isopropyl alcohol and pure water, cleaned by ultra-violet (UV) irradiation for 30 minutes and exposure to ozone, and mounted on a vacuum deposition device.

N,N'-di(1-naphthyl)-N,N'-diphenylbenzidine (NPB) was vacuum-deposited on the anode to form a hole injection layer having a thickness of 300 Å. mCP was vacuum-deposited on the hole injection layer to form a hole transport layer having a thickness of 200 Å.

Subsequently, compound 6 (host) and Ir(pmp)₃ (dopant) were co-deposited at a weight ratio of 92:8 on the hole transport layer to form an emission layer having a thickness of 250 Å.

Thereafter, 3-(4-biphenylyl)-4-phenyl-5-tert-butylphenyl-1,2,4-triazole (TAZ) was vacuum-deposited on the emission layer to form an electron transport layer having a thickness of 200 Å. LiF was vacuum-deposited on the electron transport layer to form an electron injection layer having a thickness of 10 Å, and Al was vacuum-deposited on the electron injection layer to form a cathode having a thickness of 100 Å, thereby manufacturing a light-emitting device.

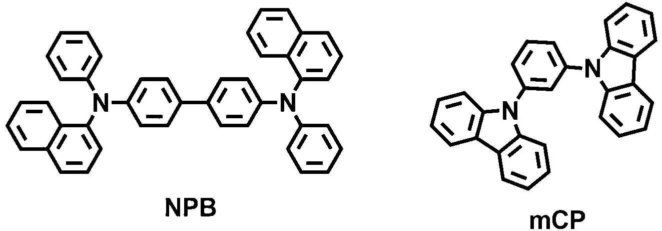

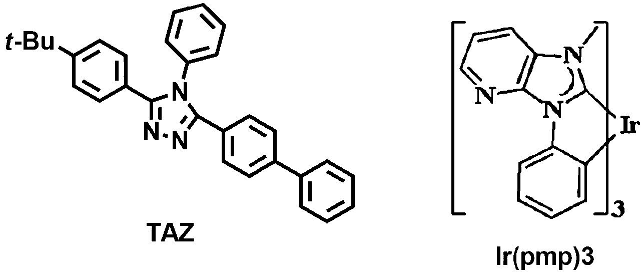

### Examples 2 to 7 and Comparative Examples 1 to 5

Light-emitting devices were manufactured using substantially the same method as in Example 1, except that the host was changed as shown in Table 1 below.

### Evaluation Example 1

To evaluate the characteristics of the light-emitting devices according to Examples 1 to 7 and Comparative Examples 1 to 5, the driving voltage at the current density of 10 mA/cm², luminescence efficiency and maximum quantum efficiency thereof were measured. The driving voltage, current density, and luminescence efficiency of each light-emitting device were measured by using a source meter (Keithley Instrument, 2400 series), and the maximum quantum efficiency was measured by using the external quantum efficiency measurement device C9920-2-12 of Hamamatsu Photonics Inc. In evaluating the maximum quantum efficiency, luminance/current density was measured utilizing a luminance meter that was calibrated for wavelength sensitivity, and the maximum quantum efficiency was converted by assuming an angular luminance distribution (Lambertian) which introduced a perfect reflecting diffuser. The evaluation results of the characteristics of the light-emitting devices are shown in Table 1 below.

**Table 1**

| No. | Emission layer host | Driving voltage (V) | Luminescence efficiency (cd/A) | Maximum quantum efficiency (%) | Emission color |
|---|---|---|---|---|---|
| Example 1 | Compound 6 | 3.5 | 26.7 | 29.8 | Blue |
| Example 2 | Compound 7 | 4.0 | 25.2 | 26.1 | Blue |
| Example 3 | Compound 15 | 4.1 | 27.6 | 27.1 | Blue |
| Example 4 | Compound 21 | 4.2 | 25.3 | 27.2 | Blue |
| Example 5 | Compound 22 | 4.3 | 26.8 | 26.3 | Blue |
| Example 6 | Compound 43 | 3.7 | 27.1 | 26.3 | Blue |
| Example 7 | Compound 49 | 4.5 | 24.9 | 27.0 | Blue |
| Comparative Example 1 | Compound CE1 | 4.9 | 15.2 | 26.2 | Blue |
| Comparative Example 2 | Compound CE2 | 4.6 | 23.9 | 25.8 | Blue |
| Comparative Example 3 | Compound CE3 | 4.5 | 24.0 | 26.9 | Blue |
| Comparative Example 4 | Compound CE4 | 4.7 | 24.3 | 25.9 | Blue |
| Comparative Example 5 | Compound CE5 | 4.7 | 22.1 | 23.0 | Blue |

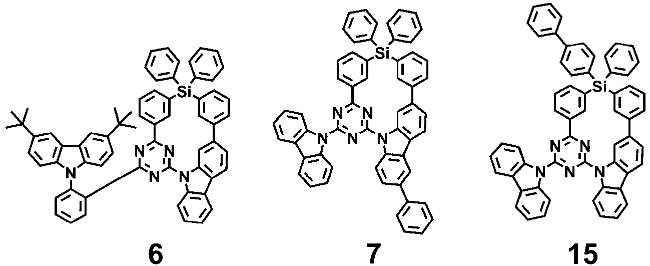

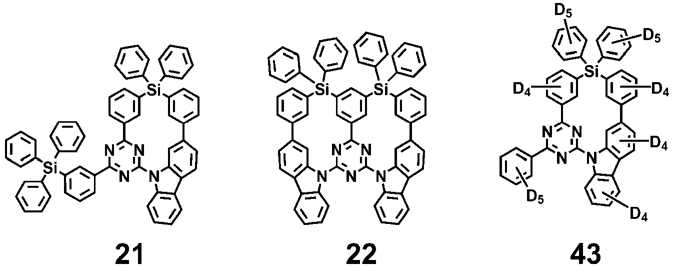

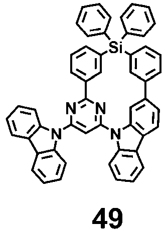

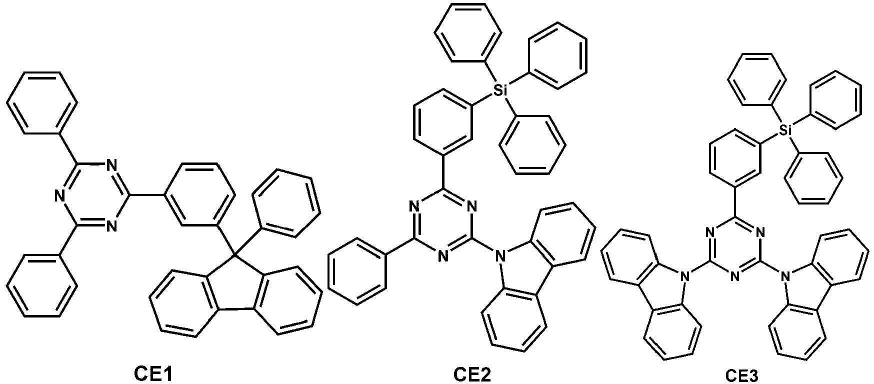

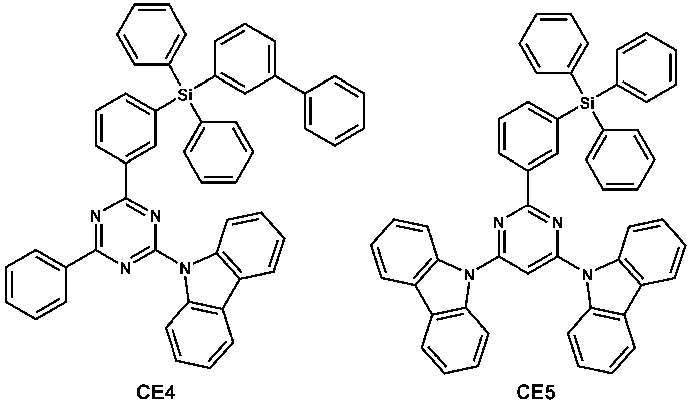

From Table 1, it can be confirmed that the light-emitting devices according to Examples 1 to 7 have lower driving voltage, higher luminescence efficiency and/or higher maximum quantum efficiency than the light-emitting devices according to Comparative Examples 1 to 5.

The organic compounds represented by Formula 1 as described above may have improved electron mobility, structural stability, photochemical stability and robustness, and the formation of exciplexes with different compounds may be suppressed or reduced. Accordingly, a light-emitting device including the organic compound as an emission material may have excellent emission characteristics such as low driving voltage, high luminescence properties and high maximum quantum efficiency. Therefore, a display device including the light-emitting device may have excellent display quality, and may provide a high-quality electronic device including the display device.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various suitable changes in form and details may be made therein without departing from the scope of the present disclosure as defined by the following claims, and equivalents thereof.

## Claims

1. A light-emitting device (10) comprising:
a first electrode (110);
a second electrode (150) facing the first electrode (110); and
an interlayer between the first electrode (110) and the second electrode (150) and comprising an emission layer (130), wherein:
the interlayer comprises at least one organic compound represented by Formula 1: 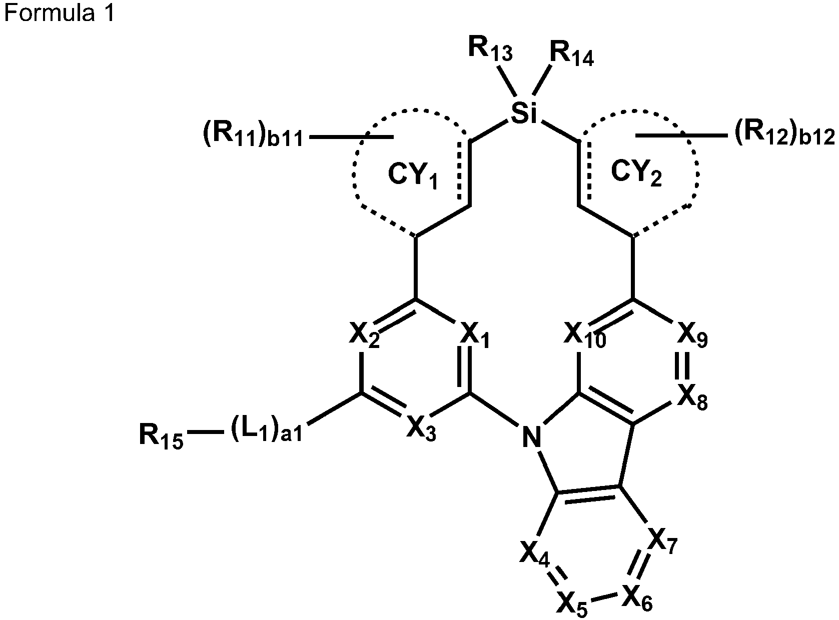
wherein, in Formula 1,
a bond represented by 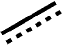 is a single bond, a double bond, or a combination thereof,
CY₁ and CY₂ are each independently a C₅-C₆₀ carbocyclic group or a C₃-C₆₀ heterocyclic group,
X₁ is C(R₁) or N, X₂ is C(R₂) or N, X₃ is C(R₃) or N, X₄ is C(R₄) or N, X₅ is C(R₅) or N, X₆ is C(R₆) or N, X₇ is C(R₇) or N, X₈ is C(R₈) or N, X₉ is C(R₉) or N, X₁₀ is C(R₁₀) or N,
L₁ is a C₅-C₆₀ carbocyclic group unsubstituted or substituted with at least one R₁₀ₐ or a C₁-C₆₀ heterocyclic group unsubstituted or substituted with at least one R₁₀ₐ,
a1 is an integer from 0 to 2, and when a1 is 0, the group represented by (L₁)ₐ₁ is a single bond,
b11 and b12 are each an integer from 1 to 10,
R₁ to R₁₅ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₅-C₆₀ carbocyclic group unsubstituted or substituted with at least one R₁₀ₐ, a C₁-C₆₀ heterocyclic group unsubstituted or substituted with at least one R₁₀ₐ, -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂),
R₁₁ and (L₁)ₐ₁-R₁₅ are optionally bonded to each other to form a C₅-C₆₀ carbocyclic group or a C₁-C₆₀ heterocyclic group,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₅-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or a combination thereof;
a C₅-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₅-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any suitable combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently
hydrogen, deuterium, -F, -Cl, -Br, -I, a hydroxyl group, a cyano group, or a nitro group; or
a C₁-C₆₀ alkyl group, a C₂-C₆₀ alkenyl group, a C₂-C₆₀ alkynyl group, a C₁-C₆₀ alkoxy group, a C₅-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any suitable combination thereof.

2. The light-emitting device of claim 1, wherein:
the emission layer comprises the at least one organic compound.

3. The light-emitting device of claim 1 or claim 2, wherein:
the emission layer emits blue light.

4. A display evice comprising:
the light-emitting device of any one of claim 1 to 3; and
a thin-film transistor electrically connected to the light-emitting device.

5. An electronic device (1000) comprising:
the display device of claim 4; and
a processor (1200) configured to transmit a signal to the display device, wherein:
the electronic device (1000) is one selected from a flat panel display, a curved display, a computer monitor, a medical monitor, a television, a billboard, indoor or outdoor lighting and/or signaling lights, a head-up display, a fully or partially transparent display, a flexible display, a rollable display, a foldable display, a stretchable display, smart glasses, a head-mounted display, a smart watch, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, an augmented reality display, a vehicle dashboard, a center information display (CID) for a vehicle, a head-up display for a vehicle, a rearview mirror display, a video wall including multiple displays that are tiled together, a theater screen, a stadium screen, a light therapy device, and a signage.

6. An organic compound represented by Formula 1: 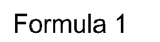 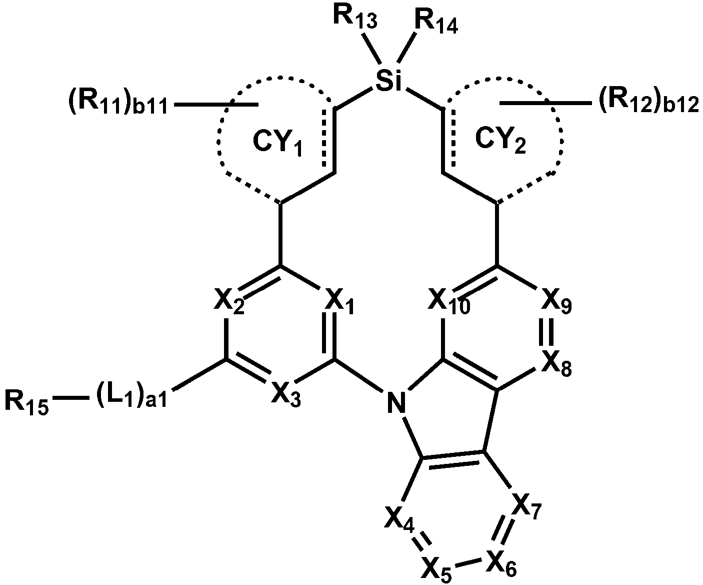 wherein, in Formula 1,
a bond represented by 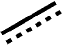 is a single bond, a double bond, or a combination thereof,
CY₁ and CY₂ are each independently a C₅-C₆₀ carbocyclic group or a C₃-C₆₀ heterocyclic group,
X₁ is C(R₁) or N, X₂ is C(R₂) or N, X₃ is C(R₃) or N, X₄ is C(R₄) or N, X₅ is C(R₈) or N, X₆ is C(R₆) or N, X₇ is C(R₇) or N, X₈ is C(R₈) or N, X₉ is C(R₉) or N, X₁₀ is C(R₁₀) or N,
L₁ is a C₅-C₆₀ carbocyclic group unsubstituted or substituted with at least one R₁₀ₐ or a C₁-C₆₀ heterocyclic group unsubstituted or substituted with at least one R₁₀ₐ,
a1 is an integer from 0 to 2, and when a1 is 0, the group represented by (L₁)ₐ₁ is a single bond,
b11 and b12 are each an integer from 1 to 10,
R₁ to R₁₅ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₅-C₆₀ carbocyclic group unsubstituted or substituted with at least one R₁₀ₐ, a C₁-C₆₀ heterocyclic group unsubstituted or substituted with at least one R₁₀ₐ, -Si(Q₁)(Q₂)(Q₃), - N(Q₁)(Q₂), -B(Q₁)(Q₂), -C(=O)(Q₁), -S(=O)₂(Q₁), **or** -P(=O)(Q₁)(Q₂),
R₁₁ and (L₁)ₐ₁-R₁₅ are optionally bonded to each other to form a C₅-C₆₀ carbocyclic group or a C₁-C₆₀ heterocyclic group,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₅-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or a combination thereof;
a C₅-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₅-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any suitable combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently
hydrogen, deuterium, -F, -Cl, -Br, -I, a hydroxyl group, a cyano group, or a nitro group; or
a C₁-C₆₀ alkyl group, a C₂-C₆₀ alkenyl group, a C₂-C₆₀ alkynyl group, a C₁-C₆₀ alkoxy group, a C₅-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any suitable combination thereof.

7. The organic compound of claim 6, wherein:
CY₁ and CY₂ in Formula 1 are each independently:
a 5-membered ring;
a 6-membered ring;
a condensed ring of at least one 5-membered ring and at least one 6-membered ring; or
a condensed ring of at least two 6-membered rings.

8. The organic compound of claim 6 or claim 7, wherein:
at least one selected from X₁ to X₃ in Formula 1 is N.

9. The organic compound of any one of claims 6 to 8, wherein:
L₁ in Formula 1 is a benzene group; a naphthalene group; a 1,2,3,4-tetrahydronaphthalene group; a phenanthrene group; a pyridine group; a pyrimidine group; a pyrazine group; a pyridazine group; a triazine group; a quinoline group; an isoquinoline group; a quinoxaline group; a quinazoline group; a phenanthroline group; a benzofuran group; a benzothiophene group; a fluorene group; a carbazole group; a dibenzofuran group; a dibenzothiophene group; a dibenzosilole group; an azafluorene group; an azacarbazole group; an azadibenzofuran group; an azadibenzothiophene group; or an azadibenzosilole group, each unsubstituted or substituted with at least one R₁₀ₐ.

10. The organic compound of any one of claims 6 to 9, wherein:
R₁ and R₁₀ in Formula 1 are each hydrogen or deuterium.

11. The organic compound of any one of claims 6 to 10, wherein:
R₁₁ and (L₁)ₐ₁-R₁₅ in Formula 1 are bonded to each other to form a 14-membered ring, and
the 14-membered ring includes, as a ring forming atom, C, Si and N.

12. The organic compound of any one of claims 6 to 11, wherein:
R₁₃ and R₁₄ in Formula 1 are each independently a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₆-C₆₀ aryl group unsubstituted or substituted with at least one R₁₀ₐ, or a C₁-C₆₀ heteroaryl group unsubstituted or substituted with at least one R₁₀ₐ.

13. The organic compound of any one of claims 6 to 12, wherein:
a group represented by *-(L₁)ₐ₁-R₁₅ in Formula 1 is a group represented by one selected from Formulae LR1 to LR74: 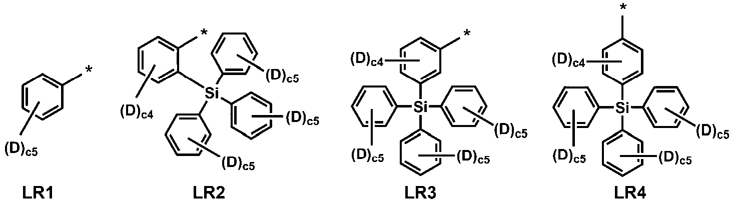 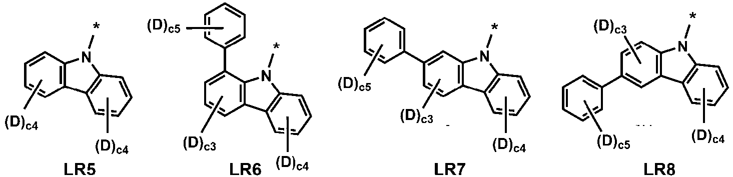 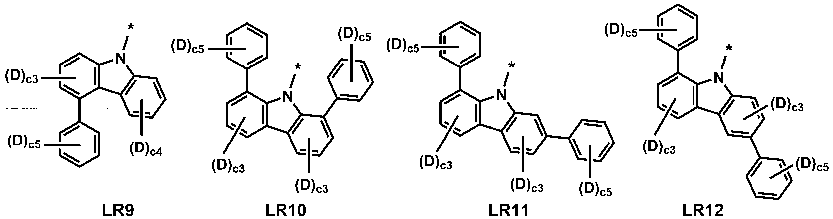 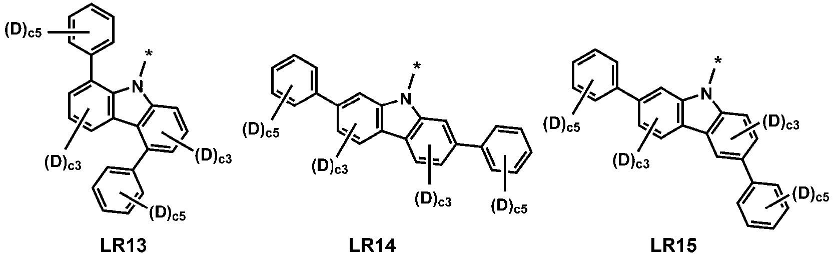 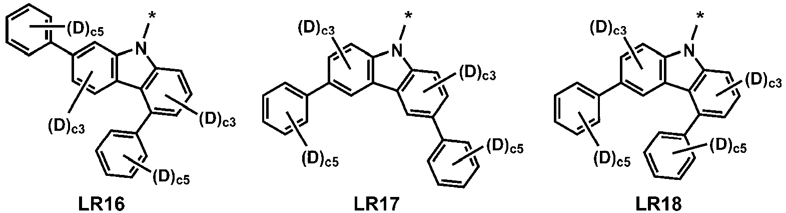 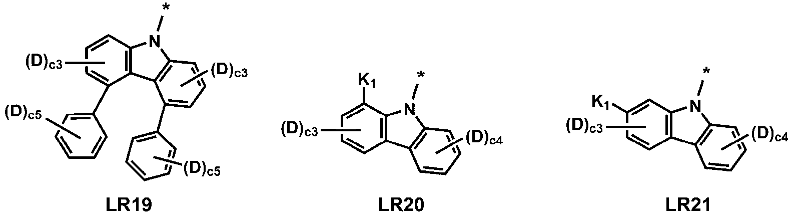 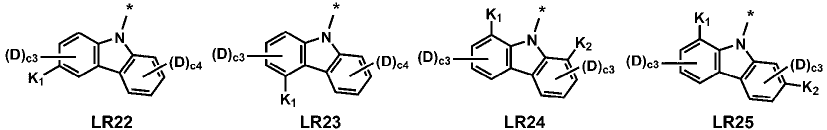 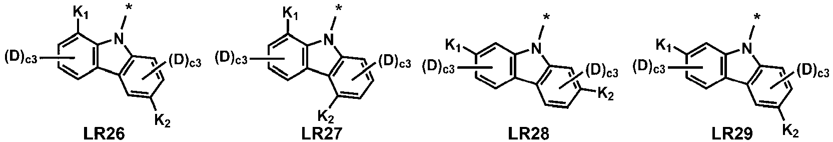 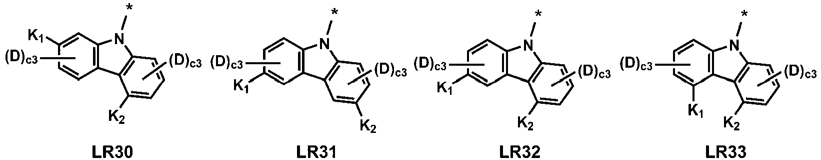 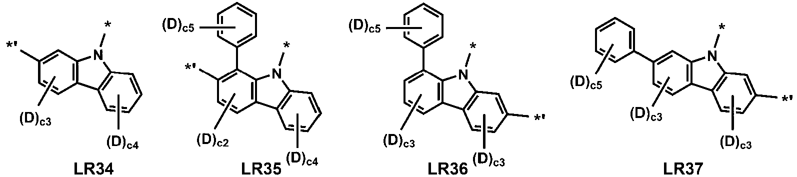 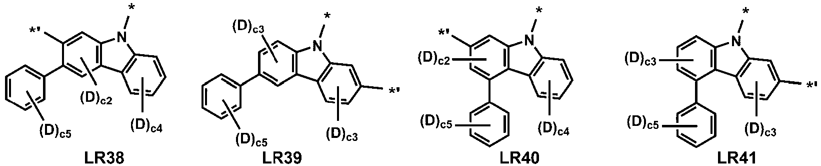 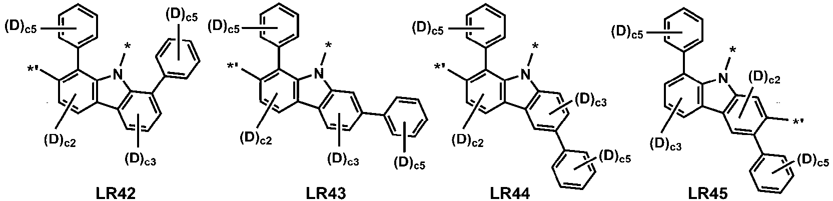 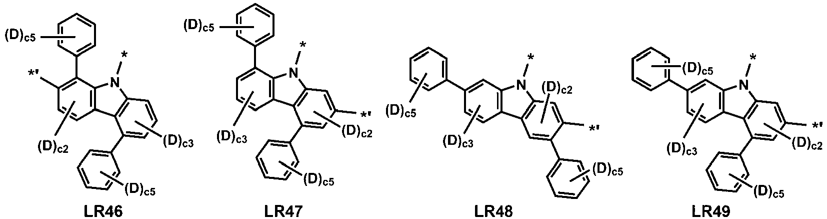 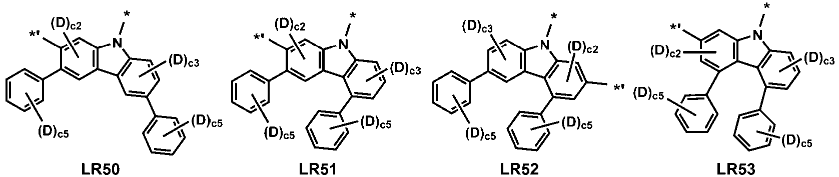 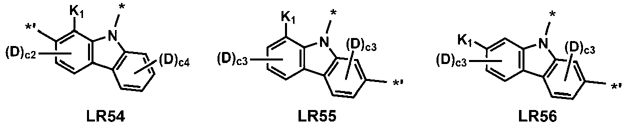 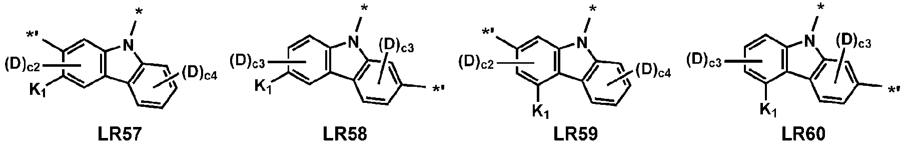 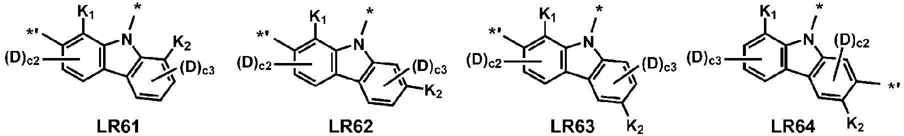 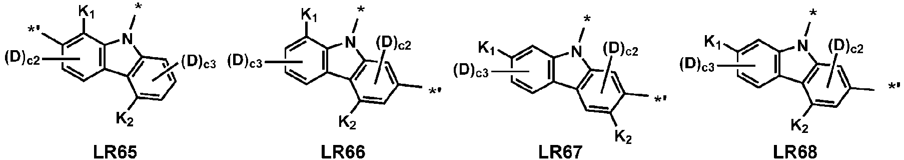 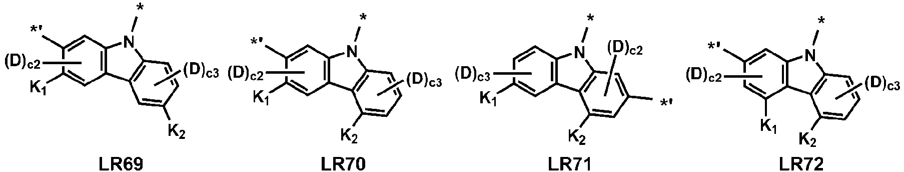 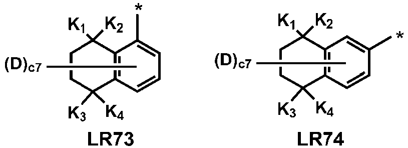
wherein, in Formulae LR1 to LR74,
D is deuterium,
K₁ to K₄ are each independently a C₁-C₆₀ alkyl group unsubstituted or substituted with at least one R₁₀ₐ,
c2 is an integer from 0 to 2,
c3 is an integer from 0 to 3,
c4 is an integer from 0 to 4,
c5 is an integer from 0 to 5,
c7 is an integer from 0 to 7,
* indicates a binding site to a neighboring atom, and
*' indicates a binding site to R₁₁ in Formula 1.

14. The organic compound of claim 6, wherein:
the organic compound is represented by one selected from Formulae 1A to 1E: 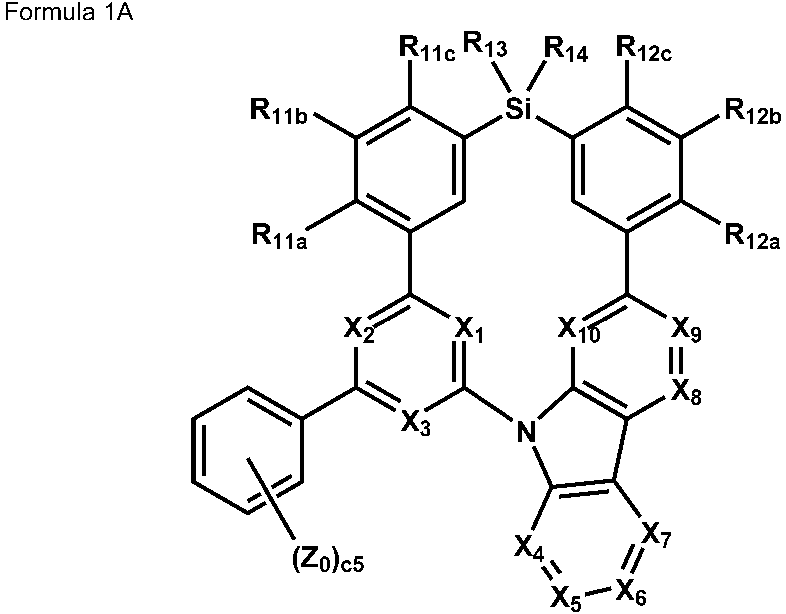 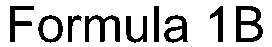 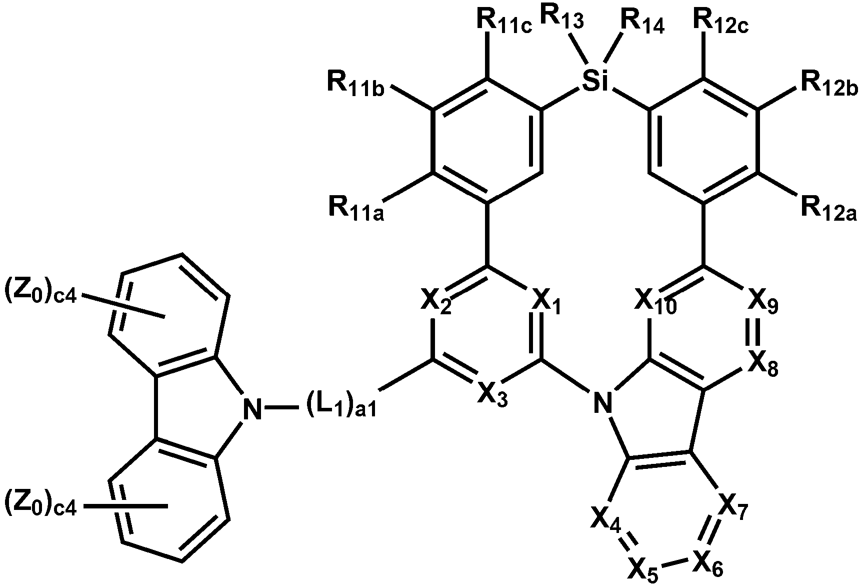 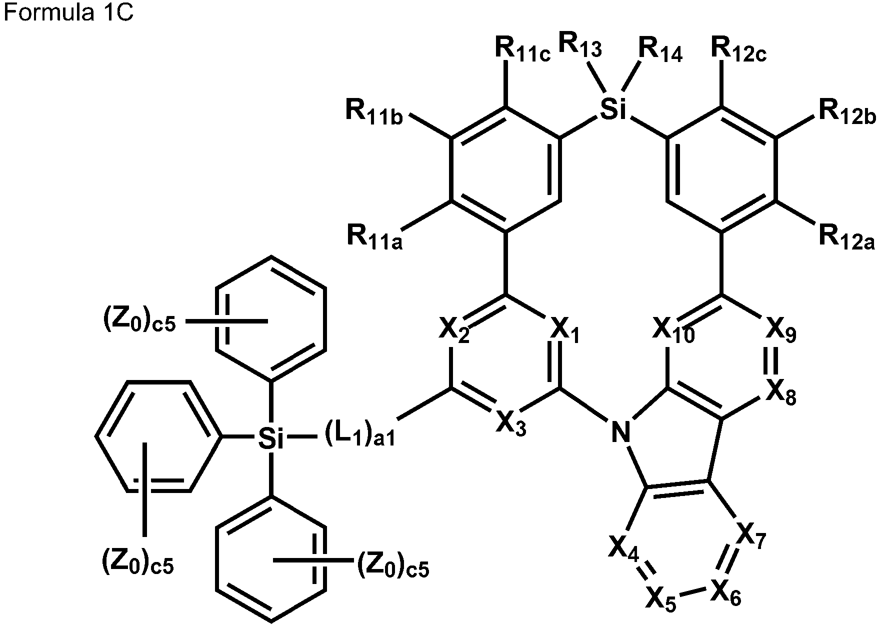 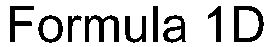 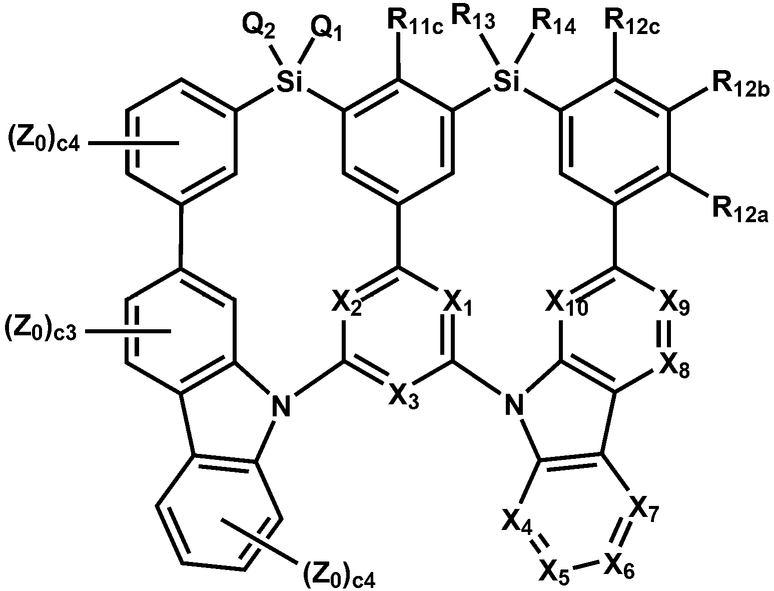 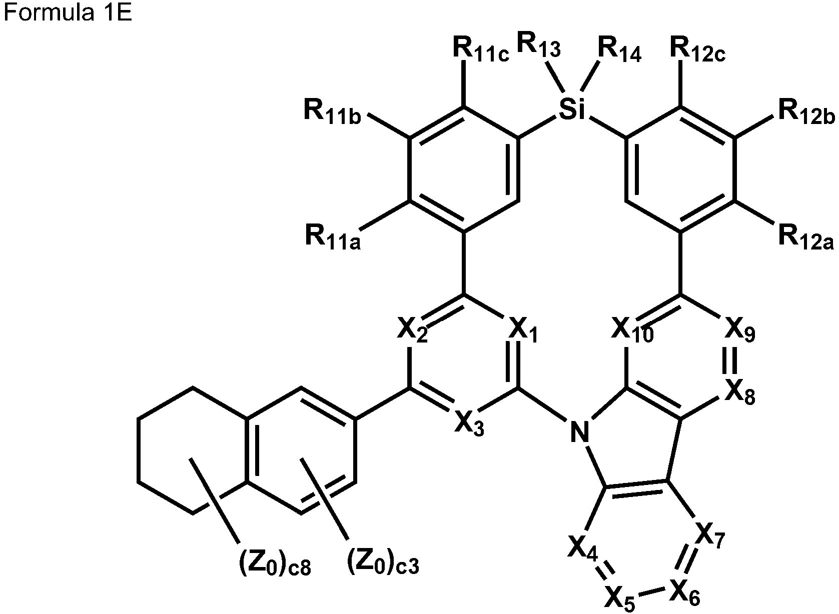 wherein, in Formulae 1A to 1E,
X₁ to X₁₀, L₁, a1, R₁₃, R₁₄, Q₁, and Q₂ are each as described in connection with Formula 1,
R₁₁ₐ to R_{11c} are each as described in connection with R₁₁ in Formula 1,
R₁₂ₐ to R_{12c} are each as described in connection with R₁₂ in Formula 1,
Zₒ is deuterium, -F, a cyano group, a C₁-C₆₀ alkyl group, a C₁-C₆₀ alkoxy group, a phenyl group, or a biphenyl group,
c3 is an integer from 0 to 3,
c4 is an integer from 0 to 4,
c5 is an integer from 0 to 5, and
c8 is an integer from 0 to 8.

15. The organic compound of claim 6, wherein:
the organic compound is one of compounds 1 to 144:
